(19)

**Europäisches Patentamt**

**European Patent Office**

**Office européen des brevets**

(11) **EP 3 232 576 A1**

(12) **EUROPEAN PATENT APPLICATION**

(43) Date of publication:
**18.10.2017 Bulletin 2017/42**

(51) Int Cl.:
**H03M 13/29** *(2006.01)* **H03M 13/27** *(2006.01)*
**H03M 13/15** *(2006.01)* **H03M 13/19** *(2006.01)*

(21) Application number: **16305442.2**

(22) Date of filing: **15.04.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **ALCATEL LUCENT**
**92100 Boulogne-Billancourt (FR)**

(72) Inventors:
- **Schmalen, Laurent**
  **70435 Stuttgart (DE)**
- **Zhang, Lei**
  **70435 Stuttgart (DE)**

(74) Representative: **2SPL Patentanwälte PartG mbB**
**Postfach 15 17 23**
**80050 München (DE)**

(54) **FEED-FORWARD STAIRCASE CODES FOR CHANNEL CODING IN OPTICAL COMMUNICATION SYSTEMS**

(57) Feed-forward or partial feed-forward staircase codes (FF-SC or PFF-SC) using the principle of staircase coding however without, at least partly, re-encoding parity bit blocks. Information symbols are mapped to information symbol positions in a sequence of two-dimensional symbol blocks, wherein a symbol block ($\mathbf{B}_i$) has a preceding symbol block ($\mathbf{B}_{i-1}$) and a subsequent symbol block ($\mathbf{B}_{i+1}$) in the sequence, and wherein the symbol block ($\mathbf{B}_i$) has information symbol positions and redundancy symbol positions. Redundancy symbols are generated for the redundancy symbol positions of the symbol blocks in the sequence. First redundancy symbols ($\mathbf{X}$; $\tilde{\mathbf{P}}_r$) for the symbol block ($\mathbf{B}_i$) are generated such that symbols at positions including or excluding redundancy symbol positions along a first dimension of the preceding symbol block ($\mathbf{B}_{i-1}$) concatenated with symbols at information symbol positions and the first redundancy symbols ($\mathbf{X}$; $\tilde{\mathbf{P}}_r$) along the first dimension of the symbol block ($\mathbf{B}_i$) form a codeword of a first FEC component code. Second redundancy symbols ($\mathbf{Y}$; $\tilde{\mathbf{P}}_c$) for the subsequent symbol block ($\mathbf{B}_{i+1}$) are generated such that symbols at the information symbol positions along a second dimension of the symbol block ($\mathbf{B}_i$) concatenated with information symbols and the second redundancy symbols ($\mathbf{Y}$; $\tilde{\mathbf{P}}_c$) along the second dimension of the subsequent symbol block ($\mathbf{B}_{i+1}$) form a codeword of a second FEC component code. The first and second redundancy symbols ($\mathbf{X}$; $\tilde{\mathbf{P}}_r$; $\mathbf{Y}$; $\tilde{\mathbf{P}}_c$) carry the same redundancy information. The FF-SC or PFF-SC encoding concept allows easy termination and avoiding, or at least limiting, parity propagation, where a single non-zero information bit leads to an infinitely extending parity sequence.

FIG. 7

EP 3 232 576 A1

**Description**

The present disclosure generally relate to communication systems and, more particularly, to communication systems employing Forward Error Correction (FEC) coding such as staircase coding, for example.

Background

High speed fiber optical communication systems are a challenging environment for FEC schemes. Modem high-speed optical communication systems require high-performing FEC engines that support throughputs of 100 Gbit/s and multiples thereof, that have low power consumption, that realize Net Coding Gains (NCGs) close to the theoretical capacity limits at a target Bit Error Rate (BER) of $10^{-15}$, and that are preferably adapted to the peculiarities of the optical channel.

Although coding schemes that allow for soft-decision decoding are now well established in optical communications, especially in long-haul and submarine transmission systems which need to operate at the lowest possible Signal-to-Noise Ratio (SNR), hard-decision decoding is still predominant in the widely deployed metro networks, due to its low complexity leading to power-friendly receiver implementations. Such low-complexity receivers are also attractive for data center interconnect applications.

In the recent years, several new capacity-approaching coding schemes suitable for high-speed optical communications have been presented. Staircase codes are hard-decision decoded, spatially-coupled codes with practical application in forward error-correction for long-haul optical-fiber transmission systems. An ITU-T G.709-compatible staircase code with rate R = 239/255 was shown to operate within 0.56 dB of capacity in terms of the NCG at a bit-error rate (BER) of $10^{-15}$. Its gap to capacity is smaller than all of the enhanced coding schemes proposed in ITU-T recommendation G.975.1. Staircase codes with rates $R \geq 6/7$ were shown to be within 0.80 dB of capacity in terms of NCG at a BER of $10^{-15}$.

Such coding gains can be obtained by using an iterative, hard-decision decoding algorithm with decoder data-flow orders of magnitude lower than that of message-passing decoders for sparse-graph codes such as Turbo or Low-Density Parity-Check (LDPC) codes. For long-haul optical-fiber transmissions systems where bit-rates exceed 100 Gb/s, staircase codes are often the best practical solution.

Besides staircase code and variants thereof, several other code constructions based on spatial coupling of algebraic component codes have been proposed, e.g. braided BCH codes. Recently, multiple works show that these codes can approach capacity of the BSC under simple iterative decoding when the rate is large enough. However, all the proposed structures of spatially coupled algebraic product codes are recursive codes which lead to several practical drawbacks in their implementation: First, a recursive structure requires extra circuitry for terminating the code, which may be undesired in some applications where a low-complexity decoder implementation is crucial. Previous publications have not explicitly dealt with code termination but have only considered free-running, non-terminated codes.

A second drawback of recursive codes is the effect of parity-propagation or parity ringing; a single non-zero information bit leads to an infinitely extending parity sequence. This effect may be undesired in some optical transmission applications, where the transceivers are usually free-running due to the setup times of links and only some of the transmitted bits carry useful information. Parity propagation limits in this case the possibility of switching off the forward error correction circuitry during times when no useful data is transmitted, non-negligibly increasing the transceiver power consumption.

Thus, there is a desire for codes that do not have parity-propagation.

Summary

According to a first aspect, the present disclosure provides an FEC encoding method. The method includes mapping information symbols to information symbol positions in a sequence of two-dimensional symbol blocks. Here, an information symbol shall be understood as a symbol of useful data. An $i$-th ( $i \in$ N) symbol block of the sequence has a preceding symbol block and a subsequent symbol block in the sequence. At least some symbol blocks comprise information symbol positions and redundancy symbol positions. The method further includes generating redundancy symbols for the redundancy symbol positions of the symbol blocks in the sequence. Generating the redundancy symbols includes generating first redundancy symbols (row or column redundancy symbols) for the $i$-th symbol block such that symbols at positions including or excluding redundancy symbol positions along a first dimension (row or column) of the preceding symbol block concatenated with symbols at information symbol positions and the first redundancy symbols along the first dimension of the $i$-th symbol block form a codeword of a first FEC component code (row or column component code). Generating the redundancy symbols further includes generating second redundancy symbols (column or row redundancy symbols) for the subsequent symbol block ($i$+1) such that symbols at information symbol positions along a second dimension (column or row) of the $i$-th symbol block concatenated with symbols at positions excluding redundancy symbol positions and the second redundancy symbols along the second dimension of the subsequent symbol block form a codeword of a second FEC component code (column or row component code).

In some embodiments, the first and second redundancy symbols can be mutually dependent according to a predetermined relationship. Despite different underlying information symbols in subsequent symbol blocks, the first and second redundancy symbols can be generated to comprise the same redundancy information.

The first and second redundancy symbols in the respective redundancy symbol positions can also be arranged as respective two-dimensional redundancy symbol blocks. The first and second redundancy symbol blocks can be subblocks of the $i$-th and the subsequent symbol block.

In some embodiments, the method can further optionally include transmitting the information symbols of the $i$-th symbol block and of the subsequent symbol block ($i$+1) along with either the first or the second redundancy symbols. Since the first and second redundancy symbols comprise the same redundancy information, this redundancy information only needs to be transmitted once along with the $i$-th symbol block or the subsequent symbol block ($i$+1). Thus, the transmission can be performed more efficiently.

In some embodiments, the first and the second FEC component codes are systematic block codes, respectively. Note that a systematic code is any error-correcting code in which the input data is embedded in the encoded output.

In some embodiments, the first FEC component can be the same as the second FEC component code. For example, a first generator polynomial of the first FEC component code can be identical to a second generator polynomial of the second FEC component code.

In some embodiments, a number of information symbol positions in subsequent symbol blocks can be different.

In some embodiments, the first FEC component code can be different from the second FEC component code. For example, a first generator polynomial of the first FEC component code can be different from a second generator polynomial of the second FEC component code.

In some embodiments, a first generator polynomial corresponding to the first FEC component code can be reciprocal to a second generator polynomial corresponding to the second FEC component code. Reciprocal generator polynomials have the property that the "mirror image", i.e. the reflection around its center, of a codeword for the first FEC component code is a codeword for the second FEC component code.

In some embodiments, the first redundancy symbols can be a permuted version of the second redundancy symbols and vice versa. Thereby permutation relates to arranging the members of a set into some sequence or order, or if the set is already ordered, rearranging (reordering) its elements.

In some embodiments, the first redundancy symbols can be a matrix or vector transposed version of the second redundancy symbols and vice versa.

In some embodiments, the first redundancy symbols can be a cyclic shifted version of the second redundancy symbols and vice versa.

In some embodiments, generating the redundancy symbols can optionally include generating, according to the first FEC component code, the first redundancy symbols for the $i$-th symbol block based on symbols at symbol positions including redundancy symbol positions along the first dimension of the preceding symbol block concatenated with information symbols at information symbol positions along the first dimension of the $i$-th symbol block, and generating, according to a second FEC component code, the second redundancy symbols for the subsequent symbol block ($i$+1) based on symbols at symbol positions excluding redundancy symbol positions along the second dimension of the $i$-th symbol block concatenated with information symbols at information symbol positions along the second dimension of the subsequent symbol block.

In some embodiments, each of the first and second redundancy symbols can optionally comprise respective adjustable (self-protection) symbols and respective parity symbols. Generating the redundancy symbols can include generating the first parity symbols such that the symbols at the symbol positions (including information symbol positions) including or excluding redundancy symbol positions along the first dimension of the preceding symbol block ($i$-1) concatenated with the symbols at the information symbol positions, the first adjustable symbols, and the first parity symbols along the first dimension of the $i$-th symbol block form a codeword of the first FEC component code. Generating the redundancy symbols can further include generating the second parity symbols such that the symbols at the information symbol positions along the second dimension of the $i$-th symbol block concatenated with the symbols at the information symbol positions, the second adjustable symbols, and the second parity symbols along the second dimension of the subsequent symbol block form a codeword of the second FEC component code. The second adjustable symbols can be a permuted version of the first adjustable symbols in accordance with a first permutation rule. The second parity symbols can be a permuted version of the first parity symbols in accordance with a second permutation rule.

In some embodiments, generating the first parity symbols can comprise generating first intermediate parity symbols based on combining a concatenation of the symbols at the information symbol positions along the first dimension of the preceding symbol block and the symbols at the information symbol positions along the first dimension of the $i$-th symbol block according to a first portion of the first FEC component code. Generating the second parity symbols can comprise generating second intermediate parity symbols based on combining a concatenation of the symbols at the information symbol positions along the second dimension of the $i$-th symbol block and the symbols at the information symbol positions along the second dimension of the subsequent symbol block according to a first portion of the second FEC component code.

In some embodiments, generating the first parity symbols can further include generating one of the first or the second adjustable symbols based on a combination of first and second generator matrices corresponding to a respective second portion of the first and second FEC component code, first and second permutation matrices corresponding to the first and second permutation rule, and the first and the second intermediate parity symbols. Generating the first parity symbols further includes generating the respective other adjustable symbols based on the determined first or the second adjustable symbols and the first permutation rule.

In some embodiments, a subset of information symbols of the *i*-th symbol block can be a permuted version of a subset of information symbols of the subsequent symbol block *i*+1. The subset of information symbols can be adjusted together with adjustable self-protection symbols and parity symbols such that information symbols, adjustable self-protection symbols and parity symbols form valid codewords.

In some embodiments, a size of the respective subset of information symbols can depend on an expected error probability of a communication channel.

In some embodiments, generating redundancy symbols of different symbol blocks in the sequence can comprise using different code rates of the first and/or second component codes between the different symbol blocks. Thereby a code rate is defined by a ratio between a number of (useful or non-predetermined) information symbols included in a codeword and a total number of symbols in the codeword.

In some embodiments, generating the first redundancy symbols can comprise generating a subset of the first redundancy symbols such that a concatenation of

- a first subset of symbols at a first subset of symbol positions (including information symbol positions) including or excluding redundancy symbol positions along the first dimension of the preceding symbol block *i*-1,
- predetermined symbols at a second subset of symbol positions (including information symbol positions) including or excluding redundancy symbol positions along the first dimension of the preceding symbol block *i*-1,
- a first subset of information symbols at a first subset of information symbol positions along the first dimension of the *i*-th symbol block,
- predetermined symbols at a second subset of information symbol positions along the first dimension of the *i*-th symbol block, and
- the subset of first redundancy symbols along the first dimension of the *i*-th symbol block

form a codeword of the first FEC component code.

In some embodiments, generating the second redundancy symbols can optionally further comprise generating a subset of the second redundancy symbols such that a concatenation of

- the first subset of information symbols at the first subset of information symbol positions along the second dimension of the *i*-th symbol block,
- predetermined symbols at a third subset of information symbol positions along the second dimension of the *i*-th symbol block,
- a first subset of information symbols at a first subset of information symbol positions along the second dimension of the subsequent symbol block *i*+1,
- predetermined symbols at a third subset of information symbol positions along the second dimension of the subsequent symbol block *i*+1, and
- the subset of the second redundancy symbols along the second dimension of the subsequent symbol block *i*+1

form a codeword of the second FEC component code.

In some embodiments, a number of information symbol positions along the first dimension can differs from a number of information symbol positions along the second dimension in of a symbol block.

In some embodiments, each symbol block can comprise $M \times M$ information symbol positions, with $M = (k - r)/2$ and $k$ denoting a length of an input message for the first or the second FEC component code, $r = n - k$ denoting a number of parity bits in a component codeword, and $n$ denoting a length of an output block of first or the second FEC component code.

In some embodiments, an initial symbol block of the sequence comprises predetermined initial symbols at information symbol positions.

In some embodiments, the method can be implemented via digital encoding circuitry installed within an FEC encoding apparatus. Such a digital encoding circuitry, e.g., a digital signal processor (DSP), a Field-Programmable Gate Array (FPGA), an Application-Specific Integrated Circuit (ASIC), or a general purpose processor, needs to be programmed accordingly. Hence, yet further embodiments also provide a computer program having a program code for performing embodiments of the method, when the computer program is executed on a programmable hardware device.

According to a further aspect of the present disclosure, it is also provided an FEC encoding apparatus. The FEC encoding apparatus comprises a mapper which is configured to map information symbols to information symbol positions in a sequence of two-dimensional symbol blocks, wherein an $i$-th symbol block of the sequence has a preceding symbol block and a subsequent symbol block in the sequence, wherein at least some symbol blocks have information symbol positions and redundancy symbol positions. The FEC encoding apparatus comprises an encoder which is configured to generate redundancy symbols for the redundancy symbol positions of the symbol blocks in the sequence. The encoder is configured to generate first redundancy symbols for the $i$-th symbol block such that symbols at positions including or excluding redundancy symbol positions along a first dimension of the preceding symbol block concatenated with the symbols at information symbol positions and the first redundancy symbols along the first dimension of the $i$-th symbol block form a codeword of a first FEC component code. The encoder is also configured to generate second redundancy symbols for the subsequent symbol block such that symbols at the information symbol positions along a second dimension of the $i$-th symbol block concatenated with symbols at positions excluding redundancy symbol positions and the second redundancy symbols along the second dimension of the subsequent symbol block form a codeword of a second FEC component code.

Note that the amount of useful information symbols can vary between subsequent symbol blocks.

Despite different underlying information symbols in subsequent symbol blocks, the first and second redundancy symbols can comprise the same redundancy information in some embodiments.

Some embodiments relate to staircase codes with self-protected parity bits. This can lead to a considerably lower error floor without any performance degradation and without the parity-ringing effect, which can be crucial in future metro networks with distributed encoding. Embodiments can still guarantee good error floor properties and low residual bit error rates without a significant increase in complexity.

Brief description of the Figures

Some embodiments of apparatuses and/or methods will be described in the following by way of example only, and with reference to the accompanying figures, in which

Fig. 1          illustrates a block diagram of a sequence of two-dimensional symbol blocks;

Fig. 2          is a block diagram illustrating an example codeword;

Fig. 3          shows a block diagram illustrating an example sub-division of a symbol block;

Fig. 4          illustrates a block diagram representation of an example staircase code;

Fig. 5          is an example staircase code block structure. Information bits (white) and parity bits (shaded) are shown. Bits in block $\mathbf{B}_0$ are fixed;

Fig. 6          is an example staircase code without parity re-encoding. Information bits (white) and parity bits (shaded) are shown. Parity-bits are not used for reencoding;

Fig. 7          is an example of a proposed feed-forward staircase code block structure, where information bits and column redundancy bits are transmitted. Row redundancy bits are punctured. Bits in block $\mathbf{B}_0$ are fixed. Small squares illustrate permutation selected for low error-floors;

Fig. 8          shows a toy example;

Fig. 9          illustrates error probability curves for feed-forward and self-protecting feed-forward staircase codes;

Fig. 10         shows a first example of partial feed-forward staircase code where horizontal parities are re-encoded and vertical parities are not re-encoded;

Fig. 11         shows a second example of partial feed-forward staircase code where horizontal parities are re-encoded and vertical parities are not re-encoded;

Fig. 12         shows a variation of the second example of partial feed-forward staircase code where vertical parities are re-encoded and horizontal parities are not re-encoded;

Fig. 13          shows the effect of suppressed parity ringing in the code of the second example (Fig. 11);

Fig. 14          is a partial feed-forward staircase code with $L=2$

Fig. 15          shows the simulated error probability curves of feed-forward staircase codes and partial feed-forward staircase codes based on the second example (Fig. 11);

Fig. 16          shows the simulated error probability curves of partial feed-forward staircase codes based on the second example (Fig. 12) at 5 different code rates;

Fig. 17          shows a first example of a partial feed-forward self-protecting staircase code with $L=1$;

Fig. 18          shows a second example of a partial feed-forward self-protecting staircase code with $L=3$;

Fig. 19          illustrates a detailed illustration of encoding of parity and extra redundancy blocks for self-protection, $L=1$

Fig. 20          shows a simulated bit-error-rate of a partial feed-forward self-protection staircase code with $L=1$, $M=96$, and $R=3/4$;

Fig. 21, 22      show a toy example;

Fig. 23          shows an example of a rate-compatible staircase code based on self-protecting staircase codes;

Fig. 24          is an illustration of an optical system with one intermediate boarding node and intermediate channels each having error probability $\delta_1$;

Fig. 25          shows an example of a rate-compatible staircase code for a system with 4 intermediate nodes;

Fig. 26          is an illustration of an optical system with three intermediate boarding nodes and intermediate channels each having error probability $\delta_1$;

Fig. 27          shows a iustification of linear redundancy adjustment, for small values of per-hop bit-error probability $\delta_1$, the optimal (minimum required) redundancy for successful transmission scales almost linearly with number of hops $h$;

Fig. 28          shows a block error rate for a 2-hop system with a rate-compatible staircase code containing L=13 blocks (excluding zero blocks). Labels indicate the number of blocks encoded by node 2;

Fig. 29          shows an illustration of constant block-length modification of the example of Fig. 23;

Fig. 30          shows an illustration of constant block-length modification of the solution of Fig. 23 for a 4-hop network;

Fig. 31          shows a simulated error rate performance of self-protecting staircase code with 3 different sizes of protruding blocks;

Fig. 32          illustrates a minimal stall pattern used to estimate FF-SC error floors for component codes with $t = 3$; and

Fig. 33          shows block and bit-error probabilities of feed-forward and partial feed-forward self-protecting staircase codes with parameters of Tables I and II. Block and bit error-floor estimates are also shown.

## Description of Examples

Various examples will now be described more fully with reference to the accompanying drawings in which some examples are illustrated. In the figures, the thicknesses of lines, layers and/or regions may be exaggerated for clarity.

Accordingly, while examples are capable of various modifications and alternative forms, examples thereof are shown by way of example in the figures and will herein be described in detail. It should be understood, however, that there is no intent to limit examples to the particular forms disclosed, but on the contrary, examples are to cover all modifications, equivalents, and alternatives falling within the scope of the invention. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular examples only and is not intended to be limiting. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which examples belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

For a better understanding of examples described herein, let us first describe the concept of staircase codes.

A staircase code is a block-wise recursively encoded FEC scheme. In staircase encoding, symbol blocks include data or information symbols and redundancy symbols, such as parity symbols. The information symbols can comprise useful data in some examples. In examples, one or more information bits may be mapped to an information symbol. Information symbols in a stream of information symbols can be mapped to a series of two-dimensional symbol blocks. The parity symbols can be computed across multiple symbol blocks in such a manner that concatenating a row of the matrix transpose of a preceding encoded symbol block with a corresponding row of a symbol block that is currently being encoded forms a valid codeword of a FEC component code. In various examples, a conventional FEC code (e.g., Hamming, BCH, Reed-Solomon, etc.) in systematic form can be selected to serve as the component code.

For example, when encoding a second symbol block in the series of symbol blocks, the parity symbols in the first row of the second symbol block can be chosen so that the first row of the matrix transpose of a preceding first symbol block, the information symbols of the first row of the second symbol block, and the parity symbols of the same row of the second block together form a valid codeword of the FEC component code. Parity symbols could equivalently be computed by concatenating a column of the previous encoded symbol block with a corresponding column of the matrix transpose of the symbol block that is currently being encoded. With this type of relationship between symbol blocks, in a staircase structure that includes alternating encoded symbol blocks and matrix transposes of encoded symbol blocks, each two-block wide row along a stair "tread" and each two-block high column along a stair "riser" forms a valid codeword of the FEC component code.

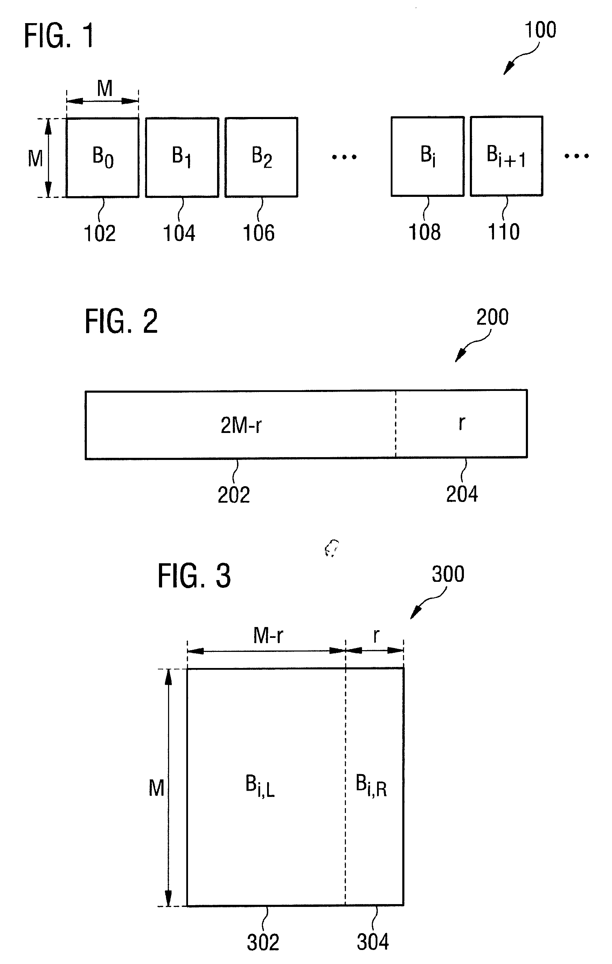

Fig. 1 is a block diagram illustrating a sequence 100 of two-dimensional symbol blocks. In the sequence 100, each block $\mathbf{B}_i$ (for $i \geqq 0$) 102, 104, 106, 108, 110 can be an $M \times M$ array of symbols. As mentioned before, each symbol in each block 102, 104, 106, 108, 110 may be one or more bits in length. Staircase codes are characterized by the relationship between the symbols in successive blocks 102, 104, 106, 108, 110.

During FEC encoding according to a staircase code, a FEC code in systematic form can first be selected to serve as the component code. This code, hereinafter C, can be selected to have a codeword length of $n = 2M$ symbols, $r$ of which can be parity symbols. As illustrated in Fig. 2, which is a block diagram illustrating an example length $2M$ codeword 200, the leftmost $2M - r$ symbols 202 constitute information or data symbol positions of $C$, and the rightmost $r$ symbols 204 are parity symbol positions, or more generally redundancy symbol positions, of $C$.

For illustrative purposes consider the example sub-division of a symbol block as shown in Fig. 3. The example symbol block 300 is sub-divided into $M - r$ leftmost columns 302 and $r$ rightmost columns 304, where $\mathbf{B}_{i,L}$ denotes the sub-matrix including the leftmost columns, and similarly $\mathbf{B}_{i,R}$ denotes the sub-matrix including the rightmost columns of the symbol block $\mathbf{B}_i$.

Entries of an initial symbol block $\mathbf{B}_0$ can be set to predetermined symbol values, e.g., all zeros. For $i \geq 1$, information symbols, specifically $M(M-r)$ such symbols, which can include information that is received from a information streaming source, for example, can be arranged or distributed into $\mathbf{B}_{i,L}$ by mapping the symbols into $\mathbf{B}_{i,L}$. Then, the entries of $\mathbf{B}_{i,R}$ can be computed or generated. Thus, information symbols from a symbol stream can be mapped to information symbol positions $\mathbf{B}_{i,L}$ in a sequence of two-dimensional symbol blocks $\mathbf{B}_i$, and parity symbols for the parity symbol positions $\mathbf{B}_{i,R}$ in each symbol block can be computed.

In computing the parity symbols, an M $\times$ (2M-r) matrix, $\mathbf{A} = [\mathbf{B}_{i-1}^T \quad \mathbf{B}_{i,L}]$, where $\mathbf{B}_{i-1}^T$ is the matrix-transpose of $\mathbf{B}_{i-1}$, can be formed. The entries of $\mathbf{B}_{i,R}$ can then be computed such that each of the rows of the matrix

$\begin{bmatrix} \mathbf{B}_{i-1}^T & \mathbf{B}_{i,L} & \mathbf{B}_{i,R} \end{bmatrix}$ is a valid codeword of *C*. That is, the elements in the *j*-th row of $\mathbf{B}_{i,R}$ can be exactly the *r* parity symbols that result from encoding the 2*M-r* symbols in the *j*-th row of **A**. Generally, the relationship between successive blocks in a staircase code satisfies the following relation: For any *i* ≥ 1, each of the rows of the matrix $\begin{bmatrix} \mathbf{B}_{i-1}^T & \mathbf{B}_i \end{bmatrix}$ is a valid codeword of the component code *C*.

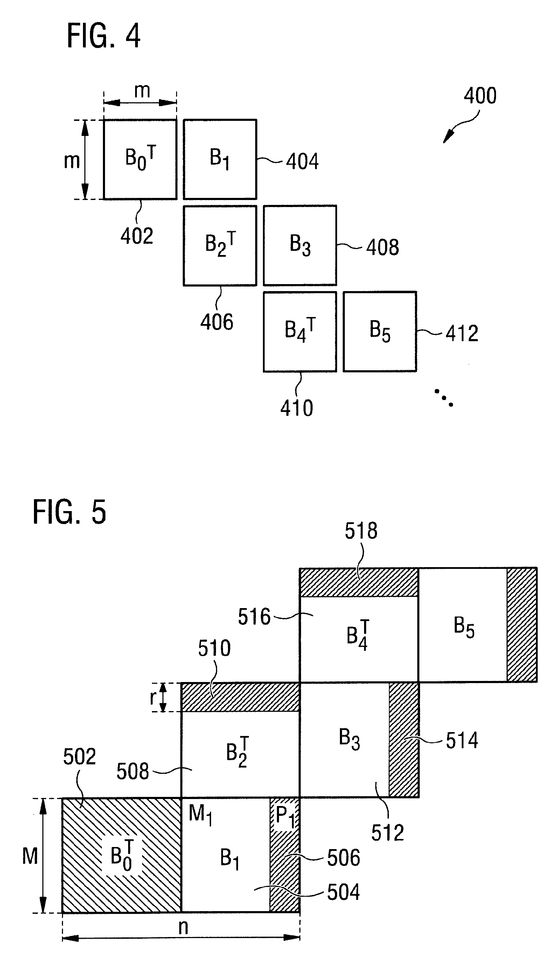

An equivalent description of staircase codes, from which their name originates, is suggested in **Figs. 4** and **5,** which are equivalent block diagram representations of an example staircase code. Every row and every column that spans two symbol blocks 402, 404, 406, 408, 410, 412 in the "staircase" 400 is a valid codeword of C. It should be apparent that each two-block row in Fig. 4 is a row of the matrix $\begin{bmatrix} \mathbf{B}_{i-1}^T & \mathbf{B}_{i,L} & \mathbf{B}_{i,R} \end{bmatrix}$, as described above for the computation of redundancy symbols. The columns are also consistent with this type of computation. Consider the first two-block column that spans the first column of $\mathbf{B}_1$ 404 and the first column of $\mathbf{B}_2^T$ 406. In the example computation described above, the coding symbols for the first row of $\mathbf{B}_2$ would be computed such that $\begin{bmatrix} \mathbf{B}_1^T & \mathbf{B}_{2,L} & \mathbf{B}_{2,R} \end{bmatrix}$ is a valid codeword of *C*. Since the first column of $\mathbf{B}_1$ 404 would be the first row in $\mathbf{B}_1{}^T$, and similarly the first column of $\mathbf{B}_2{}^T$ 406 would be the first row of $\mathbf{B}_2$, the staircase structure 400 is consistent with the foregoing example coding symbol computation.

Thus, the redundancy symbols for a block $\mathbf{B}_i$ could be computed row-by-row using corresponding rows of $\mathbf{B}_{i-1}^T$ and $\mathbf{B}_i$, as described above. A column-by-column computation using corresponding columns of $\mathbf{B}_{i-1}$ and $\mathbf{B}_i{}^T$ would be equivalent. Stated another way, parity symbols could be computed for the redundancy symbol positions in each symbol block $\mathbf{B}_i$, where *i* is a positive integer, in a sequence such that symbols at symbol positions along one dimension (row or column) of the two-dimensional symbol block $\mathbf{B}_{i-1}$ in the sequence, concatenated with the information symbols and the parity symbols along the other dimension (column or row) in the symbol block $\mathbf{B}_i$, form a codeword of a FEC component code. In a staircase code, symbols at symbol positions along the one dimension (row or column) of the symbol block $\mathbf{B}_i$ in the sequence, concatenated with the information symbols and the parity symbols along the other dimension (column or row) in the symbol block $\mathbf{B}_{i+1}$, also form a codeword of the FEC component code.

The two dimensions of the symbol blocks in this example are rows and columns. Thus, in one embodiment, the concatenation of symbols at symbol positions along a corresponding column and row of the symbol blocks $\mathbf{B}_{i-1}$ and $\mathbf{B}_i$, respectively, forms a codeword of the FEC component code, and the concatenation of symbols at symbol positions along a corresponding column and row of the symbol blocks $\mathbf{B}_i$ and $\mathbf{B}_{i+1}$, respectively, also forms a codeword of the FEC component code. The "roles" of columns and rows could instead be interchanged. The coding symbols could be computed such that the concatenation of symbols at symbol positions along a corresponding row and column of the symbol blocks $\mathbf{B}_{i-1}$ and $\mathbf{B}_i$, respectively, forms a codeword of the FEC component code, and the concatenation of symbols at symbol positions along a corresponding row and column of the symbol blocks $\mathbf{B}_i$ and $\mathbf{B}_{i+1}$, respectively also forms a codeword of the FEC component code.

As explained above, the fundamental building block of a conventional staircase code can be a binary, linear, systematic block code *C(n, k),* referred to as a component code, with block-length *n* (required to be even) and number of information bits *k.* Let $R_c$ = *k*/*n* be the component code rate. For *M*= *n*/2, the dimension of each staircase block $\mathbf{B}_i$ is *M* × *M.* For a staircase code to have non-trivial rate (i.e. *R* > 0) the component code rate must satisfy $R_c$ > 1/2.

The first staircase block $\mathbf{B}_0$ the sequence comprises predetermined initial symbols at information symbol positions. For example, it can be fixed to all-zero bit-values. Let *r* = *n* - *k* be the number of parity bits in a component codeword. Let **G** denote a *k* × *n* systematic generator matrix for *C*. We can denote by $\mathbf{G}_p$ the *k* × *r* sub-matrix of **G** containing the *r* columns which correspond to the parity bits in each codeword. For *i* ∈ {1, 2, ... }, given block *i*-1, to encode the *i*-th block, first fill an *M* × (*M* - *r*) matrix $\mathbf{M}_i$ with information bits. Next, calculate the *M* × *r* matrix $\mathbf{P}_i$ of parity symbols or bits according to

$$P_i = \begin{bmatrix} B_{i-1}^T & M_i \end{bmatrix} G_p \tag{1}$$

where (.)$^T$ denotes matrix transpose. The *i*-th symbol block is then given by $B_i = [M_i\,P_i]$ . The rate of a staircase code is given by *R* = 2$R_c$ - 1, where we assumed that the smallest transmission granularity is a complete block $\mathbf{B}_i$.

Staircase codes can be decoded using a sliding-window decoder. Consider the blocks in **Fig. 5** now to be received blocks buffered in a decoding window of exemplary length 6, with all except $\mathbf{B}_0$ 502 corrupted by a Binary Symmetric Channel (BSC). Decoding proceeds in iterations. Let $l \in \{1, 2 \ldots, l_{\max}\}$ denote decoding iterations, with the maximum number of iterations denoted by $l_{\max}$. During iteration $l$, for each $i \in \{1, 2, \ldots, 5\}$, form the matrix $\begin{bmatrix} B_{i-1}^T & B_i \end{bmatrix}$ and decode each row of the matrix by a component code decoder, e.g., a syndrome-based decoder or a bounded distance decoder. Once $l = l_{\max}$ is reached, the window "slides" by shifting out decoded block $\mathbf{B}_0$ 502 and shifting in a newly received block $\mathbf{B}_6$. The decoding process continues indefinitely in this manner. In practice, the component code decoder can be implemented using efficient table-lookup methods for syndrome-based decoding to achieve very high decoding throughputs.

Substituting $\mathbf{B}_{i-1} = [\mathbf{M}_{i-1} \ \mathbf{P}_{i-1}]$ into (1), we obtain $\mathbf{P}_i = [[\mathbf{M}_{i-1} \ \mathbf{P}_{i-1}]^T \ \mathbf{M}_i] \ \mathbf{G}_p$ which is a linear recursion of the parity-bit matrix $\mathbf{P}_i$. We can refer to this as the parity-propagation property of staircase codes. The presence of feedback in the encoding process leads to a number of issues, the most significant of which is the lack of a termination mechanism. Although staircase codes were designed for continuous transmission applications where termination is not necessary, allowing the encoding process to terminate after a certain number of blocks could extend their domain of application significantly. Furthermore, a terminated staircase code could be decoded by two sliding window decoders working in parallel from both ends of the code. The decoding throughput is doubled at a cost of extra hardware, a favorable trade-off in high-throughput optical-fiber systems.

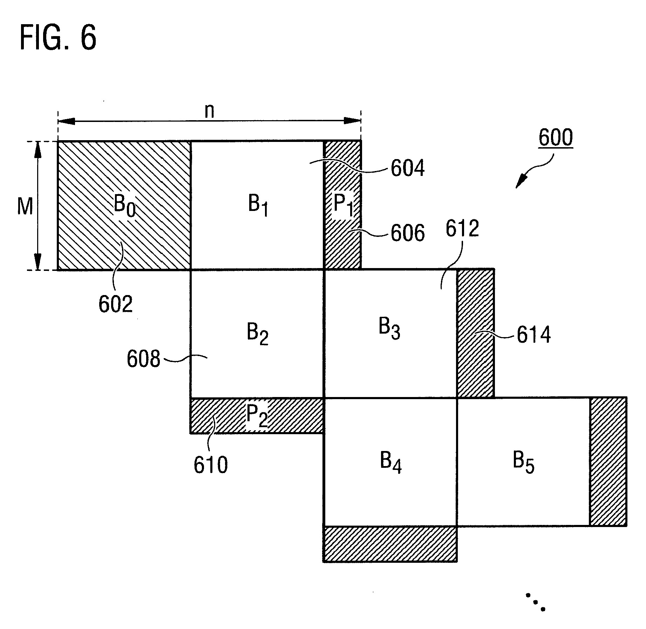

The most pragmatic approach to mitigate the effect of parity propagation would be to not re-encode the parity symbol block $\mathbf{P}_i$ of the $i$-th symbol block $\mathbf{B}_i$ when determining the parity symbol block $\mathbf{P}_{i+1}$ of the subsequent symbol block $\mathbf{B}_{i+1}$. In other words, in this example only symbols at information symbol positions of blocks $\mathbf{B}_i$ and $\mathbf{B}_{i+1}$ are encoded. Parity symbols positions are not (re-)encoded. Such an example is shown in **Fig. 6**. However, it becomes quickly obvious that this example suffers from some problems. Most importantly, if high-rate component codes with error correcting capability $t$ are used, the occurrence of $t + 1$ errors in the parity-part of a component code will not be corrected. Hence, if there are $t + 1$ errors in the parity part of a vertical codeword, $t+1$ errors in the parity part of a horizontal codeword and an additional error in the intersection of both vertical and horizontal codewords, this additional error will not be corrected and will contribute to the error floor of the code, which will become unacceptably high for most applications. Especially in optical communications, where usually residual bit error rates in the range of $10^{-13}$ to $10^{-15}$ are required, a different approach is necessary.

The present disclosure also proposes staircase codes which have so-called self-protected parity symbols or bits. This can lead to a considerably lower error floor without any performance degradation and without the parity-ringing effect.

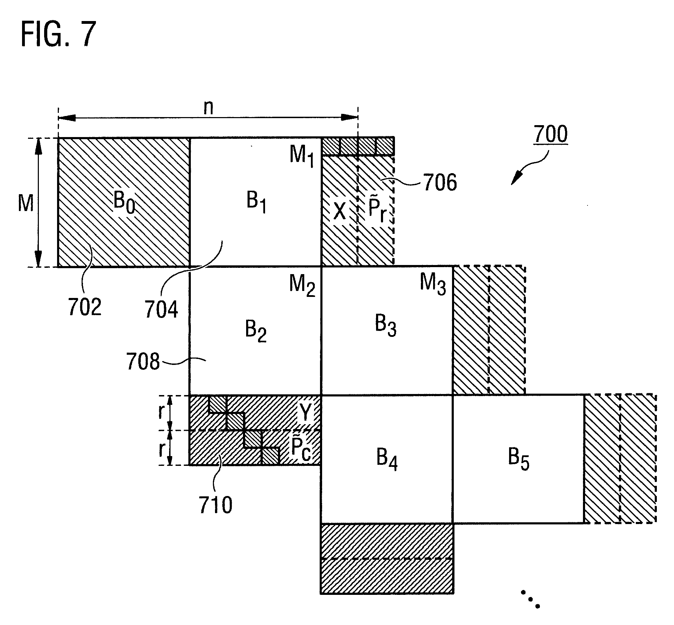

Consider the example self-protecting Feed-Forward Staircase Code (FF-SC) structure 700 shown in **Fig. 7**. Here, a row redundancy symbol sub-matrix $[\mathbf{X} \ \tilde{\mathbf{P}}_r]$ 706 associated with a row component code) comprises the same redundancy information as a column redundancy symbol sub-matrix $[\mathbf{Y} \ \tilde{\mathbf{P}}_c]$ 710 associated with a column component code. Note that the redundancy symbol sub-matrices $[\mathbf{X} \ \tilde{\mathbf{P}}_r]$ 706 and $[\mathbf{Y} \ \tilde{\mathbf{P}}_c]$ 710 can comprise respective parity symbols $\tilde{\mathbf{P}}_r$ and $\tilde{\mathbf{P}}_c$ as well as respective adjustable self-protection symbols $\mathbf{X}$ and $\mathbf{Y}$, which will be explained further below.

Thus, some examples of the present disclosure propose an FEC encoding concept, where information symbols are mapped to information symbol positions in a sequence of two-dimensional symbol blocks $\mathbf{B}_0, \mathbf{B}_1, \mathbf{B}_2$, etc. Symbol block $\mathbf{B}i$ ($i \geq 1$) has a preceding symbol block $\mathbf{B}_{i-1}$ and a subsequent symbol block $\mathbf{B}i+1$ in the sequence. Except the initial symbol block $\mathbf{B}_0$, each symbol block $\mathbf{B}_i$ can have information symbol positions and redundancy symbol positions.

For example, when generating redundancy symbols for the redundancy symbol positions of the symbol blocks in the sequence, row redundancy symbols $[\mathbf{X} \ \tilde{\mathbf{P}}_r]$ 706 for the symbol block $\mathbf{B}i$ can be generated such that information symbols at information symbol positions along a row of the preceding symbol block $\mathbf{B}_{i-1}$ concatenated with both the information symbols and the row redundancy symbols $[\mathbf{X} \ \tilde{\mathbf{P}}_r]$ 706 along a respective row of the symbol block $\mathbf{B}_i$ form a codeword of a row component code. Column redundancy symbols $[\mathbf{Y} \ \tilde{\mathbf{P}}_c]$ 710 for the subsequent symbol block $\mathbf{B}i+1$ can be generated such that the information symbols at the information symbol positions along a column of the symbol block $\mathbf{B}_i$ concatenated with information symbols and the column redundancy symbols $[\mathbf{Y} \ \tilde{\mathbf{P}}_c]$ 710 along a respective column of the subsequent symbol block $\mathbf{B}i+1$ form a codeword of a column FEC component code. Thereby, the row and column redundancy symbols $[\mathbf{X} \ \tilde{\mathbf{P}}_r]$ 706 and $[\mathbf{Y} \ \tilde{\mathbf{P}}_c]$ 710 are generated to both carry the same redundancy information. Similar to the example of Fig. 6, redundancy symbol blocks are not re-encoded between subsequent blocks to avoid parity ringing.

Examples of self-protecting feed-forward staircase codes of Fig. 7 have two important properties. First, there is no propagation of parity symbols beyond the last non-zero information block. This allows the code to be used in applications where different blocks are encoded by different users (no parity ringing), for example. Second, some examples constrain pairs of row and column redundancy or parity blocks to have identical values under some fixed permutation. Thus, in some examples, the row redundancy symbols $[\mathbf{X} \ \tilde{\mathbf{P}}_r]$ 706 can be a permuted version of the column redundancy symbols $[\mathbf{Y} \ \tilde{\mathbf{P}}_c]$ 710. In other words, row redundancy symbol sub-matrix 706 and the column redundancy symbol sub-matrix 710 contain identical redundancy symbols, however at permuted redundancy symbol positions or indices. This property allows the parity blocks to be protected by both row and column component codes, leading to better error floor performance than the feed-forward staircase codes explained above. This scheme suffers from no rate-loss since column parity blocks need not be transmitted.

As will become apparent below, the row and column redundancy symbols $\mathbf{X}, \tilde{\boldsymbol{P}}_r$ and $\mathbf{Y}, \tilde{\boldsymbol{P}}_c$ may not only contain respective parity symbols of the first and the second component code. In fact, each of the row and column redundancy symbols $\mathbf{X}, \tilde{\boldsymbol{P}}_r$ and $\mathbf{Y}, \tilde{\boldsymbol{P}}_c$ can comprise respective adjustable self-protection symbols $\mathbf{X}, \mathbf{Y}$ and respective parity symbols $\tilde{\boldsymbol{P}}_r, \tilde{\boldsymbol{P}}_c$. The block 710 at the bottom of even-indexed symbol blocks can be referred to as column redundancy block. Each column redundancy block consists of a parity block $\tilde{\boldsymbol{P}}_c$ and an adjustable self-protection block $\mathbf{Y}$. The block 706 to the right of odd-indexed information blocks can be referred to as row redundancy block, each consisting of a parity block $\tilde{\boldsymbol{P}}_r$ and an adjustable self-protection block $\mathbf{X}$, which can be both punctured, for example.

The adjustable row self-protection symbols $\mathbf{X}$ can be adjusted to cause the information symbols $\mathbf{M}_{i-1}$ at information symbol positions along a row of the preceding symbol block $\mathbf{B}_{i-1}$ concatenated with the information symbols $\mathbf{M}_i$, the adjustable row self-protection symbols $\mathbf{X}$, and the row parity symbols $\tilde{\boldsymbol{P}}_r$ along a corresponding row of the symbol block $\mathbf{B}_i$ to form a valid codeword of the row component code. Likewise, the adjustable column self-protection symbols $\mathbf{Y}$ can be adjusted such that the information symbols $\mathbf{M}_i$ at the information symbol positions along a column of the symbol block $\mathbf{B}_i$ concatenated with the information symbols $\mathbf{M}_{i+1}$, the adjustable column self-protection symbols $\mathbf{Y}$, and the column parity symbols $\tilde{\boldsymbol{P}}_c$ along a corresponding column of the subsequent symbol block $\mathbf{B}_{i+1}$ form a valid codeword of the column component code. Said differently, the adjustable row self-protection symbols $\mathbf{X}$ and row parity symbols $\tilde{\boldsymbol{P}}_r$ can be chosen such that the information symbols $\mathbf{M}_{i-1}$ along a row of the preceding symbol block $\mathbf{B}_{i-1}$ concatenated with the information symbols $\mathbf{M}_i$, the adjustable row self-protection symbols $\mathbf{X}$, and the row parity symbols $\tilde{\boldsymbol{P}}_r$ are a valid codeword of the row component code. At the same time the adjustable column self-protection symbols $\mathbf{Y}$ and column parity symbols $\tilde{\boldsymbol{P}}_c$ can be chosen to be a permuted version of $\mathbf{X}$ and $\tilde{\boldsymbol{P}}_r$, respectively, and such that the information symbols $\mathbf{M}_i$ along a column of the symbol block $\mathbf{B}_i$ concatenated with the information symbols $\mathbf{M}_{i+1}$, the adjustable column self-protection symbols $\mathbf{Y}$, and the column parity symbols $\tilde{\boldsymbol{P}}_c$ along a corresponding column of the subsequent symbol block $\mathbf{B}_{i+1}$ are a valid codeword of the column component code. The skilled person having benefit from the present disclosure will appreciate that the roles of rows and columns are interchangeable.

Some examples of the self-protecting feed-forward staircase code of Fig. 7 do not re-encode redundancy symbols of previous symbol blocks. Instead, row and column redundancy symbols carrying the same redundancy information are merely associated with a single pair of subsequent symbol blocks. Said differently, row and column redundancy symbols carrying the same or identical redundancy information and associated with a subsequent pair of symbol blocks (e.g., $\mathbf{B}_{i+1}, \mathbf{B}_{i+2}$) are independent from row and column redundancy symbols carrying other redundancy information associated with the previous pair of symbol blocks (e.g., $\mathbf{B}_{i-1}, \mathbf{B}_i$). There are multiple ways of how this self-protection can be achieved. An illustrative example will be described below.

As in a conventional staircase code, an example self-protecting FF-SC parity block contains parity symbols or bits calculated during component code encoding. A difference in an example self-protecting FF-SC is that the symbols or bits in a self-protection block $\mathbf{X}$ or $\mathbf{Y}$, which can be regarded as a sub-set of the information symbols of component codes, are additionally constrained. For an $m \times n$ matrix $\mathbf{Q}$, we denote a vectorization of $\mathbf{Q}$ by vec($\mathbf{Q}$), where the resulting vector is assumed to be a column vector and the mapping between matrix and vector indices is given by a bijection $v$: $[0, m - 1] \times [0, n - 1] \to [0, mn - 1]$. The inverse of vec() is denoted by vec$^{-1}$() with the underlying mapping $v^{-1}$, the inverse of $v$. For example, the mappings of the column-wise vectorization and its inverse are given by $v(i, j) = jm + i$ and $v^{-1}(i) = \left(i \bmod m, \left\lfloor \frac{i}{m} \right\rfloor\right).$ Let $\pi_1$ and $\pi_2$ be permutations defined by

$$\pi_b(\boldsymbol{A}) \triangleq \mathrm{vec}^{-1}(\boldsymbol{\Pi}_b \mathrm{vec}(\boldsymbol{A}))$$

where $b \in \{1, 2\}$, $\mathbf{A}$ is an $M \times r$ matrix, and $\mathbf{II}_b$ is an $Mr \times Mr$ permutation matrix. By definition, $\pi_b$ are bijective maps, with the property $\pi_b(\mathbf{A} + \mathbf{B}) = \pi_b(\mathbf{A}) + \pi_b(\mathbf{B})$. We define example self-protection constraints

$$\begin{aligned} \boldsymbol{Y} &= (\pi_1(\boldsymbol{X}))^T \\ \tilde{\boldsymbol{P}}_c &= (\pi_2(\tilde{\boldsymbol{P}}_r))^T. \end{aligned} \qquad (2)$$

Since $\pi_b$ are bijective, as long as the self-protection constraints are satisfied, we can puncture either the column or row redundancy blocks 706, 710. Thus, the information symbols of the symbol block $\mathbf{B}_i$ and of the subsequent symbol block **B***i*+1 can be transmitted along with either the row redundancy symbols **X**, $\tilde{\boldsymbol{P}}_r$ 706 or the column redundancy symbols **Y**, $\tilde{\boldsymbol{P}}_c$ 710. Since both redundancy symbol blocks 706, 710 carry the same redundancy information, the transmission of only one of the blocks 706 or 710 is sufficient.

For consistency with Fig 7, we puncture the row redundancy blocks 706 in the following example. The skilled person having benefit from the present disclosure will appreciate that puncturing the column redundancy blocks 710 would likewise be possible. Due to the constraints imposed on self-protection blocks **X, Y,** *M* should satisfy *2M + r = k,* hence *M = (k - r)/2* (assuming *k* and *r* have the same parity, which can be achieved with shortening). For computing the rate, we can first assume that always an even number of blocks **B**$_i$ are transmitted as smallest granularity. The rate of a self-protecting FF-SC is then $R_{\text{FF}} = 2R_c$ - *1 = R,* which is identical to the rate of a conventional staircase code. If we want to achieve the finer granularity of conventional staircase codes with single blocks, we can define that the parity and self-protection blocks **Y** and $\tilde{\boldsymbol{P}}_c$ are attached to each block with odd index. In that case, with a total of A blocks transmitted we have

$$R'_{\text{FF}} = \frac{2k - n}{2k - n + 4\lfloor \frac{\Lambda+1}{2}\rfloor \frac{1}{\Lambda}(n - k)},$$

which takes into account the potential transmission of an odd number of blocks. As $\limsup_{\Lambda\to\infty} \lfloor \frac{\Lambda+1}{2}\rfloor \frac{1}{\Lambda} = \liminf_{\Lambda\to\infty} \lfloor \frac{\Lambda+1}{2}\rfloor \frac{1}{\Lambda} = \frac{1}{2},$ we get

$$\lim_{\Lambda\to\infty} R'_{\text{FF}} = \frac{2k - n}{2k - n + 2(n - k)} = R_{\text{FF}}.$$

We can slightly generalize the component code definition to allow different binary linear block codes to be used as row and column component codes. Thus, the row component code can but need not be different from the column component code. Given block-length *n* and number of information bits *k*, let $C_r(n, k)$ be a row component code with $k \times n$ systematic generator matrix **G.** Let $C_c(n, k)$ be a column component code with $k \times n$ systematic generator matrix **F.** Let **G**$_p$ and **F**$_p$ denote the sub-matrices or portions containing the *r* columns of **G** and **F** corresponding to parity symbols or bits. Due to the self-protection block **X** or **Y,** the last *r* symbols out of *k* information symbols in a component codeword are constrained. We highlight this fact by partitioning **G**$_p$ and **F**$_p$ according to

$$\boldsymbol{G}_p = \begin{bmatrix} \boldsymbol{G}_i \\ \boldsymbol{G}_r \end{bmatrix} \quad \boldsymbol{F}_p = \begin{bmatrix} \boldsymbol{F}_i \\ \boldsymbol{F}_r \end{bmatrix},$$

where **G**$_i$ and **F**$_i$ are $(k - r) \times r$ sub-matrices related to information symbols and **G**$_r$ and **F**$_r$ are $r \times r$ sub-matrices related to the self-protecting symbols **X** or **Y.**

Consider the encoding operation over symbol blocks **B**$_0$, **B**$_1$, and **B**$_2$ in Fig. 7. Subsequent blocks are encoded in the same manner. By horizontally concatenating information symbols **B**$_0$ and **B**$_1$, we obtain intermediate row parity symbols

$$\boldsymbol{P}_r = \begin{bmatrix} \boldsymbol{B}_0 & \boldsymbol{B}_1 \end{bmatrix} \boldsymbol{G}_i$$

By vertically concatenating information symbols **B**$_1$ and **B**$_2$, we obtain intermediate column parity symbols

$$\boldsymbol{P}_c = \boldsymbol{F}_i^T \begin{bmatrix} \boldsymbol{B}_1 \\ \boldsymbol{B}_2 \end{bmatrix}$$

Note that intermediate parity symbols **P**$_r$ and **P**$_c$ are not the same as the (final) parity symbols $\tilde{\boldsymbol{P}}_r$ and $\tilde{\boldsymbol{P}}_c$. Consider the entries of the $M \times r$ self-protecting symbol sub-matrix **X** and the $r \times M$ self-protecting symbol sub-matrix **Y** to be adjustable variables. According to the structure shown in Fig. 7, we can write the (final) parity symbol matrices $\tilde{\boldsymbol{P}}_r$ and $\tilde{\boldsymbol{P}}_c$ as

$$\tilde{P}_r = P_r + XG_r, \qquad \tilde{P}_c = P_c + F_r^T Y$$

Imposing the self-protection conditions of Eq. (2), we obtain

$$P_c + (\pi_2(P_r))^T = F_r^T Y + (\pi_2(\pi_1^{-1}(Y^T)G_r))^T .$$

Each of the above terms is an $r \times M$ matrix. Let vec($\cdot$) be the column-wise vectorization and let $y$ = vec($Y$), $p_c$ = vec($P_c$), and $p_r$ = vec(($\pi_2(P_r))^T$). Let $\Pi_T$ be the permutation matrix satisfying $Y^T$ = vec$^{-1}$ ($\Pi_T$ vec($Y$)). Using the fact that for some matrix **Q**

$$\mathrm{vec}(QY) = (I_M \otimes Q)\mathrm{vec}(Y),$$

the above expression can be written as

$$p_c + p_r = [I_M \otimes F_r^T + \Pi_T \Pi_2 \Pi_T (I_M \otimes G_r^T)\Pi_T \Pi_1^{-1}\Pi_T]y \triangleq Ay.$$

If **A** is invertible, then the self-protecting symbol sub-matrix **Y** is given by

$$y = A^{-1}(p_c + p_r)$$
$$\triangleq A^{-1}c. \qquad\qquad\qquad (3)$$

With Eq. (2) also the self-protecting symbol sub-matrix **X** can be determined. Then $\tilde{P}_r$ and $\tilde{P}_c$ can be determined according to $\tilde{P}_r = P_r + XG_r$ and $\tilde{P}_c = P_c + F_r^T Y$. Note that the above equations can be regarded as only one of many possible ways for determining the row and column redundancy symbols **X**, $\tilde{P}_r$ and **Y**, $\tilde{P}_c$. More generally speaking, the row parity symbols $\tilde{P}_r$ can be generated such that the information symbols along a row of the preceding symbol block $B_{i-1}$ concatenated with the information symbols, the first adjustable self-protection symbols **X,** and the first parity symbols $\tilde{P}_r$ along the respective row of the symbol block **B***i* form a codeword of row component code $C_r$ *(n, k)*. Likewise, the column parity symbols $\tilde{P}_c$ can be generated such that the information symbols along a column of the symbol block $B_i$ concatenated with the information symbols, the second self-protection adjustable symbols **Y,** and the second parity symbols $\tilde{P}_c$ along a respective column of the subsequent symbol block **B***i*+1 form a codeword of the column component code $C_c(n, k)$. Thereby the second adjustable self-protection symbols **Y** can be a permuted version of the first adjustable symbols **X** in accordance with a first permutation rule $\pi_1$ or **II**$_1$. The second parity symbols $\tilde{P}_c$ can be a permuted version of the first parity symbols $\tilde{P}_r$ in accordance with a second permutation rule $\pi_2$ or **II**$_2$. In some examples, the first permutation rule can be different from the second permutation rule. Furthermore, the second adjustable self-protection symbols **Y** can be a permuted version of the first parity symbols $\tilde{P}_r$ in accordance with a first permutation rule $\pi_1$ or **II**$_1$. The second parity symbols $\tilde{P}_c$ can be a permuted version of the first adjustable self-protection symbols **X** in accordance with a second permutation rule $\pi_2$ or **II**$_2$.

More particularly, in the example described herein, generating the row parity symbols $\tilde{P}_r$ includes determining intermediate row parity symbols $P_r$ based on (linearly) combining a concatenation of the information symbols along the rows of the preceding symbol block $B_{i-1}$ and the information symbols along the respective rows of the symbol block $B_i$ according to a first portion $G_i$ of the row component code $C_r(n, k)$ (e.g., $P_r = [B_0\ B_1]\ G_i$). Generating the column parity symbols $\tilde{P}_c$ includes determining intermediate column parity symbols $P_c$ based on (linearly) combining a concatenation of the information symbols along the columns of the symbol block $B_i$ and the information symbols along respective columns of the subsequent symbol block **B***i*+1 according to a first portion $F_i$ of the column component code $C_c(n, k)$

(e.g., $P_c = F_i^T \begin{bmatrix} B_1 \\ B_2 \end{bmatrix}$).

More particularly, according to the illustrated example, generating the row parity symbols $\tilde{P}_r$ can further include determining or generating one of the row or the column adjustable symbols **X, Y,** i.e., either **X** or **Y,** based on a combination of first and second generator matrices $\mathbf{G}_r$, $\mathbf{F}_r$ corresponding to a respective second portion of the row and column component codes $C_r$ *(n, k)* and $C_c$ *(n, k)*, first and second permutation matrices $\Pi_1$ and $\Pi_2$ corresponding to the first and second permutation rule, and the intermediate row and column parity symbols $\mathbf{P}_r$, $\mathbf{P}_c$.and The respective other adjustable symbols **Y, X** can be determined based on the generated row or the column adjustable symbols **X, Y** and the first permutation rule $\pi_1$.

The invertibility of the above matrix **A** (see Eq. (3)) depends on the choices of $C_r$*(n, k)*, $C_c$*(n, k)*, **F, G,** $\Pi_1$, and $\Pi_2$. Using the same row and column component codes $C_r$*(n, k)*, $C_c$*(n, k)*, we have found that searching over the space of all $\Pi_1$ and $\text{II}_2$ can quickly produce an invertible **A**. For example, the search and calculation of **A**$^{-1}$ can be performed offline at design time, since information bits are only involved in the calculation of *c*. The main complexity of self-protecting FF-SC encoding is the multiplication in Eq. (3) between an $Mr \times Mr$ matrix and an $Mr \times 1$ vector. The complexity of this operation depends on the choice of permutation matrices $\Pi_1$ and $\Pi_2$. For instance, the permutation matrices may be chosen such that the hardware implementation is simplified or such that **A**$^{-1}$ has a special structure easing the multiplication.

In other examples, the row and column generator polynomials $g_r(x)$, $g_c(x)$ of row and column component codes $C_r$(n, k), $C_c$(n, k) can be reciprocals to ensure the invertibility of **A.** For example, if $g_r(x)$ has roots at $\{\alpha, \ldots, \alpha^{2t}\}$ then $g_c(x)$ is required to have roots at $\{\alpha^{-1}, \ldots, \alpha^{-2t}\}$. Reciprocal generator polynomials have the property that the "mirror image", i.e., the reflection around its center, of a codeword for the row code is a codeword for the column code. Hence, the same decoder can be used to decode both row and column codes, with some additional logic to reverse the bit indexing. In general, we may allow also for distinct codes in row and column directions, however, using the reciprocal generator polynomials has the advantage that a single decoder engine has to be implemented and can be used, i.e., in general we want to allow distinct row and column generator polynomials, but in a preferred embodiment, we want to use the above mentioned description with reciprocal generator polynomials.

The matrix **A**$^{-1}$ can be dense and is not block diagonal in general, which can increase the encoding complexity. However, exploiting the cyclic structure within **A**$^{-1}$, we can calculate y using $M$ multiplications between an $r \times r$ matrix and a $1 \times r$ vector.

We illustrate the self-protection feed-forward staircase codes using an example with the following row code with *n* = 10 and *k* = 8 that generates one additional parity bit and the parity of odd bit positions and has the following systematic generator matrix

$$
G = \begin{pmatrix}
1 & & & & & & & & 1 & 1 \\
& 1 & & & & & & & 1 & 0 \\
& & 1 & & & & & & 1 & 1 \\
& & & 1 & & & & & 1 & 0 \\
& & & & 1 & & & & 1 & 1 \\
& & & & & 1 & & & 1 & 0 \\
& & & & & & 1 & & 1 & 1 \\
& & & & & & & 1 & 1 & 0
\end{pmatrix}
$$

And additionally, we consider the column code with the systematic generator matrix

$$
F = \begin{pmatrix}
1 & & & & & & & & 1 & 0 \\
& 1 & & & & & & & 1 & 1 \\
& & 1 & & & & & & 1 & 0 \\
& & & 1 & & & & & 1 & 1 \\
& & & & 1 & & & & 0 & 0 \\
& & & & & 1 & & & 0 & 1 \\
& & & & & & 1 & & 0 & 1 \\
& & & & & & & 1 & 0 & 1
\end{pmatrix}
$$

Using different row and column codes ensures that we easily find an invertible matrix **A** below necessary for computing the self-protection values.

With this code, we have $r = n - k = 2$ and we have $M = \frac{k-r}{2} = 3$. The rate of the code is

$$R_c = \frac{2k}{n} - 1 = 0.6.$$

We have $G = \begin{bmatrix} I_{k \times k} & \begin{matrix} G_i \\ G_r \end{matrix} \end{bmatrix}$ with

$$G_i = \begin{pmatrix} 1 & 1 \\ 1 & 0 \\ 1 & 1 \\ 1 & 0 \\ 1 & 1 \\ 1 & 0 \end{pmatrix} \text{ and } G_r = \begin{pmatrix} 1 & 1 \\ 1 & 0 \end{pmatrix} \text{ as well as } F_i = \begin{pmatrix} 1 & 0 \\ 1 & 1 \\ 1 & 0 \\ 1 & 1 \\ 0 & 0 \\ 0 & 1 \end{pmatrix} \text{ and } F_r = \begin{pmatrix} 0 & 1 \\ 0 & 1 \end{pmatrix}$$

The blocks $\mathbf{B}_i$ are of size $3 \times 3$ and we start with the following exemplary information blocks:

$$B_0 = \begin{pmatrix} 0 & 0 & 0 \\ 0 & 0 & 0 \\ 0 & 0 & 0 \end{pmatrix} \quad B_1 = \begin{pmatrix} 1 & 0 & 0 \\ 0 & 1 & 1 \\ 0 & 0 & 0 \end{pmatrix} \quad B_2 = \begin{pmatrix} 0 & 1 & 0 \\ 1 & 1 & 1 \\ 1 & 1 & 0 \end{pmatrix}$$

We start with computing the row and column parities

$$P_r = [B_0 \ B_1]G_i = \begin{pmatrix} 0 & 0 & 0 & 1 & 0 & 0 \\ 0 & 0 & 0 & 0 & 1 & 1 \\ 0 & 0 & 0 & 0 & 0 & 0 \end{pmatrix} \begin{pmatrix} 1 & 1 \\ 1 & 0 \\ 1 & 1 \\ 1 & 0 \\ 1 & 1 \\ 1 & 0 \end{pmatrix} = \begin{pmatrix} 1 & 0 \\ 0 & 1 \\ 0 & 0 \end{pmatrix}$$

and

$$P_c = (F_i)^T \begin{bmatrix} B_1 \\ B_2 \end{bmatrix} = \begin{pmatrix} 1 & 1 & 1 & 1 & 0 & 0 \\ 0 & 1 & 0 & 1 & 0 & 1 \end{pmatrix} \begin{pmatrix} 1 & 0 & 0 \\ 0 & 1 & 1 \\ 0 & 0 & 0 \\ 0 & 1 & 0 \\ 1 & 1 & 1 \\ 1 & 1 & 0 \end{pmatrix} = \begin{pmatrix} 1 & 0 & 1 \\ 1 & 1 & 1 \end{pmatrix}$$

The next task is to compute $X, Y, \tilde{P}_r$ and $\tilde{P}_c$. Let

$$X = \begin{pmatrix} x_{1,1} & x_{1,2} \\ x_{2,1} & x_{2,2} \\ x_{3,1} & x_{3,2} \end{pmatrix}$$

and

$$\widetilde{\boldsymbol{P}}_r = \begin{pmatrix} p_{1,1} & p_{1,2} \\ p_{2,1} & p_{2,2} \\ p_{3,1} & p_{3,2} \end{pmatrix}$$

We impose the following permutation:

$$\boldsymbol{Y} = \begin{pmatrix} x_{3,1} & x_{1,1} & x_{2,1} \\ x_{2,2} & x_{3,2} & x_{1,2} \end{pmatrix}, \quad \widetilde{\boldsymbol{P}}_c = \begin{pmatrix} p_{1,1} & p_{2,1} & p_{3,1} \\ p_{3,2} & p_{1,2} & p_{2,2} \end{pmatrix}$$

We can now impose our equality constraints and have

$$\begin{pmatrix} p_{1,1} & p_{1,2} \\ p_{2,1} & p_{2,2} \\ p_{3,1} & p_{3,2} \end{pmatrix} = \widetilde{\boldsymbol{P}}_r = \boldsymbol{P}_r + \boldsymbol{X}\boldsymbol{G}_r = \begin{pmatrix} 1 & 0 \\ 0 & 1 \\ 0 & 0 \end{pmatrix} + \begin{pmatrix} x_{1,1} & x_{1,2} \\ x_{2,1} & x_{2,2} \\ x_{3,1} & x_{3,2} \end{pmatrix} \begin{pmatrix} 1 & 1 \\ 1 & 0 \end{pmatrix}$$

As well as

$$\begin{pmatrix} p_{1,1} & p_{2,1} & p_{3,1} \\ p_{3,2} & p_{1,2} & p_{2,2} \end{pmatrix} = \widetilde{\boldsymbol{P}}_c = \boldsymbol{P}_c + (\boldsymbol{F}_r)^T \boldsymbol{Y} = \begin{pmatrix} 1 & 0 & 1 \\ 1 & 1 & 1 \end{pmatrix} + \begin{pmatrix} 0 & 0 \\ 1 & 1 \end{pmatrix} \begin{pmatrix} x_{3,1} & x_{1,1} & x_{2,1} \\ x_{2,2} & x_{3,2} & x_{1,2} \end{pmatrix}$$

Writing out these equations leads to the following system of equations:

$$\begin{pmatrix} 1 & & & & 1 & & 1 & & \\ & 1 & & & 1 & & & & \\ & & 1 & & & 1 & & 1 & \\ & & & 1 & & 1 & & & \\ & & & & 1 & & & 1 & & 1 \\ & & & & & 1 & & 1 & & \\ 1 & & & & & & & & & \\ & 1 & & & & & & & & \\ & & 1 & & & & & & & \\ & & & 1 & & & 1 & & 1 \\ & & & & 1 & & 1 & & & 1 \\ & & & & & 1 & & 1 & & 1 \end{pmatrix} \begin{pmatrix} p_{1,1} \\ p_{2,1} \\ p_{3,1} \\ p_{1,2} \\ p_{2,2} \\ p_{3,2} \\ x_{1,1} \\ x_{2,1} \\ x_{3,1} \\ x_{1,2} \\ x_{2,2} \\ x_{3,2} \end{pmatrix} = \begin{pmatrix} 1 \\ 0 \\ 0 \\ 1 \\ 0 \\ 0 \\ 1 \\ 0 \\ 1 \\ 1 \\ 1 \\ 1 \end{pmatrix}$$

Which we can rewrite as

$$\begin{pmatrix} p_{1,1} \\ p_{2,1} \\ p_{3,1} \\ p_{1,2} \\ p_{2,2} \\ p_{3,2} \\ x_{1,1} \\ x_{2,1} \\ x_{3,1} \\ x_{1,2} \\ x_{2,2} \\ x_{3,2} \end{pmatrix} = \underbrace{\begin{pmatrix} 1 & & & & & & 1 & & 1 & & & \\ & 1 & & & & & 1 & & & & & \\ & & 1 & & & & & 1 & & 1 & & \\ & & & 1 & & & & 1 & & & & \\ & & & & 1 & & & & 1 & & 1 & \\ & & & & & 1 & & 1 & & & & \\ 1 & & & & & & & & & & & \\ & 1 & & & & & & & & & & \\ & & 1 & & & & & & & & & \\ & & & 1 & & & & 1 & & 1 & & \\ & & & & 1 & & 1 & & & & 1 & \\ & & & & & 1 & & 1 & & 1 & & \end{pmatrix}}_{\tilde{A}}^{-1} \begin{pmatrix} 1 \\ 0 \\ 0 \\ 1 \\ 0 \\ 0 \\ 1 \\ 0 \\ 1 \\ 1 \\ 1 \\ 1 \end{pmatrix} = \begin{pmatrix} 1 \\ 0 \\ 1 \\ 0 \\ 0 \\ 0 \\ 0 \\ 1 \\ 0 \\ 0 \\ 1 \\ 1 \end{pmatrix}$$

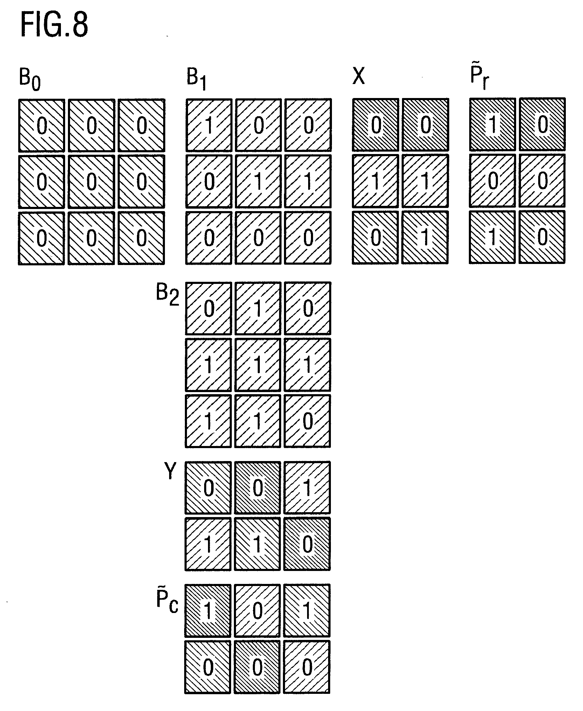

Where the inverse of the 12 × 12 matrix $\tilde{A}$ is uniquely given as this matrix is non-singular. Putting this together in the code notation yields the arrangement shown in Fig. 8, where the different hatching in $X$ and $\tilde{P}_r$ and their respective counterparts indicate the permutation function. Using the generator matrices for row and column codes, we can verify that indeed the rows and columns are code words of the respective row and column codes.

We can also write the above expression in vectorized notation. Let

$$\underline{p}_c = \begin{pmatrix} p_{1,1} & p_{2,1} & p_{3,1} & p_{3,2} & p_{1,2} & p_{2,2} \end{pmatrix}^T$$

and

$$\underline{p}_r = \begin{pmatrix} p_{1,1} & p_{2,1} & p_{3,1} & p_{1,2} & p_{2,2} & p_{3,2} \end{pmatrix}^T$$

be the vectorized versions of the temporary parity bits. We define for an $r \times r$ matrix $Q$, $B(Q)$ to be the block diagonal matrix of size $Mr \times Mr$ where the diagonal entries are copies of $Q$ and zeros elsewhere. We have the permutation matrix $\Pi_2$ that describes the permutation of the parity bits, i.e., $\underline{p}_c = \Pi_2 \underline{p}_r$.

$$\Pi_2 = \begin{pmatrix} 1 & & & & & \\ & 1 & & & & \\ & & 1 & & & \\ & & & & & 1 \\ & & & 1 & & \\ & & & & 1 & \end{pmatrix}$$

Similarly, let $\underline{x} = (x_{1,1}\ x_{2,1}\ x_{3,1}\ x_{1,2}\ x_{2,2}\ x_{3,2})^T$ and its permuted vectorized version $\underline{y} = (x_{3,1}\ x_{1,1}\ x_{2,1}\ x_{2,2}\ x_{3,2}\ x_{1,2})^T = \Pi_1\underline{x}$ with the permutation matrix

$$\Pi_1 = \begin{pmatrix} & & 1 & & & \\ 1 & & & & & \\ & 1 & & & & \\ & & & & 1 & \\ & & & & & 1 \\ & & & 1 & & \end{pmatrix}$$

The inverse of the permutation matrix is given by

$$\mathbf{\Pi}_1^{-1} = \begin{pmatrix} & & 1 & & & \\ 1 & & & & & \\ & 1 & & & & \\ & & & 1 & & \\ & & & & 1 & \\ & & & & & 1 \end{pmatrix}^T = \begin{pmatrix} & 1 & & & & \\ & & 1 & & & \\ 1 & & & & & \\ & & & & & 1 \\ & & & 1 & & \\ & & & & 1 & \end{pmatrix}$$

We first compute the matrix $\tilde{\Pi}_2$ which also takes into account the transposition of the blocks under vectorization and which is given by

$$\tilde{\mathbf{\Pi}}_2 = \begin{pmatrix} 1 & & & & & \\ & & & & 1 & \\ & & 1 & & & \\ & & & 1 & & \\ & & & & & 1 \\ & & & & 1 & \end{pmatrix}$$

Similary, we can compute the matrix $\tilde{\mathbf{\Pi}}_1^{-1}$ which takes into account the transposition under the vectorization and which is given by

$$\tilde{\mathbf{\Pi}}_1^{-1} = \begin{pmatrix} & & 1 & & & \\ 1 & & & & & \\ & 1 & & & & \\ & & & & 1 & \\ & & & & & 1 \\ & & & 1 & & \end{pmatrix}$$

We can now compute the matrix $\boldsymbol{A}$ which is given by ,

$$\boldsymbol{A} = \mathcal{B}((\boldsymbol{F_r})^T) + \tilde{\mathbf{\Pi}}_2 \mathcal{B}\left(\left(\boldsymbol{G_r}\right)^T\right) \tilde{\mathbf{\Pi}}_1^{-1}$$

$$= \begin{pmatrix} 0 & 0 & & & & \\ 1 & 1 & & & & \\ & & 0 & 0 & & \\ & & 1 & 1 & & \\ & & & & 0 & 0 \\ & & & & 1 & 1 \end{pmatrix} + \begin{pmatrix} 1 & & & 1 & & \\ & & & & 1 & & 1 \\ & & & 1 & & & \\ & & 1 & & & 1 & \\ & & & & & & 1 \\ & & 1 & & & & \end{pmatrix}$$

$$= \begin{pmatrix} 1 & & 1 & & & \\ 1 & 1 & & 1 & & 1 \\ & & 1 & & & \\ & 1 & 1 & 1 & 1 & \\ & & & & & 1 \\ & 1 & & & 1 & 1 \end{pmatrix}$$

which leads to the inverse

$$A^{-1} = \begin{pmatrix} 1 & & 1 & & & & \\ 1 & 1 & & & 1 & & & 1 \\ & & & 1 & & & & \\ & & & & 1 & 1 & 1 & 1 \\ 1 & 1 & & & & 1 & 1 & \\ & & & & & & & 1 \end{pmatrix}$$

We can finally use this matrix to compute the vector

$$\underline{y} = A^{-1}\left(\underline{p_c} + \mathbf{\Pi}_2\underline{p_r}\right)$$

and find the values of $\underline{y}$ and consequently $\underline{x}$ and from these the final parity bits.

Decoding of the proposed self-protecting FF-SC is very similar to conventional staircase codes. A sliding window decoder is used starting from block $\mathbf{B}_0$. When corrections are made in a column redundancy block the corresponding row redundancy block is also modified, and vice versa. Additional logic may be required to implement the permutations $\pi_1$, $\pi_2$, and their inverses.

In the following we describe an example choice of permutations $\pi_1$ and $\pi_2$ suitable for applications requiring very low error-floors. The permutations $\pi_1$, $\pi_2$ can be defined by the permutation matrices

$$\mathbf{\Pi}_1 = \mathcal{B}(E_M^{M-1}, E_M^{M-2}, \ldots, E_M^{M-r})$$

$$\mathbf{\Pi}_2 = \mathcal{B}(E_M^{M-r-1}, E_M^{M-r-2}, \ldots, E_M^{M-2r}),$$

together with column-wise vectorization vec($\cdot$) and its inverse vec$^{-1}(\cdot)$ where $E_M$ denotes the $M \times M$ elementary permutation matrix, obtained by cyclically shifting each row of the identity matrix of size $M \times M$ to the right by 1. These permutations cyclically shift each column of $\mathbf{X}$ and $\tilde{P}_r$ by a number of bits related to their column index, an example of which is shown in Fig. 7. Thus, the row redundancy symbols $\mathbf{X}$ and $\tilde{P}_r$ are cyclically shifted versions of the column redundancy symbols $\mathbf{Y}$ and $\tilde{P}_c$. These permutation rules can be implemented efficiently in hardware, for example by using barrel shifters. Discussions of the estimated and simulated error-floor performance under these permutations are given below.

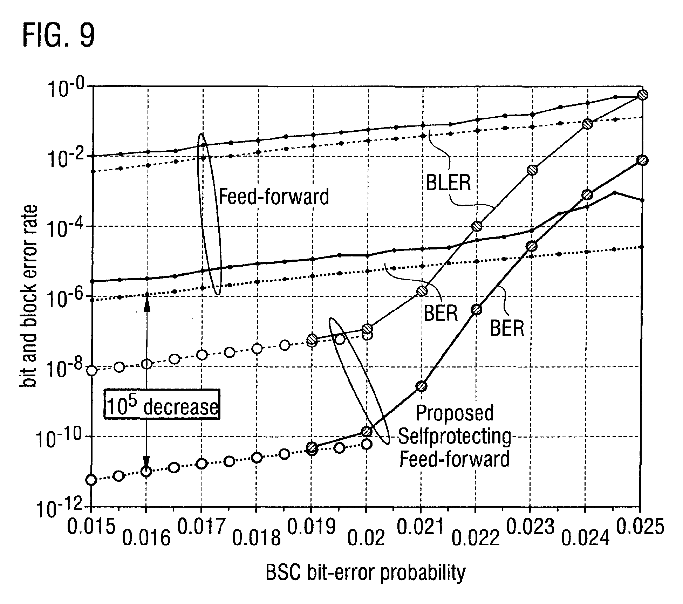

Simulated block (BLER) and bit error (BER) probability curves for both feed-forward (Fig. 6) and self-protecting feed-forward staircase codes (Fig. 7) are shown in **Fig. 9.** The code parameters used in the simulations are $M = 72$, $r = 24$, $n = 192$, $t = 3$, and $R = 3/4$. The solid curves near the top of the figure are from feed-forward staircase codes, along with their error floor estimates. In the case of feed-forward codes, we estimate the bit-error-rate error floor based on minimal stall patterns of weight 7 (1 error in information block, 6 errors in adjoining parity blocks, which will not be resolved as they are not protected) assuming all errors are from the channel

$$BER_{feed-forward} \geq \binom{r}{3}^2 p^7,$$

where $p$ denotes the channel error probability (pre-FEC error rate).

The circle-marked curves correspond to the self-protecting feed-forward staircase codes, along with their error floor estimates. We estimate the bit-error-rate error floor based on minimal stall patterns of weight 8 (4 errors in the information block, 4 errors in parity block) assuming all errors are from the channel

$$BER_{self-protecting} \geq \binom{M}{2}\binom{2r}{2}\frac{2}{M^2}p^8.$$

As shown, the error floors for both block and bit error rates were reduced by 5 orders of magnitude with no performance loss in the waterfall region. Finally note that the codes used in this simulation example are just toy codes with small sizes to demonstrate the performance advantage. Real coding implementations will most likely use codes with larger $n$, e.g., $n = 1020$.

Although self-protection allows to considerably reduce the error floor of feed-forward staircase codes (shown in Fig. 6), the error floor may still be unacceptably high for some applications requiring very low residual BERs, e.g., optical core networks.

Thus, a further idea presented herein is to relax the parity ringing constraint slightly and allow ringing parities for $A$ additional sub-frames of the staircase code. This means that following an information chunk, in the worst case $A$ additional redundancy or parity parts will be non-zero. The following parity-parts will then be non-zero. This relaxed parity ringing constraint leads to the situation that a part of the redundancy or parity symbols are re-encoded while parts of the redundancy or parity symbols are not re-encoded. Said differently, we can slightly relax the parity-propagation constraint by allowing the parity bits to propagate over some blocks and propose so-called Partial Feed-Forward Staircase Codes (PFF-SCs). Let $L \in \{1, 2, ...\}$ be the propagation length of a PFF-SC, defined as the maximum number of consecutive blocks over which parity-propagation can occur. The PFF-SC can then use a hybrid structure, with $L$-1 blocks being standard staircase code blocks followed by one block with parity bits that are not re-encoded but where self-protection can be used to mitigate the detrimental effect of harmful error patterns. Thus, examples of PFF-SCs can be combined with the self-protected FF-SCs of Fig. 7.

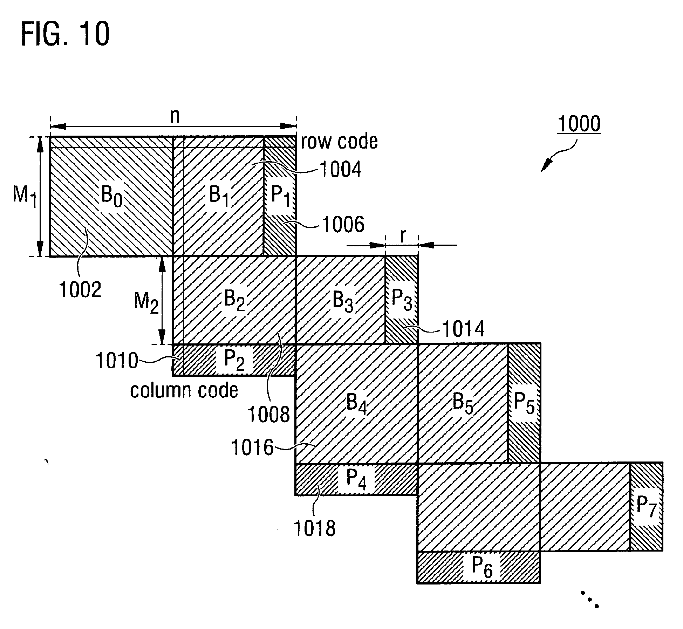

**Fig. 10** shows an example illustrating a basic partial feed-forward staircase code 1000 with propagation length $L$=1. We can see that $r$ horizontal parity symbols 1006, 1014 denoted $\mathbf{P}_i$, with $i$ odd, are re-encoded by the row code $C_r$, whereas $r$ vertical parities 1010, 1018 of the column code $C_c$, denoted $\mathbf{P}_j$, with $j$ even, are not re-encoded by the row code $C_r$. In some examples, we can use the same component codes in the horizontal and vertical directions, i.e., with identical (possibly shortened) length $n$.

Thus, according to further examples of the present disclosure, it is provided a further FEC encoding concept, including respective methods and apparatuses. Again, information symbols are mapped to information symbol positions in a sequence of two-dimensional symbol blocks. A symbol block $\mathbf{B}i$ ($i \geq 1$) has a preceding symbol block $\mathbf{B}_{i-1}$ and a subsequent symbol block $\mathbf{B}i$+1 in the sequence. The symbol block $\mathbf{B}_i$ comprises information symbol positions and has associated redundancy symbol positions for redundancy symbols. According to a column or vertical component code, column redundancy symbols $\mathbf{P}_i$ for the symbol block $\mathbf{B}i$ can be generated based on symbols at symbol positions including redundancy symbol positions along a column of the preceding symbol block $\mathbf{B}_{i-1}$ concatenated with information symbols along a respective column of the symbol block $\mathbf{B}_i$. According to a row or horizontal component code, row redundancy symbols $\mathbf{P}_j$ for the subsequent symbol block $\mathbf{B}i$+1 can be generated only based on symbols at symbol positions excluding redundancy symbol positions along a row of the symbol block $\mathbf{B}_i$ concatenated with information symbols along a respective row of the subsequent symbol block $\mathbf{B}_{i+1}$. Thus, while the column redundancy symbols $\mathbf{P}_i$ for the symbol block $\mathbf{B}_i$ are generated by re-encoding row redundancy symbols of at least one preceding symbol block $\mathbf{B}_{i-1}$, the row redundancy symbols $\mathbf{P}_j$ for the subsequent symbol block $\mathbf{B}i$+1 are generated not taking into account the column redundancy symbols $\mathbf{P}_i$ of symbol block $\mathbf{B}_i$. Note again that the roles of rows and columns can be interchanged. In other words, the $i$-th redundancy symbols $\mathbf{P}_i$ for the symbol block $\mathbf{B}_i$ can be dependent on redundancy symbols of at least one previous symbol block, while the ($i$+1)-th redundancy symbols $\mathbf{P}_j$ for the subsequent symbol block $\mathbf{B}i$+1 are independent of any previous redundancy symbols of symbol blocks prior to $\mathbf{B}_{i+1}$. This situation is e.g. shown for symbol block $\mathbf{B}_3$ having the preceding symbol block $\mathbf{B}_2$ and a subsequent symbol block $\mathbf{B}_4$ in the sequence of Fig. 10. While the redundancy symbols $\mathbf{P}_2$ of symbol block $\mathbf{B}_2$ are not re-encoded to generate redundancy symbols $\mathbf{P}_3$ of symbol block $\mathbf{B}_3$, the redundancy symbols $\mathbf{P}_3$ of symbol block $\mathbf{B}_3$ are re-encoded to generate redundancy symbols $\mathbf{P}_4$ of symbol block $\mathbf{B}_4$.

In some examples, the row and column redundancy symbols $\mathbf{P}_i$, $\mathbf{P}_j$ can consist of parity symbols only, or, in other examples, of adjustable self-protection symbols as well as parity symbols. Thus, the skilled person having benefit from the present disclosure will appreciate that the partial feed-forward concept of Fig. 10 can be combined with the self-protection concept of Fig. 7, as will become apparent further below.

For example, we can set

$$M_1 = \frac{n}{2} \quad \text{and} \quad M_2 = M_1 - r = \frac{n-2r}{2} = \frac{k-r}{2},$$

where $k := n - r$ denotes the number of information symbols or bits per codeword. Note that with this example construction, the sizes of different information symbol sub-blocks are not equal. For example, the size of the all-zero block $\boldsymbol{B}_0$ is $M_1 \times M_1$, while the size of the first data-containing block $\boldsymbol{B}_1$ equals $M_1 \times M_2$. The size of the second data-containing block $\boldsymbol{B}_2$ equals $M_2 \times M_1$ and the size of the third data containing block $\boldsymbol{B}_3$ equals $M_2 \times M_2$. The fourth data containing block $\boldsymbol{B}_4$ can have the same size as $\boldsymbol{B}_0$, i.e., $M_1 \times M_1$ and the sequence of sizes repeats thereon, i.e., dim $\boldsymbol{B}_i$ = dim $\boldsymbol{B}_{i-4}$ as we can see from the example of Fig. 10.

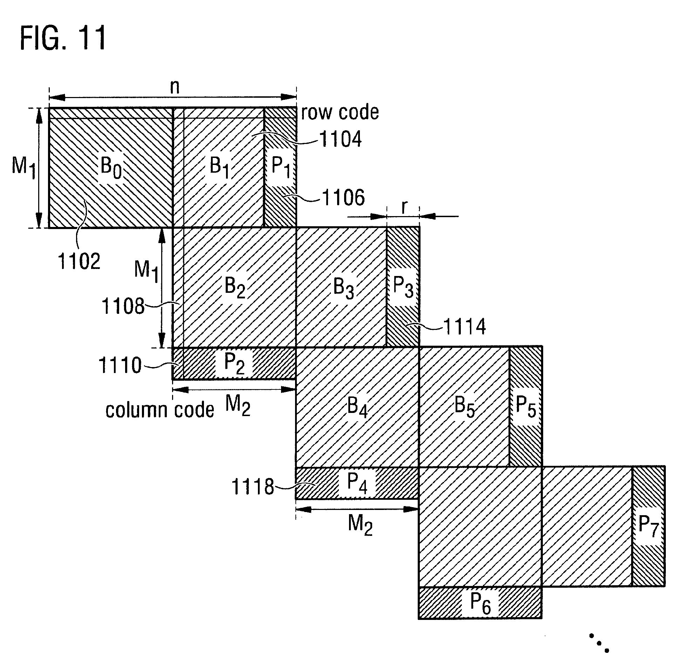

According to another example, we can slightly modify the example code of Fig. 10 to yield a more uniform sequence of block sizes. This is shown in **Fig. 11,** where we can use the same code for row and column coding and where we define $M_1 := \frac{n-r}{2} = \frac{k}{2}$ and similarly $M_2 := \frac{n}{2}.$ Then, the size of the blocks equals

$$\dim B_i = \begin{cases} M_1 \times \frac{k-r}{2} & \text{if } i \text{ odd} \\ M_1 \times M_2 & \text{if } i \text{ even} \end{cases}.$$

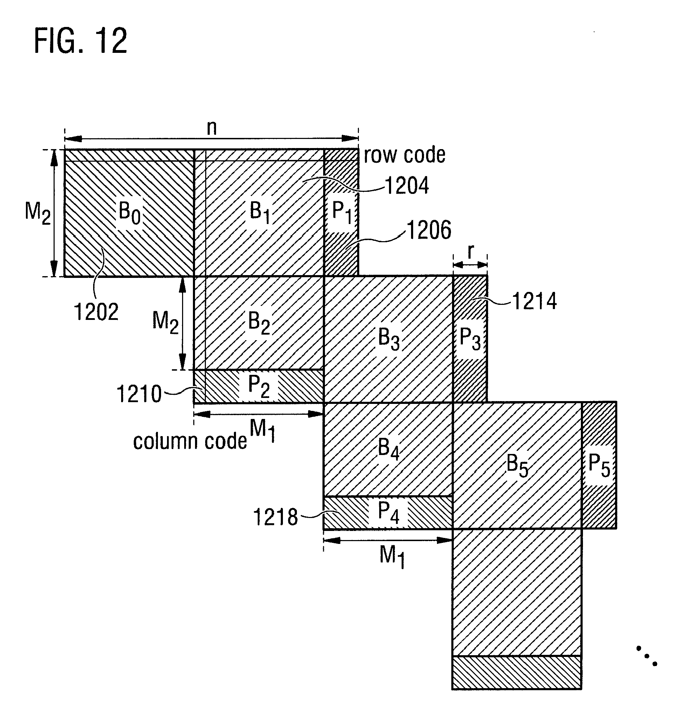

The rate of this example code will be $R := R_c^2 = \left(\frac{k}{n}\right)^2$ (as in a conventional, uncoupled product code). Note that the rate of the above presented self-protection code was given by $\tilde{R} := 2R_c$ - 1. We can immediately see that the rate of the scheme proposed in Figs. 11 or 12 is larger than that, as

$$(R_c - 1)^2 = R_c^2 - 2R_c + 1 \geq 0 \quad \Leftrightarrow \quad R_c^2 \geq 2R_c - 1 =: \tilde{R}$$

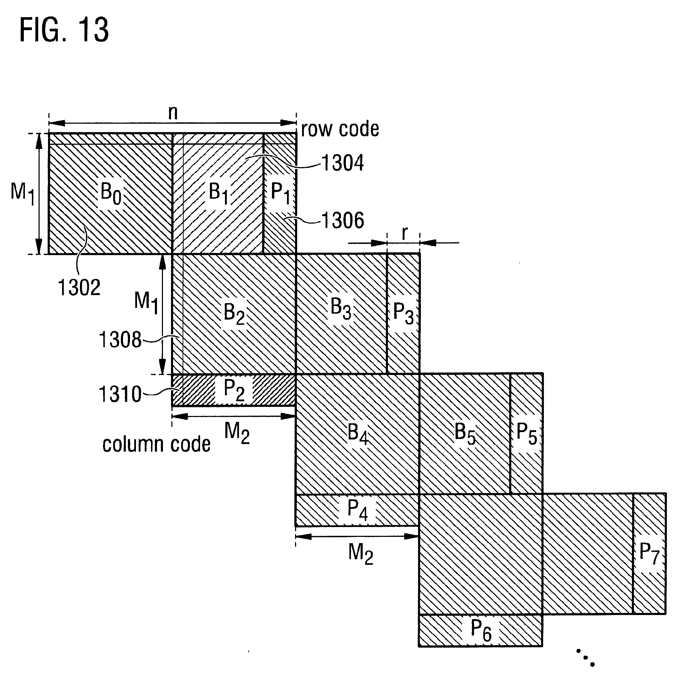

The effect of the suppressed parity ringing is shown in **Fig. 13,** where we assume that only the block $B_1$ 1304 contains useful data. We can see that besides the directly associated parities $P_1$ 1306, also the parities $P_2$ 1310 are non-zero. Of course, the roles of horizontal and vertical codes may be exchanged, i.e., the horizontal parities are not re-encoded while the vertical parities are re-encoded. Such an example is shown in **Fig. 12.**

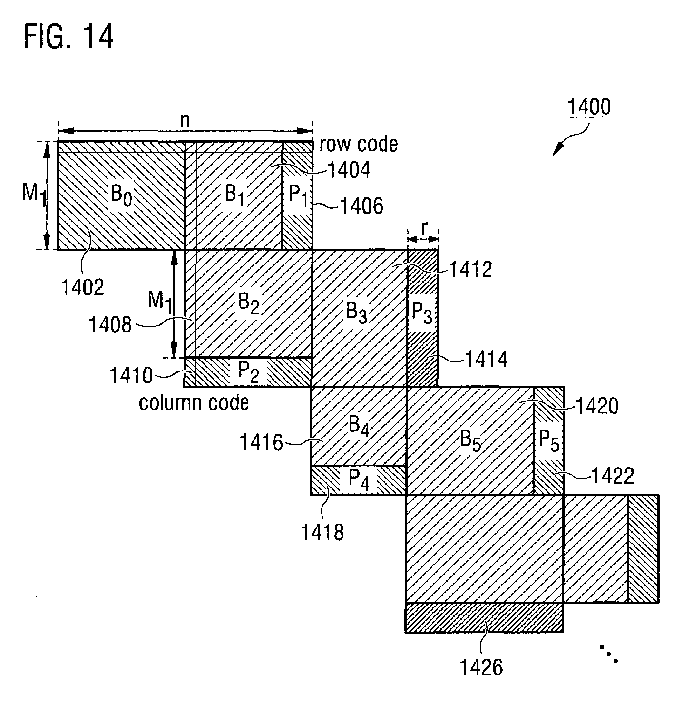

Example implementations are not restricted to codes with propagation length $L$ = 1. We may also set $L$ = 2 and design a code 1400 as shown in **Fig. 14.** Here, always two consecutive parity blocks 1406, 1410 are re-encoded followed by a single parity-block 1414 which is not re-encoded. Likewise two consecutive parity blocks 1418, 1422 are re-encoded followed by a single parity-block 1426 which is not re-encoded. In this case, whenever the last non-zero information bit is contained in block $B_i$, the last non-zero parity will be at most in block $P_{i+2}$. In general for any $L$, whenever the last non-zero information bit is contained in block $B_i$, the last non-zero parity will be at most in block $P_{i+A}$.

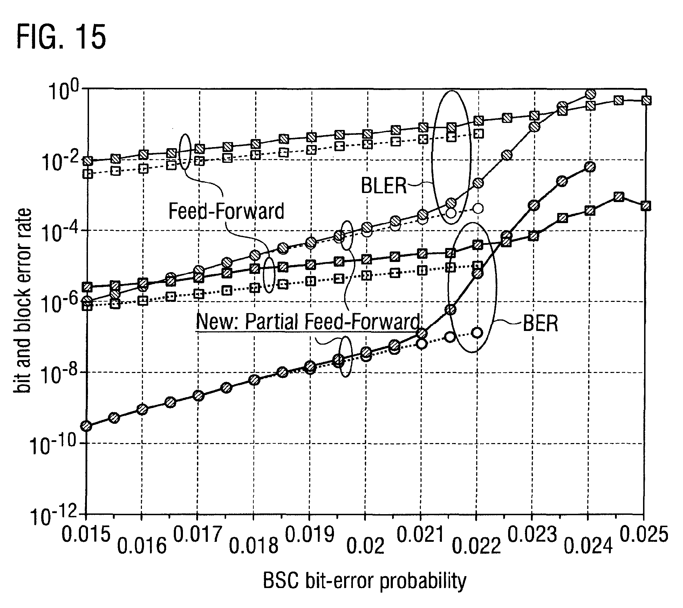

We illustrate the performance of the partial feed-forward code using an example with the same code as above: We select codes with $r$ = 24, $n$ = 192, $k$ = 168, $t$ = 3. The self-protection code construction from above leads to a code of rate $\tilde{R}$ = 3/4 . If we select $M_1 := 84$ and $M_2 := 96$, we get a code of slightly higher rate $R$ = 0.76563. We show the simulation results in **Fig. 15.** The upper lines are block error rates (BLER) and the lower lines are bit error rates (BER). The lines marked by squares correspond to the feed-forward code as shown in Fig. 6. The lines marked by circles correspond to the proposed partial feed-forward code.

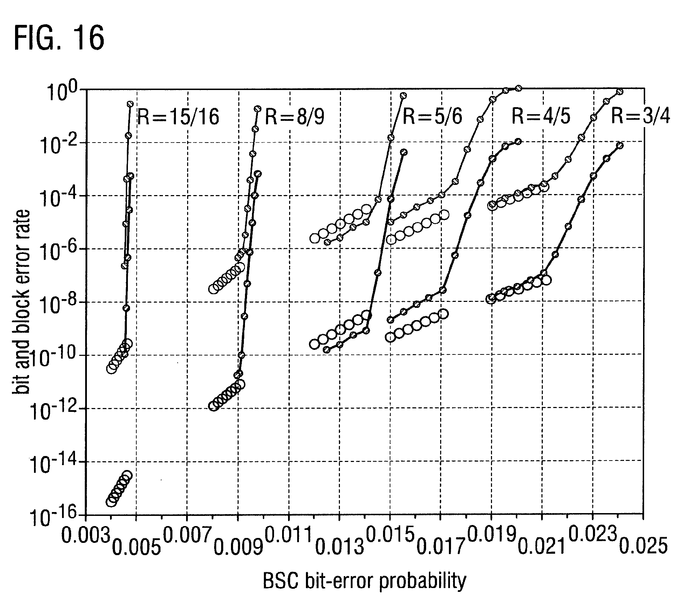

We can see that the error floor is mainly dominated by error patterns of weight 16. The error-floor estimates shown in Fig. 16 are given by

$$BER_{feed-forward} \cong \binom{r}{3}^2 p^7.$$

$$BER_{partial\ feed-forward} \cong \binom{2M_2}{4}\left(\frac{2}{M_1 M_2} + \frac{2}{M_1(2M_2-r)}\right)\binom{M_1}{1}\binom{r}{3}^4 p^{16}..$$

These expressions do not take into account the possibility of stall patterns being created due to mis-corrections during decoding, hence may be inaccurate when mis-corrections (or the lack of mis-corrections) become significant in comparison to errors from the channel.

The slope of the partial feed-forward error-floor is steeper than the feed-forward code due to the increase of the minimum stall-pattern weight from 7 to 16. The multiplicity (i.e. the total possible number) of error patterns of weight 16 is higher for the partial feed-forward code than the example self-protection code, resulting in a smaller error-floor reduction. However, the partial feed-forward code does not require complex calculations of extra bit-values and uses a very simple product interleaver. It provides a useful trade-off between error-floor and implementation complexity.

Using **Fig. 15** as an example, we observe that the column component codes are more susceptible to mis-corrections caused by errors in the parity bits as the parity bits are not corrected by a second component code. At the decoder, we therefore always terminate iterative decoding after the decoding of the more reliable row component codes.

Depending on the dimensions of the left-most block in the decoding window, the order of row/column decoding must be swapped at each iteration in order to satisfy this condition.

We show the simulated error rates of partial feed-forward staircase codes based on $t = 3$ BCH component codes with rates R in the set {3/4,4/5,5/6,8/9,15/16} in Fig. 16. Estimated error floors are also shown. For code rates 5/6 and 8/9, the number of parity bits in the component code is odd (the required BCH component code has field extension-degree $m = 9$). Since we need both $n$ and $k$ to be even to have integer-valued $M_1$ and $M_2$, we extend the code by multiplying the generator polynomial $G(z)$ by $1 + z$ (which ensures an even parity of the codewords) and then shorten the component code by 1 bit to obtain the even-weight subcode of length $n$. This modification has the added benefit of allowing us to better detect mis-corrections during decoding by checking that the decoded word is of even weight. The resulting reduction in mis-correction probability is likely the reason for the discrepancy between the estimated and simulated error floors for R=5/6 in Fig. 16.

The self-protecting code concept of Fig. 7 works by using some part of the data positions of the code to generate parity bits of the horizontal code that are identical to those of the vertical code. Therefore, we can puncture one of the parity positions and not transmit them. This is shown in Fig. 7, where the punctured (i.e., not transmitted) parity positions are shown with dashed lines. We have shown that we can reduce the error floor with this code construction by 5 orders of magnitude with this construction compared with the feed-forward approach from Fig. 6. The approach itself needs to realize an interleaving scheme for the parities, which increases the complexity of the encoder. Furthermore, the generators of the horizontal and vertical codes can be different.

The partial feed-forward concept of Figs. 10-14 is alternative solution to the parity-ringing problem which only re-encodes half of the parity blocks. Since only component code encodings are required to encode these codes (same as for the original staircase codes), they can have lower implementation complexity as compared to self-protecting staircase codes. However, the error-floor of partial feed-forward staircase codes is 2-3 orders of magnitude higher than the error-floor of self-protecting staircase codes. We therefore seek a solution which can provide a trade-off between implementation complexity and error-floor. A good solution should have no parity-ringing, a very low error-floor, and a slight increase in encoding and decoding complexity as compared to the original staircase codes.

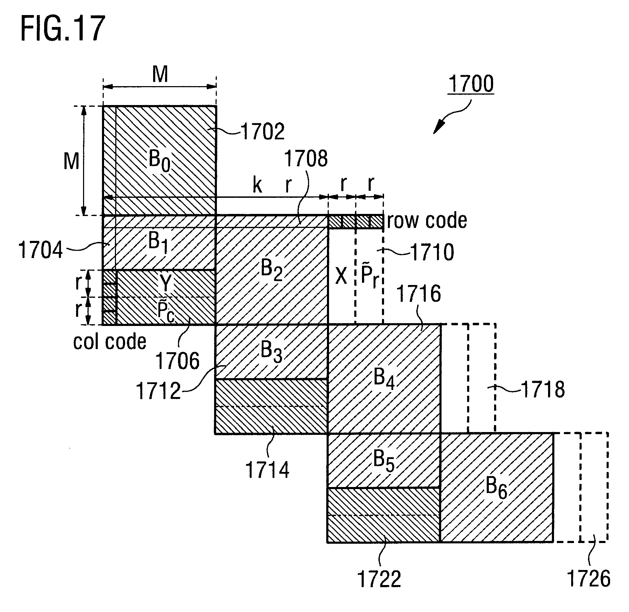

**Fig. 17** illustrates an example code 1700 combining the partial feed-forward concept of Fig. 10 with the self-protection concept of Fig. 7.

In this combined partial feed-forward self-protection code example, row or horizontal self-protected redundancy symbols $[X \, \tilde{P}_r]$ 1710 for the symbol block $B_2$ 1708 can be generated such that symbols at symbol positions (including preceding information symbol positions 1704 and redundancy symbol positions $[Y \, \tilde{P}_r]$ 1706) along a row of the preceding symbol block $B_1$ 1704 concatenated with the information symbols 1708 and the row self-protected redundancy symbols $[X \, \tilde{P}r]$ 1710 along the respective row of the symbol block $B_2$ form a codeword of a row or horizontal component code. Column or vertical self-protected redundancy symbols $[Y \, \tilde{P}_c]$ 1714 for the subsequent symbol block $B_3$ can be generated such that only information symbols at information symbol positions 1708 (excluding redundancy symbol positions 1710) along a column of the symbol block $B_2$ concatenated with information symbols 1712 and the column self-protected redundancy symbols $[Y \, \tilde{P}_c]$ 1714 along the respective column of the subsequent symbol block $B_3$ form a codeword of a column or vertical component code.

In this example, each of the row and column self-protected redundancy symbols $[X \, \tilde{P}_r]$, $[Y \, \tilde{P}_r]$ comprise respective adjustable self-protection symbols $X$, $Y$ and respective parity symbols $\tilde{P}_r$, $\tilde{P}_c$. Similar to what has been described above with respect to the self-protection FF-SC, the row parity symbols $\tilde{P}_r$ can be determined such that the symbols at the symbol positions along the row of the preceding symbol block $B_1$ concatenated with the information symbols, the adjustable row self-protection symbols $X$, and the row parity symbols $\tilde{P}_r$ along the respective row of the symbol block $B_2$ form a valid codeword of the row component code. The column parity symbols $\tilde{P}_c$ can be determined such that the information symbols at the information symbol positions along the column(s) of the symbol block $B_2$ concatenated with the information symbols, the adjustable column self-protection symbols $Y$, and the column parity symbols $\tilde{P}_c$ along the respective column(s) of the subsequent symbol block $B_3$ form a codeword of the column component code. Again, the row self-protected redundancy symbols $[X \, \tilde{P}_r]$ carry the same redundancy information as the column self-protected redundancy symbols $[Y \, \tilde{P}_r]$. In some examples, the column self-protection symbols $Y$ can be a transposed version of the row self-protection symbols $X$. Similarly, the column parity symbols $\tilde{P}_c$ can be a transposed version of the row parity symbols $\tilde{P}_r$. Thus, the self-protection scheme with a simple transpose interleaver can be applied to the re-encoded parity-bits of partial feed-forward staircase codes. As already mentioned above, the roles of rows and columns are interchangeable. Note that other permutations can be applicable as well.

During the encoding process, the initial gray block $B_0$ can be filled with all-zeros. In subsequent blocks, the sub-blocks 1804, 1808, 1812, 1816 correspond to information symbols. The sub-blocks 1806, 1814, 1822 correspond to parity or extra redundancy bits, added for self-protection. Bits in both the information sub-blocks 1804, 1808, 1812, 1816 and redundancy sub-blocks 1806, 1814, 1822 can be transmitted. The sub-blocks 1810, 1818 can be punctured parity and redundancy bits, which are not transmitted. The small squares 1807, 1811 illustrate the transpose interleaving between the horizontal parity and redundancy blocks ($Y, \tilde{P}_c$) and vertical parity and redundancy blocks ($X, \tilde{P}_r$). Note that

this interleaver is simpler than the cyclic shift interleaver used in the self-protection scheme described above.

Let $L \in \{1, 2, 3, ...\}$ be the propagation length parameter of a partial feed-forward self-protecting staircase code, defined as the maximum number of consecutive blocks for which parity-ringing can occur. In the example shown in Fig. 17, the propagation length is 1. Each time blocks **Y** and $\tilde{\boldsymbol{P}}_c$ are calculated, the input to the next encoding consist entirely of information symbols, which terminates parity-ringing.

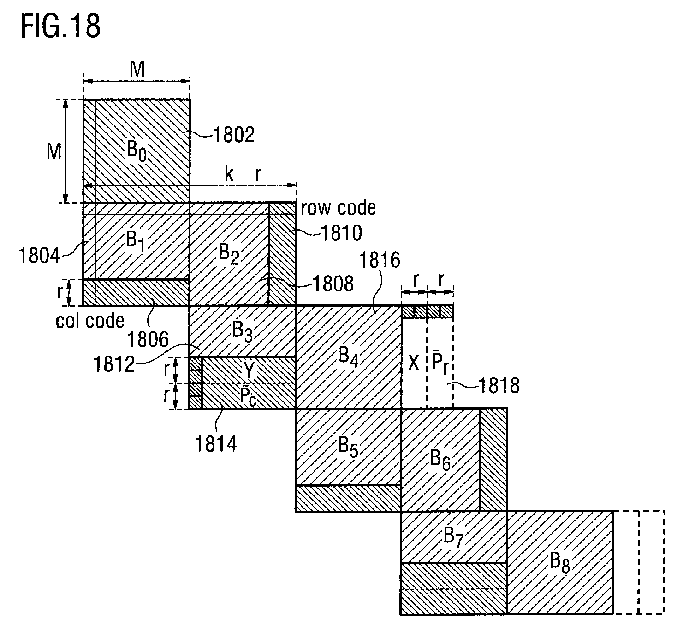

**Fig. 18** shows another example of a partial feed-forward self-protecting staircase code with propagation length $L = 3$. In a sequence of four blocks: $\boldsymbol{B}_i \, \boldsymbol{B}_{i+1} \, \boldsymbol{B}_{i+2} \, \boldsymbol{B}_{i+3}$ where $i$ is a multiple of four, block $\boldsymbol{B}_i$ contains only information bits; blocks $\boldsymbol{B}_{i+1}$, $\boldsymbol{B}_{i+2}$ contain parity-bits without the extra redundancy for self-protection; and block $\boldsymbol{B}_{i+3}$ contains parity-bits and extra redundancy for self-protection. Parity-ringing ends after three blocks, since $\boldsymbol{B}_{i+4}$ only contains information bits. The blocks $\boldsymbol{B}_{i+1}$, $\boldsymbol{B}_{i+2}$ are encoded in the same way as the original staircase code.

In particular, row self-protected redundancy symbols [**X** $\tilde{\boldsymbol{P}}_r$] for the symbol block $\mathbf{B}_4$ of Fig. 18 can be generated such that symbols at symbol positions (including preceding column self-protected redundancy symbol positions [**Y** $\tilde{\boldsymbol{P}}_r$]) along rows of the preceding symbol block $\mathbf{B}_3$ concatenated with the information symbols and the row self-protected redundancy symbols [**X** $\tilde{\boldsymbol{P}}_r$] along respective rows of the symbol block $\mathbf{B}_4$ form a codeword of a row component code. Note that the row self-protected redundancy symbols [**X** $\tilde{\boldsymbol{P}}_r$] and the preceding column self-protected redundancy symbols [**Y** $\tilde{\boldsymbol{P}}_r$] include adjustable self-protection symbols **X, Y** and respective parity symbols $\tilde{\boldsymbol{P}}_r$, $\tilde{\boldsymbol{P}}_c$. Column parity symbols $\mathbf{P}_5$ for the subsequent symbol block $\mathbf{B}_5$ can be generated such that only information symbols at information symbol positions (excluding self-protected redundancy symbol positions) along columns of the symbol block $\mathbf{B}_4$ concatenated with information symbols and the column parity symbols $\mathbf{P}_5$ along respective columns of the subsequent symbol block $\mathbf{B}_5$ form a codeword of a column component code. Parity symbols $\mathbf{P}_6$ of the next symbol block $\mathbf{B}_5$ can be based on conventionally re-encoding the redundancy symbols $\mathbf{P}_5$.

Fig. 18 illustrates the structure of a PFF-SC with $L = 3$. In this example, two out of every four blocks are standard staircase code blocks. Self-protection can be used to stop parity-propagation after $L = 3$ blocks. Another difference in PFF-SCs is the position of the self-protection redundancy blocks, which are part of the conventional staircase structure. This modification allows the permutations $\pi_1$, $\pi_2$ to be more trivial and drastically reduces the error-floor as compared to FF-SC. Another difference is that the number of information bits per block $\mathbf{B}_i$ is not constant. As in FF-SC, we set $M = (k - r)/2$ to account for the self-protection and all blocks contain $M^2$ code bits. The component codes are shortened respectively. In order to accommodate the position of self-protection redundancy blocks **Y,** the component codes involved in self-protection (e.g., codes over blocks $\mathbf{B}_2$ and $\mathbf{B}_3$ as well as $\mathbf{B}_6$ and $\mathbf{B}_7$ in Fig. 18) are shortened by an extra $2r$ bits relative to the other component codes.

In order to compute the rate of the example PFF-SC of Fig. 18, we count the number of information bits per block. The first $L - 1$ blocks $\mathbf{B}_{1+(L+1)i}, ... \mathbf{B}_{L-1+(L+1)i}, i \in \{0, 1, ...\}$ out of $L + 1$ blocks (e.g, $\mathbf{B}_1$ and $\mathbf{B}_2$ in Fig. 18) are standard staircase code blocks of size $M \times M$ with $M(M - r) = \frac{1}{4}(k^2 + 3r^2 - 4kr)$ information bits. The block $\mathbf{B}_{L+(L+1)i}, i \in \{0, 1, ...\}$ contains exactly $M(M - 2r) = \frac{1}{4}(k^2 + 5r^2 - 6kr)$ information bits and finally, the block $\mathbf{B}_{(L+1)(i+1)}, i \in \{0, 1, ...\}$ contains exactly $M^2 = 1/4(k - r)^2$ information bits. For computing the rate, we fix again the granularity of transmission. If we assume that always $L + 1$ blocks $\mathbf{B}_1, \ldots, \mathbf{B}_{(L+1)i}, i \in \mathbb{N}$ are transmitted, then the rate can be computed as

$$R_{\mathrm{PFF}} = \frac{(L - 1)M(M - r) + M(M - 2r) + M^2}{(L + 1)M^2}$$
$$= 1 - \frac{r}{M} = 1 + \frac{2R_c - 2}{2R_c - 1},$$

which is independent *of L.* As $R_{\mathrm{PFF}} - R = \frac{(2R_c - 2)^2}{1 - 2R_c}$, we can conclude that $R_{\mathrm{PFF}} < R$ if $R_c > 1/2$, which we assumed as prerequisite. This implies a rate loss with these codes. However, at high rates the differences are small. For example, $R_{\mathrm{PFF}}$ is within 5% of $R$ for $R_c \geq 10/11$ and within 25% for $R_c \geq 5/6$. Note that a PFF-SC of non-trivial rate requires $R_c > 3/4$.

This result may seem counter-intuitive at first glance, since it appears that we should recover the original staircase code rate $R$ for $L \rightarrow \infty$. However, note that a key difference in the proposed construction is that the component codes of the staircase-like blocks are shortened by $2r$, which leads to the observed rate difference. We could relax the granularity constraint of $L + 1$ blocks and find an expression $R'_{\mathrm{PFF}}(\Lambda, L)$. As this expression is cumbersome and does not lead to any new insights, we omit it here. For practical purposes, it is customary to restrict ourselves to the granularity of $L + 1$ blocks, allowing easy termination and possibly higher error rates at the code boundaries.

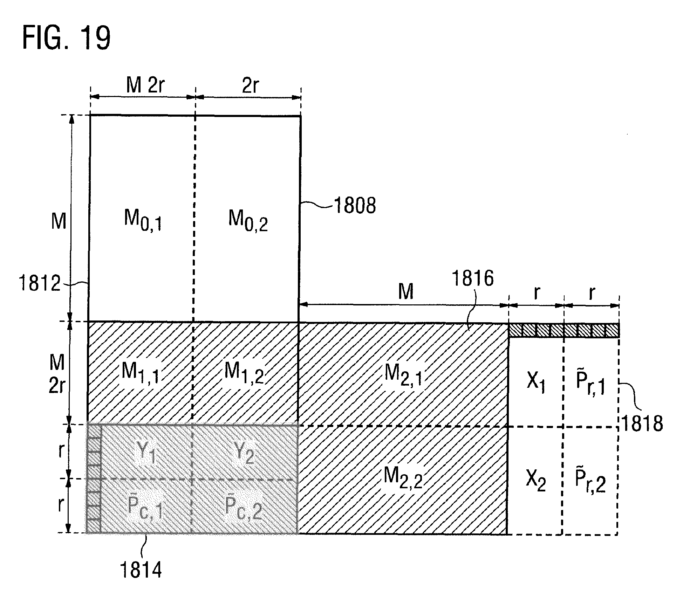

In the following, we describe an example encoder of PFF-SC. We focus only on the self-protection blocks, since *L*-1 out of *L*+1 consecutive blocks are encoded in the same way as the original staircase code. Our explanations will focus on **Fig. 19,** which highlights blocks $\mathbf{B}_2$, $\mathbf{B}_3$, $\mathbf{B}_4$, $\mathbf{Y}$, $\tilde{\boldsymbol{P}}_c$, $\mathbf{X}$, and $\tilde{\boldsymbol{P}}_r$ of Fig. 18 for *L* = 3. Fig. 19 further sub-divides each block into sub-blocks. The encoding process comprises two stages. Stage 1 calculates $\mathbf{Y}_1$. Stage 2 calculates $\mathbf{Y}_2$ based on $\mathbf{Y}_1$. In terms of implementation complexity, stage 1 is equivalent to component code encoding, while stage 2 is a general matrix multiplication. Fortunately, for high code rates where *M* >> *r*, the encoding complexity is dominated by stage 1.

1) Calculating $\mathbf{Y}_1$:

We inherit the definitions of matrices $\mathbf{G}_p$, $\mathbf{F}_p$, $\mathbf{G}_i$, $\mathbf{F}_i$, and $\mathbf{G}_r$, $\mathbf{F}_r$ from above. By horizontally concatenating $\mathbf{M}_{1,1}$, $\mathbf{M}_{1,2}$, and $\mathbf{M}_{2,1}$, we obtain

$$P_{r,1} = \begin{bmatrix} M_{1,1} & M_{1,2} & M_{2,1} \end{bmatrix} G_i$$

By vertically concatenating blocks $\mathbf{0}_{2r \times M\text{-}2r}$, $\mathbf{M}_{0,1}$ and $\mathbf{M}_{1,1}$, where $\mathbf{0}_{2r \times M\text{-}2r}$ accounts for the extra shortening of the column component codes, we obtain

$$P_{c,1} = F_i^T \begin{bmatrix} \mathbf{0}_{2r \times M-2r} \\ M_{0,1} \\ M_{1,1} \end{bmatrix}$$

Thus, determining the column parity symbols $\tilde{\boldsymbol{P}}_c$ of symbol block $\mathbf{B}_i$ comprises determining intermediate column parity symbols $\mathbf{P}_{c,1}$ based on combining a concatenation of the information symbols $\mathbf{M}_{0,1}$ at the information symbol positions along columns of the previous symbol block $\mathbf{B}_{i-1}$ and the information symbols $M_{1,1}$ at the information symbol positions along columns of the symbol block $\mathbf{B}_i$ according to a first portion $\mathbf{F}_i$ of the column component code. Determining the row parity symbols $\tilde{P}r$ of subsequent symbol block $\mathbf{B}_{i+1}$ comprises determining intermediate row parity symbols $\mathbf{P}_{r,1}$ based on combining a concatenation of the information symbols $\mathbf{M}_{1,1}$, $\mathbf{M}_{1,2}$ at the information symbol positions along rows of the preceding symbol block $\mathbf{B}_i$ and the information symbols $\mathbf{M}_{2,1}$ at the information symbol positions along respective rows of the subsequent symbol block $\mathbf{B}_{i+1}$ according to a first portion $\mathbf{G}_i$ of the row component code.
We write $\tilde{\boldsymbol{P}}_{c,1}$ and $\tilde{\boldsymbol{P}}_{r,1}$ as

$$\tilde{P}_{c,1} = P_{c,1} + F_r^T Y_1, \qquad \tilde{P}_{r,1} = P_{r,1} + X_1 G_r$$

Imposing self-protection constraints

$$Y_1 = X_1^T, \qquad \tilde{P}_{c,1} = \tilde{P}_{r,1}^T$$

under trivial permutations and solving for $\mathbf{Y}_1$ gives

$$Y_1 = \left( G_r^T + F_r^T \right)^{-1} \left( P_{c,1} + P_{r,1}^T \right)$$
$$\triangleq A^{-1} C.$$

$$(4)$$

Thus, determining the row parity symbols $\tilde{\boldsymbol{P}}_{r,1}$ can further comprise determining one of the adjustable row or column self-protection symbols $\mathbf{X}_1$, $\mathbf{Y}_1$ based on a combination of first and second generator matrices $\mathbf{G}_r$, $\mathbf{F}_r$ corresponding to a respective second portion of the row and column component code, based on the permutation rule (e.g., matrix transpose), and based on the intermediate row and column parity symbols $\mathbf{P}_{r,1}$, $\mathbf{P}_{c,1}$. The respective other adjustable self-protection symbols $\mathbf{Y}_1$, $\mathbf{X}_1$ can be computed based on the determined first or the second adjustable symbols $\mathbf{X}_1$, $\mathbf{Y}_1$ and the permutation rule (e.g. matrix transpose).
Since, $\mathbf{A} = \mathbf{0}_{r \times r}$ if $\mathbf{G}_r = \mathbf{F}_r$, a necessary condition for $\mathbf{A}$ to be invertible is $G_r \neq \mathbf{F}_r$. Here we satisfy this condition by using different binary cyclic codes as row and column component codes. Let *g(x)* and *f(x)* be generator polynomials

for $C_r(n, k)$ and $C_c(n, k)$. We require $g(x)$ and $f(x)$ to satisfy the condition

$$f(x) = x^{\deg(g(x))} g(x^{-1})$$

where $\deg(p(x))$ is the degree of polynomial $p(x)$. The component codes then have the property that the "mirror-image" of a codeword $(c_0, c_1, \dots, c_{n-1}) \in C_r(n, k)$, i.e. $(c_{n-1}, c_{n-2}, \dots, c_0)$, is a codeword of $C_c(n, k)$, and vice versa. Hence, the same decoder can be used to decode both component codes, with some simple bit-reversal logic. Using different binary cyclic component codes with generator polynomials satisfying (10) gives an invertible **A**. By calculating $\mathbf{A}^{-1}$ offline at design time, the complexity of finding $\mathbf{Y}_1$ and $\tilde{\boldsymbol{P}}_{c,1}$ is equivalent to a multiplication between an $r \times r$ matrix and an $in \times M - 2r$ matrix.

If $g(x)$ and $f(x)$ do not share any common factors then **A** is invertible. One way of satisfying this condition is to use reciprocal polynomials. For example, if $g(x)$ has roots at $\{\alpha, \dots, \alpha^{2t}\}$ then $f(x)$ is selected to have roots at $\{\alpha^{-1}, \dots, \alpha^{-2t}\}$. A property of the codewords generated by reciprocal polynomials is that the "mirror image", i.e. reflection about the center, of a codeword for the row code is a codeword for the column code. Hence, the same decoder can be used to decode both row and column component codes, with some additional logic to reverse the bit indexing.. This additional operation is especially fast in the high-rate regime. Hence, a large portion of the parity and redundancy bits can be calculated with complexity similar to staircase code encoding.

2) Calculating $\mathbf{Y}_2$:

In stage 2, the blocks $\mathbf{Y}_1$ and $\tilde{\boldsymbol{P}}_{c,1}$ are considered known. By vertically concatenating blocks $\mathbf{0}_{2r \times 2r}$, $\mathbf{M}_{0,2}$ and $\mathbf{M}_{1,2}$ we obtain

$$\boldsymbol{P}_{c,2} = (\boldsymbol{F}_i)^T \begin{bmatrix} \mathbf{0}_{2r \times 2r} \\ \boldsymbol{M}_{0,2} \\ \boldsymbol{M}_{1,2} \end{bmatrix}$$

hence

$$\tilde{\boldsymbol{P}}_{c,2} = \boldsymbol{P}_{c,2} + \boldsymbol{F}_r^T \boldsymbol{Y}_2. \tag{5}$$

We partition the matrix $\mathbf{G}_i$ into three sub-matrices with

$$\boldsymbol{G}_i = \begin{bmatrix} \boldsymbol{G}_A \\ \boldsymbol{G}_B \\ \boldsymbol{G}_C \end{bmatrix}$$

where dim $\boldsymbol{G}_A = (M - 2r) \times r$, dim $\boldsymbol{G}_B = 2r \times r$, and dim $\boldsymbol{G}_c = M \times r$. We can now write

$$\tilde{\boldsymbol{P}}_{r,2} = \begin{bmatrix} \boldsymbol{Y}_1 \\ \tilde{\boldsymbol{P}}_{c,1} \end{bmatrix} \boldsymbol{G}_A + \begin{bmatrix} \boldsymbol{Y}_2 \\ \tilde{\boldsymbol{P}}_{c,2} \end{bmatrix} \boldsymbol{G}_B + \boldsymbol{M}_{2,2} \boldsymbol{G}_C + \boldsymbol{X}_2 \boldsymbol{G}_r$$

Using (5) and the self-protection constraint $\mathbf{Y}_2^T = \mathbf{X}_2$, we have

$$\tilde{\boldsymbol{P}}_{r,2} = \begin{bmatrix} \boldsymbol{Y}_1 & \mathbf{0}_{r \times 2r} & \boldsymbol{M}_{2,2} \\ \tilde{\boldsymbol{P}}_{c,1} & \boldsymbol{P}_{c,2} & \end{bmatrix} \boldsymbol{G}_i + \begin{bmatrix} \boldsymbol{I}_r \\ \boldsymbol{F}_r^T \end{bmatrix} \boldsymbol{Y}_2 \boldsymbol{G}_B + \boldsymbol{Y}_2^T \boldsymbol{G}_r$$

Imposing the self-protection constraint $\tilde{\boldsymbol{P}}_{r,2} = (\tilde{\boldsymbol{P}}_{c,2})^T$ and simplification yields

$$Y_2^T A^T + \begin{bmatrix} I_r \\ F_r^T \end{bmatrix} Y_2 G_B = C \tag{6}$$

where **A** was defined in Eq. (4) and

$$C \triangleq \begin{bmatrix} Y_1 & 0_{r\times 2r} & M_{2,2} \\ \tilde{P}_{c,1} & P_{c,2} \end{bmatrix} G_i + \begin{bmatrix} 0_{2r\times 2r} & M_{0,2}^T & M_{1,2}^T \end{bmatrix} F_i$$

Note that all terms in Eq. (6) are $2r \times r$ matrices. Let vec($\cdot$) now denote the row-wise vectorization given by the mapping $v(i,j) = in + j$. Let y = vec($Y_2$) and c = vec($C$). Let $S(A)$ be the $r \times 2r^2$ matrix where for $i \in [0, r - 1]$ and $j = 2ri$, thejth column of $S(A)$ is the $i$th column of **A**, with zeros elsewhere. We can write Eq. (6) as

$$By = c$$

where B is a $2r^2 \times 2r^2$ matrix given by

$$B \triangleq \begin{bmatrix} S(A) \\ S(A)E_{2r^2} \\ \vdots \\ S(A)E_{2r^2}^{2r-1} \end{bmatrix} + \begin{bmatrix} I_r \otimes G_B^T \\ F_r^T \otimes G_B^T \end{bmatrix}$$

, e.g.,

$$B = \begin{bmatrix} [A^T]_{1,1} & [A^T]_{1,2} & \cdots & [A^T]_{1,r} \\ [A^T]_{2,1} & [A^T]_{2,2} & \cdots & [A^T]_{2,r} \\ \vdots \\ [A^T]_{r,1} & [A^T]_{r,2} & \cdots & [A^T]_{r,r} \\ [A^T]_{r+1,1} & [A^T]_{r+1,2} & \cdots & [A^T]_{r+1,r} \\ \vdots \\ [A^T]_{2r,1} & [A^T]_{2r,2} & \cdots & [A^T]_{2r,r} \end{bmatrix} + \begin{bmatrix} (G_B)^T & 0_{r\times r} & \cdots & 0_{r\times r} \\ 0_{r\times r} & (G_B)^T & 0_{r\times r} & \cdots \\ \vdots \\ 0_{r\times r} & \cdots & 0_{r\times r} & (G_B)^T \\ f_{1,1}(G_B)^T & f_{1,2}(G_B)^T & \cdots & f_{1,r}(G_B)^T \\ f_{2,1}(G_B)^T & f_{2,2}(G_B)^T & \cdots & f_{2,r}(G_B)^T \\ \vdots \\ f_{r,1}(G_B)^T & f_{r,2}(G_B)^T & \cdots & f_{r,r}(G_B)^T \end{bmatrix}$$

3) Finding an invertible B:

Since $G_r$ and $F_r$ were fixed in stage 1 in order to obtain an invertible **A**, *if B is singular, a way to obtain an invertible B is to manipulate $G_B$* using elementary row operations. Here we focus on row permutations of $G_B$ only, since they do not affect the error floor.

Let $\Pi$ be a $2r \times 2r$ permutation matrix. Denote the permuted $G_B$ by $\tilde{G}_B = \Pi G_B$, . A computer search can be used to find an appropriate $\Pi$ that results in an invertible **B**. Given $\Pi$, the expressions for $\tilde{P}_{r,2}$ *and B* are modified by replacing $G_B$ with $\tilde{G}_B$. Note that $\Pi$ also affects stage 1 calculations, where (8) has to be modified to

$$P_{r,1} = \begin{bmatrix} M_{1,1} & M_{1,2}\Pi & M_{2,1} \end{bmatrix} G_i$$

For an invertible **B**, the matrix $Y_2$ is given by

$$y = B^{-1}c.$$

where *y* denotes the vectorization of $\mathbf{Y}_2$ under row-wise vectorization. The complexity of calculating $\mathbf{Y}_2$ is dominated by the multiplication with a $2r^2 \times 2r^2$ matrix. Since only 1 out of every $L + 1$ blocks requires self-protection calculations, the average complexity of PFF-SC approaches conventional staircase codes with increasing $L$.

We illustrate the self-protection feed-forward staircase codes using an example with the following row code with $n = 14$ and $k = 12$ that generates $r = 2$ additional parity bits and has the following generator matrix

$$
G \;=\;
\begin{pmatrix}
1 & & & & & & & & & & & 1 & 1\\
& 1 & & & & & & & & & & 0 & 0\\
& & 1 & & & & & & & & & 1 & 1\\
& & & 1 & & & & & & & & 1 & 0\\
& & & & 1 & & & & & & & 1 & 1\\
& & & & & 1 & & & & & & 1 & 0\\
& & & & & & 1 & & & & & 1 & 1\\
& & & & & & & 1 & & & & 1 & 0\\
& & & & & & & & 1 & & & 1 & 1\\
& & & & & & & & & 1 & & 1 & 0\\
& & & & & & & & & & 1 & 1 & 1\\
& & & & & & & & & & 1 & 1 & 0
\end{pmatrix}
$$

And additionally, we consider the column code with the systematic generator matrix

$$
F \;=\;=\;
\begin{pmatrix}
1 & & & & & & & & & & & 1 & 0\\
& 1 & & & & & & & & & & 1 & 1\\
& & 1 & & & & & & & & & 1 & 0\\
& & & 1 & & & & & & & & 1 & 1\\
& & & & 1 & & & & & & & 1 & 0\\
& & & & & 1 & & & & & & 0 & 1\\
& & & & & & 1 & & & & & 0 & 0\\
& & & & & & & 1 & & & & 0 & 1\\
& & & & & & & & 1 & & & 0 & 0\\
& & & & & & & & & 1 & & 0 & 1\\
& & & & & & & & & & 1 & 0 & 1\\
& & & & & & & & & & 1 & 0 & 1
\end{pmatrix}
$$

Using different row and column codes ensures that we easily find an invertible matrix $\mathbf{A}$ below necessary for computing the self-protection values.

With this code, we have r = $n$ - $k$ = 1 and we have $M = \dfrac{k-r}{2} = 5.$ The rate of the code is

$$
R_{PFF} = 1 + \frac{\frac{2k}{n}-2}{\frac{2k}{n}-1} = 0.6.
$$

We have $G \;=\; \begin{bmatrix} I_{k\times k} & \begin{matrix} G_i \\ G_r \end{matrix} \end{bmatrix}$ with

$$\boldsymbol{G}_i = \begin{pmatrix} 1 & 1 \\ 0 & 0 \\ 1 & 1 \\ 1 & 0 \\ 1 & 1 \\ 1 & 0 \\ 1 & 1 \\ 1 & 0 \\ 1 & 1 \\ 1 & 0 \end{pmatrix} \text{ and } \boldsymbol{G}_r = \begin{pmatrix} 1 & 1 \\ 1 & 0 \end{pmatrix} \text{ as well as } \boldsymbol{F}_i = \begin{pmatrix} 1 & 0 \\ 1 & 1 \\ 1 & 0 \\ 1 & 1 \\ 1 & 0 \\ 0 & 1 \\ 0 & 0 \\ 0 & 1 \\ 0 & 0 \\ 0 & 1 \end{pmatrix} \text{ and } \boldsymbol{F}_r = \begin{pmatrix} 0 & 1 \\ 0 & 1 \end{pmatrix}$$

For illustrating the example, we refer to Fig. 18 and use blocks $\boldsymbol{B}_2$, $\boldsymbol{B}_3$ and $\boldsymbol{B}_4$. The blocks in the example are of different sizes and are given by:

$$\boldsymbol{B}_2 = \begin{pmatrix} 1 & 0 & 0 & 0 & 0 \\ 0 & 0 & 0 & 1 & 0 \\ 0 & 1 & 1 & 0 & 0 \\ 0 & 1 & 0 & 1 & 1 \\ 0 & 0 & 0 & 0 & 0 \end{pmatrix} \quad \boldsymbol{B}_3 = \begin{pmatrix} 1 & 1 & 0 & 0 & 1 \end{pmatrix} \quad \boldsymbol{B}_4 = \begin{pmatrix} 0 & 0 & 1 & 0 & 0 \\ 1 & 1 & 0 & 1 & 1 \\ 1 & 0 & 0 & 0 & 1 \\ 1 & 1 & 1 & 1 & 1 \\ 0 & 0 & 1 & 1 & 0 \end{pmatrix}$$

Step 1) Computing $\boldsymbol{Y}_1$

From the matrices above, we extract $\boldsymbol{M}_{1,1} = (1)$ $\boldsymbol{M}_{1,2} = (1\ 0\ 0\ 1)$ $\boldsymbol{M}_{2,1} = (0\ 0\ 1\ 0\ 0)$ We then first compute $\boldsymbol{P}_{r,1} = (\boldsymbol{M}_{1,1}\ \boldsymbol{M}_{1,2}\ \boldsymbol{M}_{2,1})\boldsymbol{G}_i = (1\ 0)$.

By vertically concatenating blocks $\boldsymbol{0}_{2r \times M\text{-}2r}$, $\boldsymbol{M}_{0,1}$ and $\boldsymbol{M}_{1,1}$, where $\boldsymbol{0}_{2r \times M\text{-}2r}$, accounts for the extra shortening of the column component codes, and with

$$\boldsymbol{M}_{0,1} = \begin{pmatrix} 1 \\ 0 \\ 0 \\ 0 \\ 0 \end{pmatrix}, \quad \boldsymbol{M}_{1,1} = (1)$$

we have

$$\boldsymbol{P}_{c,1} = \left(\boldsymbol{F}_i\right)^T \begin{pmatrix} \boldsymbol{0}_{2r \times M - 2r} \\ \boldsymbol{M}_{0,1} \\ \boldsymbol{M}_{1,1} \end{pmatrix} = \begin{pmatrix} 1 & 1 & 1 & 1 & 1 & 0 & 0 & 0 & 0 & 0 \\ 0 & 1 & 0 & 1 & 0 & 1 & 0 & 1 & 0 & 1 \end{pmatrix} \begin{pmatrix} 0 \\ 0 \\ 0 \\ 0 \\ 1 \\ 0 \\ 0 \\ 0 \\ 0 \\ 1 \end{pmatrix} = \begin{pmatrix} 1 \\ 1 \end{pmatrix}$$

We can write

$$\widetilde{\boldsymbol{P}}_{c,1} = \boldsymbol{P}_{c,1} + (\boldsymbol{G}_c^x)^T \boldsymbol{Y}_1 \quad and \quad \widetilde{\boldsymbol{P}}_{r,1} = \boldsymbol{P}_{r,1} + \boldsymbol{X}_1 \boldsymbol{G}_r^x$$

And imposing self-protection constraints $Y_1 = X_1^T$ and $\widetilde{P}_{c,1} = \widetilde{P}_{r,1}^T$ leads to

$$Y_1 = \left( (G_r)^T + (F_r)^T \right)^{-1} (P_{c,1} + P_{r,1}^T) = \left( \begin{pmatrix} 1 & 1 \\ 1 & 0 \end{pmatrix} + \begin{pmatrix} 0 & 0 \\ 1 & 1 \end{pmatrix} \right)^{-1} \left( \begin{pmatrix} 1 \\ 1 \end{pmatrix} + \right.$$

$$\left. (1 \quad 0)^T \right) = \begin{pmatrix} 1 \\ 1 \end{pmatrix}$$

and hence

$$\widetilde{P}_{c,1} = P_{c,1} + \left( F_r \right)^T Y_1 = \begin{pmatrix} 1 \\ 1 \end{pmatrix} + \begin{pmatrix} 0 & 0 \\ 1 & 1 \end{pmatrix} \begin{pmatrix} 1 \\ 1 \end{pmatrix} = \begin{pmatrix} 1 \\ 1 \end{pmatrix},$$

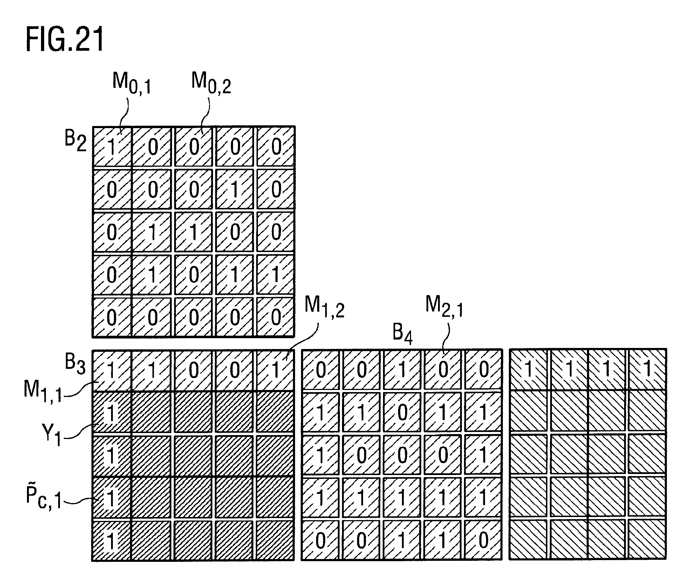

which leads to the situation shown in **Fig. 21.**

Step 2) Computing $Y_2$

We first calculate

$$P_{c,2} = \left( F_i \right)^T \begin{pmatrix} \mathbf{0}_{2r \times 2r} \\ M_{0,2} \\ M_{1,2} \end{pmatrix} = \begin{pmatrix} 1 & 1 & 1 & 1 & 1 & 0 & 0 & 0 & 0 & 0 \\ 0 & 1 & 0 & 1 & 0 & 1 & 0 & 1 & 0 & 1 \end{pmatrix} \begin{pmatrix} 0 & 0 & 0 & 0 \\ 0 & 0 & 0 & 0 \\ 0 & 0 & 0 & 0 \\ 0 & 0 & 0 & 0 \\ 0 & 0 & 0 & 0 \\ 0 & 0 & 1 & 0 \\ 1 & 1 & 0 & 0 \\ 1 & 0 & 1 & 1 \\ 0 & 0 & 0 & 0 \\ 1 & 0 & 0 & 1 \end{pmatrix} =$$

$$\begin{pmatrix} 0 & 0 & 0 & 0 \\ 0 & 0 & 0 & 0 \end{pmatrix}$$

We then compute the matrix **C** with

$$C = \begin{pmatrix} Y_1 & 0_{r \times 2r} \\ \widetilde{P}_{c,1} & P_{c,2} \end{pmatrix} M_{2,2} \Big) G_i + \underbrace{\left(0_{2r \times 2r} \quad M_{0,2}^T \quad M_{1,2}^T\right) F_i}_{P_{c,2}^T}$$

$$= \begin{pmatrix} 1 & 0 & 0 & 0 & 0 & 1 & 1 & 0 & 1 & 1 \\ 1 & 0 & 0 & 0 & 0 & 1 & 0 & 0 & 0 & 1 \\ 1 & 0 & 0 & 0 & 0 & 1 & 1 & 1 & 1 & 1 \\ 1 & 0 & 0 & 0 & 0 & 0 & 0 & 1 & 1 & 0 \end{pmatrix} \begin{pmatrix} 1 & 1 \\ 0 & 0 \\ 1 & 1 \\ 1 & 0 \\ 1 & 1 \\ 1 & 0 \\ 1 & 1 \\ 1 & 0 \\ 1 & 1 \\ 1 & 0 \end{pmatrix}$$

$$+ \begin{pmatrix} 0 & 0 & 0 & 0 & 0 & 0 & 1 & 1 & 0 & 1 \\ 0 & 0 & 0 & 0 & 0 & 0 & 1 & 0 & 0 & 0 \\ 0 & 0 & 0 & 0 & 0 & 1 & 0 & 1 & 0 & 0 \\ 0 & 0 & 0 & 0 & 0 & 0 & 0 & 1 & 0 & 1 \end{pmatrix} \begin{pmatrix} 1 & 0 \\ 1 & 1 \\ 1 & 0 \\ 1 & 1 \\ 1 & 0 \\ 0 & 1 \\ 0 & 0 \\ 0 & 1 \\ 0 & 0 \\ 0 & 1 \end{pmatrix}$$

$$= \begin{pmatrix} 1 & 1 \\ 1 & 1 \\ 0 & 1 \\ 1 & 0 \end{pmatrix} + \begin{pmatrix} 0 & 0 \\ 0 & 0 \\ 0 & 0 \\ 0 & 0 \end{pmatrix} = \begin{pmatrix} 1 & 1 \\ 1 & 1 \\ 0 & 1 \\ 1 & 0 \end{pmatrix}$$

With the *row-wise* vectorization $c = (1\ 1\ 1\ 1\ 0\ 1\ 1\ 0)^T$.

We next compute the matrix **B** *which* makes use of $A = \left((G_r)^T + (F_r)^T\right) = \begin{pmatrix} 1 & 1 \\ 0 & 1 \end{pmatrix}.$

Then the $r \times 2r^2$ matrix $S(A)$ is obtained as where for $i \in \{0, ..., r - 1\}$, the $j = 2ri$th column of $S(A)$ is the ith column of **A**.

$$S(A) = \begin{pmatrix} 1 & 0 & 0 & 0 & 1 & 0 & 0 & 0 \\ 0 & 0 & 0 & 0 & 1 & 0 & 0 & 0 \end{pmatrix}$$

Then,

$$B = \begin{pmatrix} S(A) \\ S(A)E_{2r^2} \\ \vdots \\ S(A)E_{2r^2}^{2r-1} \end{pmatrix} + \begin{pmatrix} I_r \otimes G_B^T \\ (F_r)^T \otimes G_B^T \end{pmatrix}$$

Where $G_B$ is obtained by partitioning $G_i$ as

$$G_i = \begin{pmatrix} G_A \\ G_B \\ G_C \end{pmatrix}$$

With dim $G_A = (M - 2r) \times r$, dim $G_B = 2r \times r$, and dim $G_c = M \times r$. And hence

$$G_B = \begin{pmatrix} 0 & 0 \\ 1 & 1 \\ 1 & 0 \\ 1 & 1 \end{pmatrix}$$

We can hence write B as

$$B = \begin{pmatrix} 1 & & & 1 & & & \\ 0 & & & 1 & & & \\ & 1 & & & 1 & & \\ & 0 & & & 1 & & \\ & & 1 & & & 1 & \\ & & 0 & & & 1 & \\ & & & 1 & & & 1 \\ & & & 0 & & & 1 \end{pmatrix} + \begin{pmatrix} 0 & 1 & 1 & 1 & & & & \\ 0 & 1 & 0 & 1 & & & & \\ & & & & 0 & 1 & 1 & 1 \\ & & & & 0 & 1 & 0 & 1 \\ & & & & & & & \\ & & & & & & & \\ 0 & 1 & 1 & 1 & 0 & 1 & 1 & 1 \\ 0 & 1 & 0 & 1 & 0 & 1 & 0 & 1 \end{pmatrix}$$

which is of full rank and can hence be inverted giving

$$y = B^{-1}c = \begin{pmatrix} 1 & 1 & 0 & 0 & 1 & 1 & 0 & 0 \\ 0 & 0 & 1 & 1 & 0 & 1 & 0 & 0 \\ 0 & 0 & 0 & 0 & 1 & 1 & 0 & 0 \\ 0 & 0 & 0 & 0 & 1 & 0 & 1 & 1 \\ 0 & 1 & 1 & 1 & 1 & 1 & 1 & 1 \\ 0 & 0 & 1 & 1 & 1 & 1 & 1 & 0 \\ 0 & 0 & 0 & 0 & 0 & 1 & 0 & 0 \\ 0 & 0 & 0 & 1 & 0 & 0 & 0 & 0 \end{pmatrix} \begin{pmatrix} 1 \\ 1 \\ 1 \\ 1 \\ 0 \\ 1 \\ 1 \\ 0 \end{pmatrix} = \begin{pmatrix} 1 \\ 1 \\ 1 \\ 1 \\ 1 \\ 0 \\ 1 \\ 1 \end{pmatrix}$$

Which is the vectorization of $Y_2$ and hence

$$Y_2 = \begin{pmatrix} 1 & 1 & 1 & 1 \\ 1 & 0 & 1 & 1 \end{pmatrix}$$

leading further to

$$\widetilde{P}_{c,2} = P_{c,2} + \left(F_r\right)^T Y_2 = \begin{pmatrix} 0 & 0 & 0 & 0 \\ 0 & 0 & 0 & 0 \end{pmatrix} + \begin{pmatrix} 0 & 0 \\ 1 & 1 \end{pmatrix}\begin{pmatrix} 1 & 1 & 1 & 1 \\ 1 & 0 & 1 & 1 \end{pmatrix} =$$

$$\begin{pmatrix} 0 & 0 & 0 & 0 \\ 0 & 1 & 0 & 0 \end{pmatrix}$$

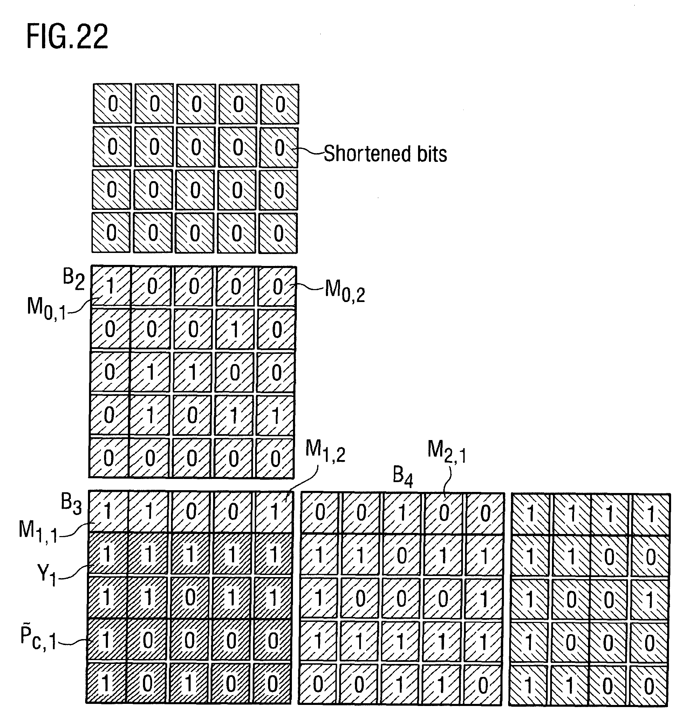

Finally, we get the situation shown in **Fig. 22.**

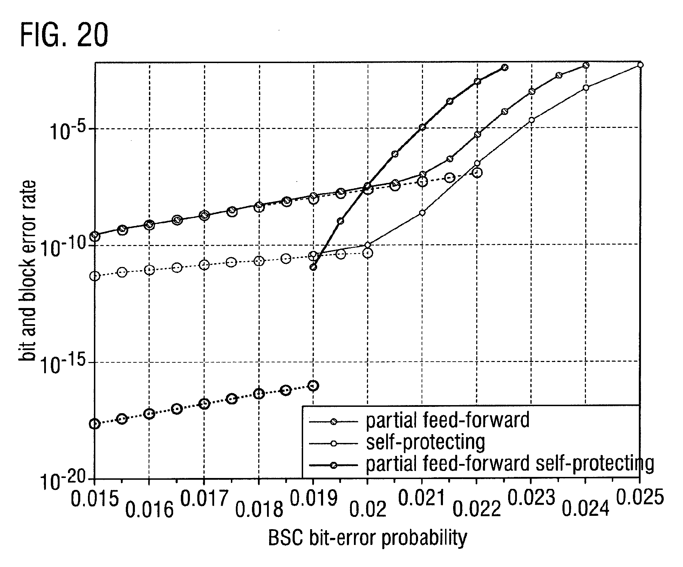

We illustrate the performance of the partial feed-forward self-protecting code using an example code very similar to those presented above. We designed a code with r = 24, $n$ = 240, $k$ = 192, $t$ = 3. The above example code had a rate of $\tilde{R}$ = 3/4. Using propagation length $L$=1, our construction has $M$ = 96 and the same rate. We show the simulated bit-error-rates in **Fig. 20.** As the reference numerals indicate, the bit-error-rates of self-protecting (reference numeral 2102) and partial feed-forward staircase codes (reference numeral 2104) are also shown in Fig. 20. Error floor estimates are shown with respective open circles.

Observe that the error floor of partial feed-forward self-protecting staircase code is below both of the other codes. In fact, the error floor of partial feed-forward self-protecting staircase codes is expected to be very close to the error floor of the original staircase code. An estimate of the error floor based on stall patterns of weight 16 is given by

$$BER_{partial\ feed-forward\ self-protecting} \cong \binom{M}{4} \sum_{m=1}^{4} \binom{M}{m} \binom{M}{4-m} p^{16} \frac{16}{M^2}$$

This estimate is shown by the open circles in Fig. 20. It is much lower than the estimated error floors of the other codes and is already below $10^{-15}$ in the waterfall region of the BER curve.

According to another aspect of the present disclosure, the encoding of self-protecting, partial feed-forward, or partial feed-forward self-protecting staircase codes can be modified to allow on-the-fly adjustments of the redundancy added to each block in the staircase code chain as they are encoded, for example, by intermediate network nodes prior to arriving at a destination node of a communications network. Doing so can provide near-optimal redundancy for successful decoding of every block in the staircase chain, even though different blocks may experience different channel noise conditions. An advantage of this solution is that the amount of net data rate wasted is very little and close to the optimum.

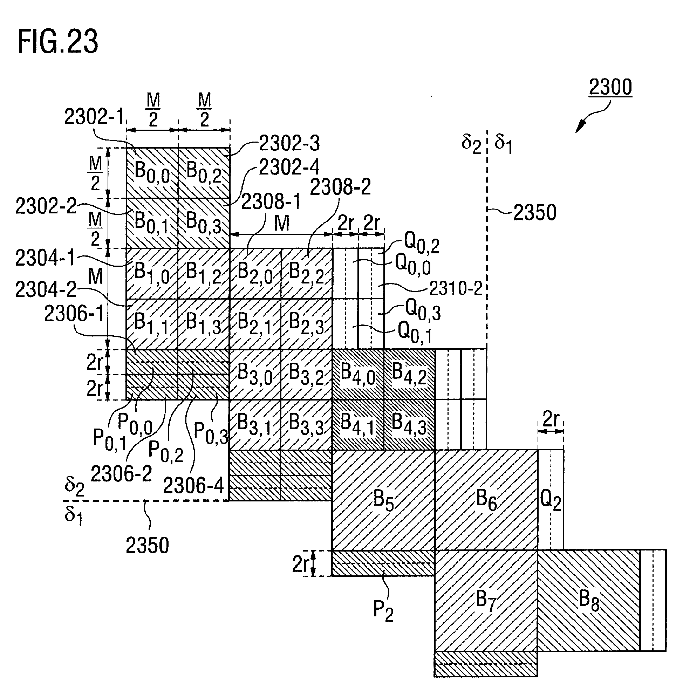

**Fig. 23** shows an example of a rate-compatible staircase code based on self-protecting staircase codes. The skilled person having benefit from the present disclosure will appreciate that the modified rate-compatible encoding can also be combined with any of the schemes presented above, in particular it can be implemented using partial feed-forward or partial feed-forward self-protecting staircase codes. The choice of which parity-ringing-free staircase code to use depends on the rate, implementation complexity, and error-floor requirements of a particular application.

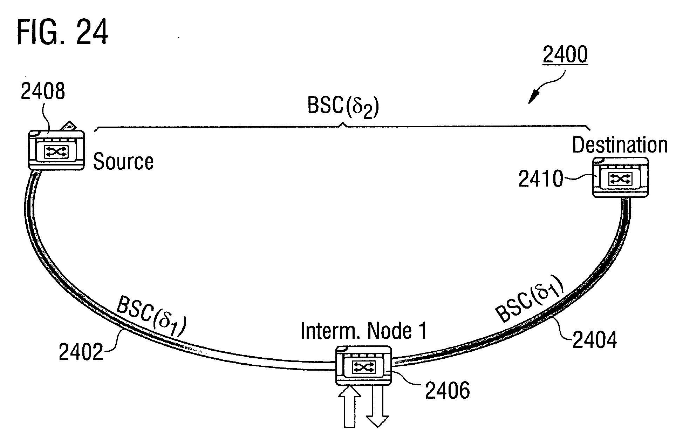

Fig. 23 shows an example of a rate-compatible staircase code 2300 for an example 2-hop system 2400 illustrated in **Fig. 24.** We assume that channels 2402, 2404 between the intermediate nodes 2406 (and source 2408 and destination 2410) are Binary Symmetric Channels (BSCs) with error probability $\delta_1$ The data that is transmitted from the source 2408 to the destination 2410 undergoes both channels 2402, 2404, hence two hops, and has a combined error probability of

$$\delta_2 = \frac{1}{2}(1 - (1 - 2\delta_1)^2) > \delta_1.$$

In the example code of Fig. 23 there are L = 7 blocks $\mathbf{B}_i$ to $\mathbf{B}_7$ containing information symbols and two blocks $\mathbf{B}_0$ and $\mathbf{B}_8$ fixed to zeros which need not be transmitted. Block $\mathbf{B}_4$ is a transition block which can be encoded slightly differently from the other surrounding blocks. The first five blocks $\mathbf{B}_0$ to $\mathbf{B}_4$ from the left are sub-divided into respective four small sub-blocks, labeled $\boldsymbol{B}_{i,j}$. The corresponding redundancy blocks, which can include parity-check and extra redundant bits for self-protection, are also sub-divided into respective four sub-blocks labeled $\boldsymbol{P}_{i,j}$ (e.g., transmitted) and $\boldsymbol{Q}_{i,j}$ (e.g., not transmitted).

The dimension of each block $\mathbf{B}_i$ can be $M \times M$, and thus quadratic. For a component code with block-length $n$, $k$ information bits, and $r = n - k$ parity-check bits, $M$ is given by $M = \frac{k-r}{2}.$ The dimension of each normal redundancy block (such as $\boldsymbol{P}_2$) can be $2r \times M$. The dimension of each sub-block can be $M/2 \times M/2$. The dimension of each sub-divided redundancy block (such as $\boldsymbol{P}_{0,0}$) can be $2r \times M/2$. The way we obtain the sub-divided parity blocks can be described as follows: we only use two sub-blocks to generate a parity block, i.e., instead of using $2M = k - r$ information bits to generate the parities, we now use $\frac{2M}{2} = \frac{k-r}{2}$ data bits to generate a block of parities. The remaining $\frac{k-r}{2}$ data bits can be shortened in the encoder (i.e., assumed to be zero and thus not transmitted).

From the furthest to the nearest intermediate node 2406 (relative to the destination node 2410), channel bit-error probabilities decrease with each hop. In Fig. 24, since there is only one intermediate node, we refer to the destination node 2410 as "node 2" and the intermediate node 2406 as "node 1". As shown, node 2 encodes $4M^2$ information bits in four blocks $\mathbf{B}_1$ to $\mathbf{B}_4$ and node 1 encodes $3M^2$ information bits in three blocks $\mathbf{B}_5$ to $\mathbf{B}_7$. The skilled person having benefit from the present disclosure will appreciate that this ratio is just given exemplarily here and depends on the amount of data that either the source or intermediate node wants to transmit.

The channels experienced by each block are delineated by the thick, dashed lines 2350. All bits to the left or above the line (except those not transmitted) 2350 are received with bit-error probability $\delta_2$. All bits to the right or below the line are received with bit-error probability $\delta_1 < \delta_2$. In our system model, given per-hop bit-error probability $\delta_1$, the bit-error probability for bits transmitted by an intermediate node $h$ hops from the destination 2410 is given by

$$\delta_h = \frac{1}{2}\left[1 - (1 - 2\delta_1)^h\right].$$

Redundancy can be adjusted in relation to the channel bit-error probability experienced by each block. In other words, redundancy can be adjusted in relation to a number of hops from source to the destination of the respective symbol blocks. For the bits transmitted over the channel with bit-error probability $\delta_2$, we can assign $2r/M$ redundant bits per information bit, for example. For the bits transmitted over the channel with error-probability $\delta_1$, we can assign $r/M$ redundant bits per information bit, for example.

In general, we can use $hr/M$ redundant bits per information bit encoded by an intermediate node $h$ hops away from the destination node, for example. This linear redundancy adjustment scheme is best suited to cases where $\delta_1$ is small (e.g., $10^{-3}$). The first order Taylor expansion of $\delta_h$ around 0 is $\delta_h = h\delta_1 + O(\delta_1^2)$, thus for small $\delta_1$ the bit-error probability grows approximately linearly with $h$.

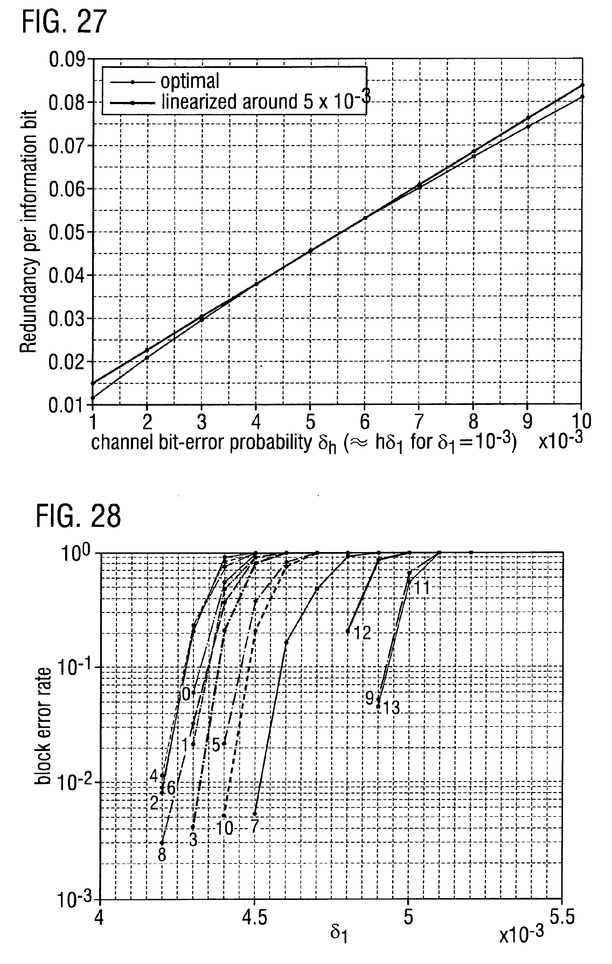

In **Fig. 27,** we plot the optimal redundancy per information bit ($1 - C(\delta)$ where $C(\delta)$ is the capacity of a binary symmetric channel with error probability $\delta$) for successful transmission. The example shows a 10-hop system with $\delta_1 = 10^{-3}$. Linearizing around $\delta_5 = 5 \times 10^{-3}$ shows that a linear redundancy adjustment approximates the optimal redundancy scaling well.

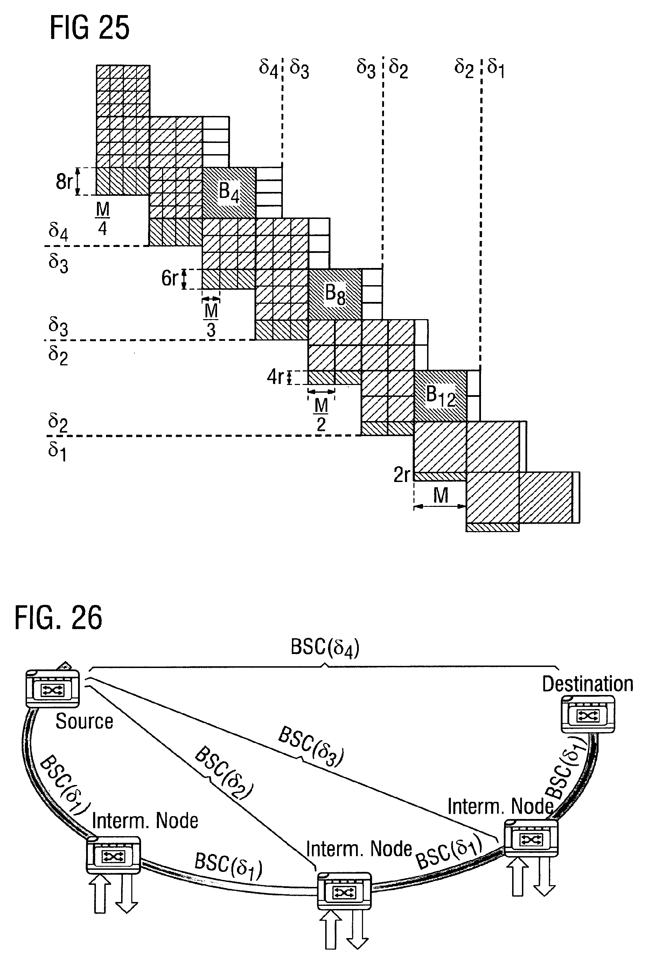

To accommodate the increase in redundancy with increasing $h$, the sub-division of each staircase block can also be increased. Given $h$, each symbol block $\mathbf{B}_i$ can be sub-divided into $h \times h$ sub-blocks, each of dimension $M/h \times M/h$. The $h \times h$ sub-blocks may be nonoverlapping. Small deviations from $M/h$ are allowed if it is not an integer. **Fig. 25** shows an overview of a rate-compatible staircase code for a 4-hop system (with a diagram of a 4-hop system shown in **Fig. 26**). The transition blocks $\mathbf{B}_4$, $\mathbf{B}_8$, $\mathbf{B}_{12}$ can be sub-divided differently depending on whether row or column component codes are encoded. For example, the first transition block $\mathbf{B}_4$ from the left can be sub-divided into 16 sub-blocks during row encoding. However, it can be sub-divided into 9 sub-blocks during column encoding.

A property of rate-compatible staircase codes is that the code rate is not fixed and can be influenced by also encoding predetermined dummy symbols or bits. Here, we defined the code rate as a ratio between a number of (useful or non-predetermined) information symbols included in a codeword and a total number of symbols in the codeword. Let $i \in \{1, \dots , h\}$ be an index of hops in the system. For a staircase chain containing L blocks (excluding zero blocks), let $L_i$ denote the number of blocks encoded by an intermediate node $i$ hops away from the destination node. Let the total number of codeword bits encoded by the intermediate node $i$ hops away be $N_i = L_i M^2 + \frac{L_i}{2} M i r$ and the total number of bits in the codeword be $N = \sum_i N_i$.

The rate of the encoded codeword is given by $R = 1 - \sum_i \frac{N_i}{N}\left(\frac{ir}{M+ir}\right)$. Let $R_{c,i} = \frac{ir}{M+ir} = 2\frac{i(1-R_c)}{(2i-1)-2(i-1)R_c}$ where $R_c = \frac{k}{n}$ and let $g_i = \frac{N_i}{N}$, then $R = \sum_i g_i(1 - R_{c,i})$. The code rate is a convex combination of the rates encoded at different intermediate nodes. The capacity of time-sharing $N$ channel uses between $h$ different BSCs with probability of error $h\delta$, with $N_i$ channel uses of each BSC, is given by $C = \sum_i g_i(1 - C(h\delta))$.

The time-sharing capacity is a convex combination of capacities of difference BSCs. Hence, the gap to capacity of each individual staircase code (of different redundancies) is maintained in a rate-compatible staircase code. In other words, there is no loss in performance due to the combination of different staircase codes of different rates into a single code.

Thus, the rate-compatible staircase encoding concept of Fig. 23 generally includes mapping information symbols to information symbol positions in a sequence of two-dimensional symbol blocks. Individual symbol blocks have information symbol positions as well as row and column redundancy symbol positions. Generating row and/or column redundancy symbols for the redundancy symbol positions of different symbol blocks in the sequence includes, between the different symbol blocks, using different code rates of the row and/or column component codes. The different code rates may be achieved despite using only one row and/or column component code with constant rate between the different symbol blocks. Technically, the component codes can stay the same. The rate can be adjusted via shortening. This may be understood as if we change the rate by switching between different codes, which is not true, we just change the rate by adapting the shortening. In some examples, the redundancy symbols of at least one preceding symbol block can be re-encoded for generating redundancy symbols of one or more subsequent symbol blocks. Additionally or alternatively, the redundancy symbols of a preceding symbol block are not re-encoded for generating the redundancy symbols of a subsequent symbol block in order to avoid parity ringing.

In the following we describe an example encoding process for the example 2-hop system in Fig. 24. The extension to an $h$-hop system is straightforward. The same component code with $n$ coded bits, $k$ information bits, and unique decoding radius t can be used throughout the encoding. Other examples can also employ different component codes, as described above. Starting from the first block $\mathbf{B}_0$ 2302 on the left, sub-blocks $B_{0,0}$ 2302-1, $B_{1,0}$ 2304-1, and $B_{2,0}$ 2308-1, can be encoded by self-protecting staircase encoding, with component codes shortened by $M$, to calculate first column redundancy sub-block $P_{0,0}$ 2306-1 and the equivalent first row redundancy sub-block $Q_{0,0}$ 2310-1. Similarly, sub-blocks $B_{0,3}$ 2302-4, $B_{1,3}$ 2304-4, and $B_{2,3}$ 2308-4, are encoded to calculate redundancy fourth column redundancy sub-block $P_{0,3}$ and the equivalent forth row redundancy sub-block $Q_{0,3}$.

Continuing the pattern, sub-blocks $B_{0,1}$ 2302-2, $B_{1,1}$ 2304-2, and $B_{2,1}$ 2308-2, are encoded to calculate second column redundancy sub-block $P_{0,1}$ 2306-2 and the equivalent second row redundancy sub-block $Q_{0,1}$. Finally, sub-blocks $B_{0,2}$ 2302-3, $B_{1,2}$ 2304-3, and $B_{2,2}$ 2308-3, are encoded to calculate third column redundancy block $P_{0,2}$ and the equivalent third row redundancy sub-block $Q_{0,2}$. At the transition block $\mathbf{B}_4$, during row encoding the block can be sub-divided into four sub-blocks and encoded as above. During column encoding, the entire block can be used, along with $\mathbf{B}_5$ to calculate $P_2$ and $Q_2$. The remaining blocks can be encoded by standard self-protecting staircase code encoding.

Said differently, generating redundancy symbols for the redundancy symbol positions of the symbol blocks in the sequence can include generating a first subset $P_{0,0}$ 2306-1 of column redundancy symbols for a symbol block $\mathbf{B}_i$ such that a concatenation of

- a first subset of information symbols $B_{0,0}$ 2302-1 at first subset of information symbol positions along a column of the preceding symbol block $\mathbf{B}_{i-1}$,
- predetermined (dummy) symbols at a second subset of information symbol positions (corresponding to $B_{0,1}$ 2302-2) along the column of the preceding symbol block $\mathbf{B}_{i-1}$,
- a first subset of information symbols $B_{1,0}$ 2304-1 at a first subset of information symbol positions along a respective column of the symbol block $\mathbf{B}_i$,
- predetermined (dummy) symbols at a second subset of information symbol positions (corresponding to $B_{1,1}$ 2304-2) along the respective column of the symbol block $\mathbf{B}_i$, and
- the first subset of first redundancy symbols $P_{0,0}$ 2306-1 along the respective column of the symbol block $\mathbf{B}_i$

form a valid codeword of a column component code.

Generating the redundancy can further include generating a second subset $\boldsymbol{P}_{0,1}$ 2306-2 of column redundancy symbols for the symbol block $\mathbf{B}_i$ such that a concatenation of

- predetermined (dummy) symbols at the first subset of information symbol positions (corresponding to $\boldsymbol{B}_{0,0}$ 2302-1) along the column of the preceding symbol block $\mathbf{B}_{i-1}$
- a second subset of information symbols $\boldsymbol{B}_{0,1}$ 2302-2 at the second subset of information symbol positions along the column of the preceding symbol block $\mathbf{B}_{i-1}$,
- predetermined (dummy) symbols at the first subset of information symbol positions (corresponding to $\boldsymbol{B}_{1,0}$ 2304-1) along the respective column of the symbol block $\mathbf{B}_i$,
- a second subset of information symbols $\boldsymbol{B}_{1,1}$ 2304-2 at the second subset of information symbol positions along the respective column of the symbol block $\mathbf{B}_i$, and
- the second subset $\boldsymbol{P}_{0,1}$ 2306-2 of column redundancy symbols along the respective column of the symbol block $\mathbf{B}_i$

form a valid codeword of the column component code.

Further, generating redundancy symbols can include generating a third subset $P_{0,2}$ 2306-3 of column redundancy symbols for a symbol block $\mathbf{B}_i$ such that a concatenation of

- a third subset of information symbols $B_{0,2}$ 2302-3 at third subset of information symbol positions along a column of the preceding symbol block $\mathbf{B}_{i-1}$,
- predetermined (dummy) symbols at a fourth subset of information symbol positions (corresponding to $B_{0,3}$ 2302-4) along the column of the preceding symbol block $\mathbf{B}_{i-1}$,
- a third subset of information symbols $B_{1,2}$ 2304-3 at a third subset of information symbol positions along a respective column of the symbol block $\mathbf{B}_i$,
- predetermined (dummy) symbols at a fourth subset of information symbol positions (corresponding to $B_{1,3}$ 2304-4) along the respective column of the symbol block $\mathbf{B}_i$, and
- the third subset of first redundancy symbols $P_{0,2}$ 2306-3 along the respective column of the symbol block $\mathbf{B}_i$

form a valid codeword of a column component code.

Yet further, generating the redundancy can include generating a fourth subset $\boldsymbol{P}_{0,3}$ 2306-4 of column redundancy symbols for the symbol block $\mathbf{B}_i$ such that a concatenation of

- predetermined (dummy) symbols at the third subset of information symbol positions (corresponding to $\boldsymbol{B}_{0,2}$ 2302-3) along the column of the preceding symbol block $\mathbf{B}_{i-1}$,
- a fourth subset of information symbols $\boldsymbol{B}_{0,3}$ 2302-2 at the fourth subset of information symbol positions along the column of the preceding symbol block $\mathbf{B}_{i-1}$,
- predetermined (dummy) symbols at the third subset of information symbol positions (corresponding to $\boldsymbol{B}_{1,2}$ 2304-3) along the respective column of the symbol block $\mathbf{B}_i$,
- a fourth subset of information symbols $\boldsymbol{B}_{1,3}$ 2304-4 at the fourth subset of information symbol positions along the respective column of the symbol block $\mathbf{B}_i$, and
- the fourth subset $\boldsymbol{P}_{0,3}$ 2306-4 of column redundancy symbols along the respective column of the symbol block $\mathbf{B}_i$

form a valid codeword of the column component code.

Likewise, generating redundancy symbols can include generating a first subset $Q_{0,0}$ 2310-1 of row redundancy symbols for the subsequent symbol block $\mathbf{B}_{i+1}$ such that a concatenation of

- the first subset of information symbols $B_{1,0}$ 2304-1 at first subset of information symbol positions along a row of the symbol block $\mathbf{B}_i$,
- predetermined (dummy) symbols at the third subset of information symbol positions (corresponding to $B_{1,2}$ 2304-3) along the row of the symbol block $\mathbf{B}_i$,
- a first subset of information symbols $B_{2,0}$ 2308-1 at a first subset of information symbol positions along a respective row of the subsequent symbol block $\mathbf{B}_{i+1}$,
- predetermined (dummy) symbols at a third subset of information symbol positions (corresponding to $B_{2,2}$ 2308-3) along the respective row of the subsequent symbol block $\mathbf{B}_{i+1}$, and
- the first subset $Q_{0,0}$ 2310-1 of row redundancy symbols 2310-1 along the respective row of the subsequent symbol block $\mathbf{B}_{i+1}$

form a valid codeword of a row component code.

Generating the redundancy symbols can further include generating a second subset $\boldsymbol{Q}_{0,2}$ 2310-2 of row redundancy symbols for the subsequent symbol block $\mathbf{B}_{i+1}$ such that a concatenation of

- predetermined (dummy) symbols at the first subset of information symbol positions (corresponding to $\boldsymbol{B}_{1,0}$ 2304-1) along the row of the symbol block $\mathbf{B}_i$,
- the third subset of information symbols $\boldsymbol{B}_{1,2}$ 2304-3 at the third subset of information symbol positions along the row of the symbol block $\mathbf{B}_i$,
- predetermined (dummy) symbols at the first subset of information symbol positions (corresponding to $\boldsymbol{B}_{2,0}$ 2308-1) along the respective row of the subsequent symbol block $\mathbf{B}_{i+1}$
- a third subset of information symbols $\boldsymbol{B}_{2,2}$ 2308-3 at the third subset of information symbol positions along the respective row of the subsequent symbol block $\mathbf{B}_{i+1}$, and
- the second subset $\boldsymbol{Q}_{0,2}$ 2310-2 of row redundancy symbols along the respective row of the subsequent symbol block $\mathbf{B}_{i+1}$.

form a valid codeword of the row component code.

Further, generating redundancy symbols can include generating a third subset $Q_{0,1}$ 2310-3 of row redundancy symbols for the subsequent symbol block $\mathbf{B}_{i+1}$ such that a concatenation of

- the second subset of information symbols $B_{1,1}$ 2302-3 at the second subset of information symbol positions along a row of the symbol block $\mathbf{B}_i$,
- predetermined (dummy) symbols at the fourth subset of information symbol positions (corresponding to $B_{1,3}$ 2304-4) along the row of the symbol block $\mathbf{B}_i$,
- a second subset of information symbols $B_{2,1}$ 2308-2 at a second subset of information symbol positions along a respective row of the subsequent symbol block $\mathbf{B}_{i+1}$,
- predetermined (dummy) symbols at a fourth subset of information symbol positions (corresponding to $B_{2,3}$ 2308-4) along the respective row of the subsequent symbol block $\mathbf{B}_{i+1}$ and
- the third subset $Q_{0,1}$ 2310-3 of row redundancy symbols along the respective row of the subsequent symbol block $\mathbf{B}_{i+1}$,

form a valid codeword of the row component code.

Yet further, generating the redundancy can include generating a fourth subset $\boldsymbol{Q}_{0,3}$ 2310-4 of row redundancy symbols for the subsequent symbol block $\mathbf{B}_{i+1}$ such that a concatenation of

- predetermined (dummy) symbols at the second subset of information symbol positions (corresponding to $\mathbf{B}_{1,1}$ 2304-2) along the row of the symbol block $\mathbf{B}_i$,
- the fourth subset of information symbols $\mathbf{B}_{1,3}$ 2304-4 at the fourth subset of information symbol positions along the row of the symbol block $\mathbf{B}_i$,
- predetermined (dummy) symbols at the second subset of information symbol positions (corresponding to $\mathbf{B}_{2,1}$ 2308-2) along the respective row of the subsequent symbol block $\mathbf{B}_{i+1}$,
- the fourth subset of information symbols $\mathbf{B}_{2,3}$ 2308-4 at the fourth subset of information symbol positions along the respective row of the subsequent symbol block $\mathbf{B}_{i+1}$, and
- the fourth subset $\mathbf{Q}_{0,3}$ 2310-4 of row redundancy symbols along the respective row of the subsequent symbol block $\mathbf{B}_{i+1}$

form a valid codeword of the row component code.

The skilled person having benefit from the present disclosure will appreciate that the redundancy symbols can comprise adjustable self-protection symbols and/or parity symbols that may be re-encoded or not re-encoded as described in the various examples above. Further, the roles of columns and rows may be exchanged. In a transition block between different code rates, such as block $\mathbf{B}_5$ in the example of Fig. 23, the number of sub-blocks in row dimension can differ from the number of sub-blocks in column dimension. While four sub-blocks are used to compute the row redundancy symbols of $\mathbf{B}_5$ in the above described manner, the whole block $\mathbf{B}_5$ is used to compute the column parties $\mathbf{P}_2$ as has been described with regard to the self-protecting feed-forward staircase codes (see Fig. 10).

A rate-compatible staircase code can be decoded by using the iterative, windowed staircase decoder. At each block, the decoder should know the intermediate node that originally encoded the block. This additional information is assumed to be available, for example within a header transmitted separately from the container.

**Fig.28** shows the block error-rate of a 2-hop system with different loading factors transmitted using a rate-compatible staircase code. Code parameters are M = 480, r = 30, and $L$ = 13 (excluding zero blocks). It is a slightly longer version of the code in Fig. 23, with encoding starting from the left side. The label on each plot is the number of blocks (out of 13) encoded by node 2, i.e. the loading factor of node 2. Observe that successful decoding is achieved for all loading factors. Note that although the horizontal axis is labeled $\delta_1$, the actual channel bit-error probability varies with the loading factor. Only the case where all blocks are encoded by node 1 (the plot labeled 0) has channel bit-error probability $\delta_1$. When all blocks are encoded by node 2 (the plot labeled 13), the channel bit-error probability is close to $2\delta_1$. We find the gap to capacity (in net coding-gain) for the all node 1 case to be 0.573 dB and for the all node 2 case to be 0.638 dB.

We note that the cases where an odd number of blocks are encoded by node 2 appears to perform much better. This suggests that performance improves when the transition block is encoded by node 1. Based on this observation, we may require in some examples that all transition blocks in a rate-compatible staircase code be encoded by the intermediate node with the better channel.

Further examples of the present disclosure propose to fix the size of the redundancy blocks to the maximum number of redundancy symbols required in the network. Any "unused" parts of the redundancy blocks can be filled with information symbols. The skilled person having benefit from the present disclosure will appreciate that this can be combined with other examples described above. Since the redundancy blocks do not change size depending on the location of the encoding intermediate node, this example has the constant block-length property.

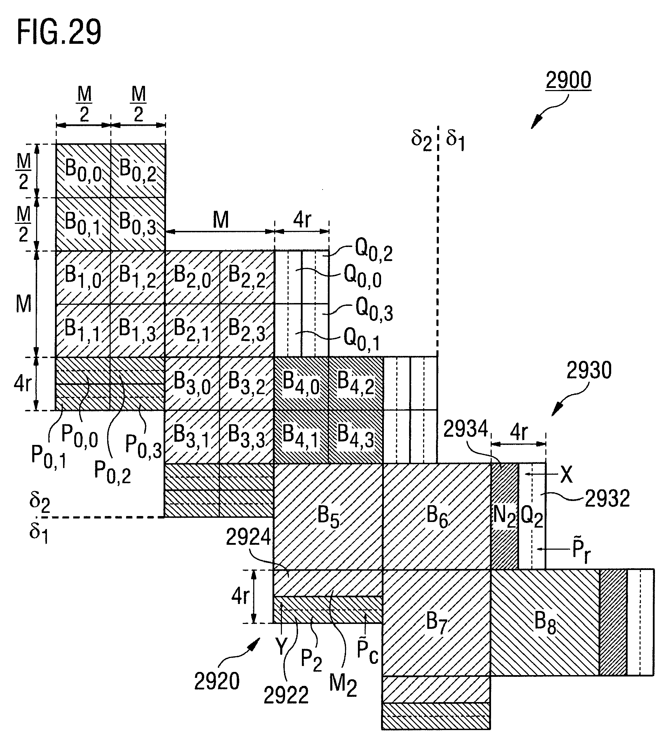

An example is shown in **Fig. 29** for the 2-hop ($h$ = 2) system in Fig. 24. The parameters are determined based on a component code with block-length $n$ symbols, of which $k$ are information symbols, and $r = n - k$ are parity symbols. The value of $M$ can be given by $\max\{M|2M + 2hr \leq n\}$, where $h$ denotes the number of hops. Observe that all staircase blocks have dimension $M \times M$ and all redundancy blocks have dimension $2hr \times M$ (here $4r \times M$). Here, we already implicitly assume that self-protection is used as the size of parity-blocks is fixed to $2rh$, where the factor 2 describes the additional redundancy for self-protection. In the case of no self-protection, this size can be adjusted accordingly.

No modification to the code structure is necessary for blocks encoded by intermediate nodes 2 hops away from the destination and which experience a channel bit-error probability of $\delta_2$. Redundancy blocks 2920 encoded by intermediate nodes 1 hop away can be split into sub-blocks $\mathbf{M}_i$ 2924 and $\mathbf{P}_i$ 2922. Correspondingly, the un-transmitted permuted redundancy blocks 2930 can also be split into sub-blocks $\mathbf{N}_i$ 2934 and $\mathbf{Q}_i$ 2932. The sub-blocks $\mathbf{M}_i$ 2934 can be filled with information symbols, while the blocks $\mathbf{P}_i$ 2922 contain redundancy symbols, for example, including adjustable self-protection symbols $\mathbf{Y}$ and parity symbols $\tilde{\mathbf{P}}_c$. At this point it would be inaccurate to continue to refer to these blocks 2920, 2930 as "redundancy blocks" since they may contain information bits. In the following, we refer to the blocks 2920, 2930 not within the main staircase (those labeled by $\mathbf{B}_i$ or $\mathbf{B}_{i,j}$) as protruding blocks.

We now describe an encoding example focused on protruding blocks $\mathbf{M}_2$, $\mathbf{P}_2$, $\mathbf{N}_2$, and $\mathbf{Q}_2$ based on information bits contained in $\mathbf{B}_4$ (the combination of blocks $\mathbf{B}_{4,j}$ for $j$ = 1, ... ,4), $\mathbf{B}_5$, and $\mathbf{B}_6$. Note the sub-division of $\mathbf{P}_2$ into sub-blocks $\mathbf{Y}, \tilde{\mathbf{P}}_c$ and $\mathbf{Q}_2$ into sub-blocks $\mathbf{X}, \tilde{\mathbf{P}}_r$.

Consider binary cyclic codes (such as BCH codes) as component codes. Let $\mathcal{C}^{\mathrm{row}}$ (n, k) be the row component code with generator polynomial g$^{\mathrm{row}}$(x) and systematic generator matrix of size $k \times n$. Let matrix **G** of size $k \times r$ be the last $r$ columns of the row component code generator matrix, i.e. the columns which generate the parity symbols of the component codeword. Let $^{col}$(n, k), g$^{col}$(x), and **F** be their column counterparts. In general, the generator polynomials and matrices of row and column component codes need not be the same.

Partition the matrices **G** and **F** according to

$$\mathbf{G} = \begin{bmatrix} \mathbf{G}_{\mathrm{p}} \\ \mathbf{G}_{\mathrm{r}} \end{bmatrix}, \mathbf{F} = \begin{bmatrix} \mathbf{F}_{\mathrm{p}} \\ \mathbf{F}_{\mathrm{r}} \end{bmatrix}$$

where $\mathbf{G}_{\mathrm{p}}$, $\mathbf{F}_{\mathrm{p}}$ are sub-matrices of size $(k - r) \times r$ related to information symbols and $\mathbf{G}_{\mathrm{r}}$, $\mathbf{F}_{\mathrm{r}}$ are sub-matrices of size r $\times$ r related to the self-protecting symbols **X** or **Y.** By vertically concatenating $\mathbf{B}_4$, $\mathbf{B}_5$, and $\mathbf{M}_2$ we can calculate intermediate column parity symbols

$$\mathbf{P}_{\mathrm{c}} = (\mathbf{F}_{\mathrm{p}})^{\mathrm{T}} \begin{bmatrix} \mathbf{B}_4 \\ \mathbf{B}_5 \\ \mathbf{M}_2 \end{bmatrix}.$$

Given some permutation $\pi_1$ over the elements of the information symbol subset $\mathbf{M}_2$, i.e. $\mathcal{C}^{\mathrm{row}}$ where $\Pi_1$ is a *2rM $\times$ 2rM* permutation matrix and vec(), vec$^{-1}$ () is some vectorization and its inverse of $\mathbf{M}_2$, assign the further information symbol subset

$$\mathbf{N}_2 = \left( \pi_1(\mathbf{M}_2) \right)^{\mathrm{T}}.$$

Thus, a subset of information symbols $\mathbf{N}_i$ can be a permuted version of a subset of information symbols $\mathbf{M}_i$ or vice versa. The information carried by both subsets $\mathbf{N}_i$, $\mathbf{M}_i$ is the same and thus one of them need not be transmitted. The subsets of information symbols $\mathbf{N}_i$, $\mathbf{M}_i$ can be adjusted together with adjustable self-protection symbols and parity symbols such that information symbols, adjustable self-protection symbols and parity symbols form valid codewords. This will be come apparent below.

By horizontally concatenating information symbols of $\mathbf{B}_5$, $\mathbf{B}_6$ and $\mathbf{N}_2$, we obtain intermediate row parity symbols

$$\mathbf{P}_{\mathrm{r}} = [\mathbf{B}_5 \ \mathbf{B}_6 \ \mathbf{N}_2]\mathbf{G}_{\mathrm{p}}.$$

Note that the intermediate row parity symbols $\mathbf{P}_{\mathrm{c}}$, $\mathbf{P}_{\mathrm{r}}$ are not the same as the parity symbols $\tilde{\mathbf{P}}_c$ $\tilde{\mathbf{P}}_r$ This has already been described above.

Using variable self-protection matrices **Y** and **X,** we can write the parity symbols $\tilde{\mathbf{P}}_c$ and $\tilde{\mathbf{P}}_r$ as $\tilde{\mathbf{P}}_c = \mathbf{P}_{\mathrm{c}} + (\mathbf{F}_{\mathrm{r}})^{\mathrm{T}}\mathbf{Y}$, $\tilde{\mathbf{P}}_r = \mathbf{P}_{\mathrm{r}} + \mathbf{X}\mathbf{G}_{\mathrm{r}}$.

Given permutations $\pi_2$ and $\pi_3$, defined in a similar manner as $\pi_1$ but which are in general not the same permutations, we can impose the self-protection constraints

$$\mathbf{X} = (\pi_2(\mathbf{Y}))^{\mathrm{T}}, \qquad \tilde{\mathbf{P}}_r = (\pi_3(\tilde{\mathbf{P}}_c))^{\mathrm{T}}.$$

Re-arranging gives

$$\pi_3((\mathbf{F}_{\mathrm{r}})^{\mathrm{T}}\mathbf{Y})^{\mathrm{T}} + \pi_2(\mathbf{Y})^{\mathrm{T}}\mathbf{G}_{\mathrm{r}} = \mathbf{P}_{\mathrm{r}} + \pi_3(\mathbf{P}_{\mathrm{c}})^{\mathrm{T}} \triangleq \mathbf{C}.$$

The solution of Y in the above expression was described above for example realizations of interleavers. A similar technique can be used here. An additional complexity of this example is the permutation of $\mathbf{M}_2$ using $\pi_1$. The complexity of this permutation can be varied depending on the error-floor requirements.

Note that when encoding the blocks $P_{0,0}$ using $B_{0,0}$ and $B_{1,0}$ (and $P_{0,2}$ using $B_{0,2}$ and $B_{1,2}$; (and $P_{0,1}$ using

$B_{0,1}$ and $B_{1,1}$; (and $P_{0,3}$ using $B_{0,3}$ and $B_{1,3}$ and other similar blocks) we employ shortening, i.e., fill the missing portions of the block with zeros to account for the missing extra information symbols in the protruding blocks).

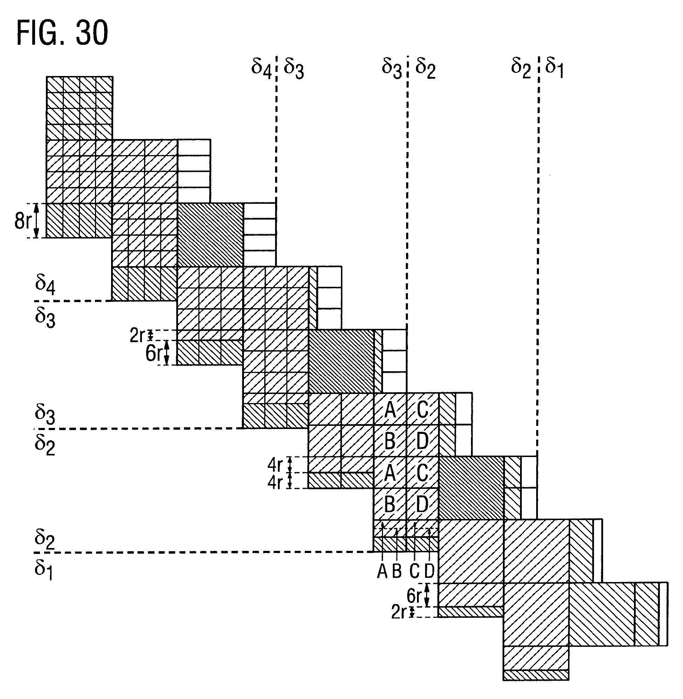

**Fig. 30** shows an embodiment of the constant block-length solution for the 4-hop network shown in Fig. 26. A relation between the respective channel bit-error probabilities is $\delta_4 > \delta_3 > \delta_2 > \delta_1$ Note the decrease in the number of information bits in the protruding blocks as the channel bit-error probability increases. The overall block-length is constant since every staircase block contains $M^2$ bits and each protruding block contains *8rM* bits. For a general *h*-hop system, a protruding block contains *2hrM* bits. For *i = 1, ... , h*, 2(*i - 1*)*rM* of them are information bits. Thus, a size of the respective subset of information symbols $N_i$, $M_i$ can depend on an expected error probability of a (remaining) communication channel. Said differently, it can be dependent on the number of remaining intermediate network nodes or hops up to a destination network node. Thereby the dependency can be inversely proportional, i.e., the more hops to go, the fewer information symbols and the more redundancy symbols in a protruding block.

A minor difference between a multi-hop embodiment and the 2-hop example above is the information bits in a protruding block are further divided into sub-blocks. For example, consider the blocks corresponding to channel bit-error probability $\delta_2$ in Fig. 7. In left-half of each protruding block has dimension 8r $\times$ *M*/2, of which the top 4r $\times$ *M*/2 are information bits. During encoding, this 4r $\times$ *M*/2 information block is further sub-divided into two sub-blocks of dimension 2r $\times$ M/2.

The top sub-block is used in the encoding of the top-left sub-blocks of the corresponding staircase blocks (all labeled A). The bottom sub-block is used in the encoding of the bottom-left sub-blocks of the corresponding staircase blocks (all labeled B). Similarly, blocks are sub-divided and grouped according to labels C and D as shown. The permuted information blocks (shown in light green) are divided correspondingly.

In comparison to the code of Fig. 23, by filling parts of a protruding block with information bits, a slight rate gain is obtained. For *i = 1, ... , h*, the rate of the blocks encoded by intermediate node *i* in the modified solution is given by

$$\tilde{R}_i = 1 - \frac{ir}{M + hr} = 1 - \frac{2i(1 - R_c)}{(2h - 1) - 2(h - 1)R_c}.$$

Compared to the $R_i$ expression above

$$R_i = 1 - 2\frac{i(1 - R_c)}{(2i - 1) - 2(i - 1)R_c}$$

the difference in rate is $2(h\text{-}i)(1\text{-}R_c)\geq0$. Recall that the overall rate is a linear combination $R = \sum_i g_i R_i$ (or $R = \sum_i g_i \tilde{R}_i$ in the modified solution) hence the overall rate is increased.

As an example of the effect on performance due to the filling of protruding blocks with information bits, we simulated self-protecting staircase codes with different amounts of information bits in protruding blocks. The example code parameters are *n* = 1022, *k* = 992, r = 30, and M = 421. The largest possible protruding block has dimensions 2(3)(30)$\times$421.

We simulated three cases. In the first case, protruding blocks with dimensions 2(30) $\times$ 421 were simulated, which only contained redundant bits. In the second case, protruding blocks with dimensions 2(2)(30) $\times$ 421 were simulated, which contained 2(30) $\times$ 421 information bits in addition to redundant bits. In the third case, protruding blocks with dimensions 2(3)(30) $\times$ 421 were simulated, which contained 2(2)(30) $\times$ 421 information bits in addition to redundant bits.

We emphasize that these simulations do not correspond to the filling of protruding blocks for a 3-hop network with *i* = 1,2,3, i.e., the overall block-length is not constant across the three cases. They correspond to the performance of the proposed solution over a 1-hop, 2-hop, or 3-hop network with *i* = 1. We focused on *i* = 1 because it has the largest fraction of information bits in each protruding block.

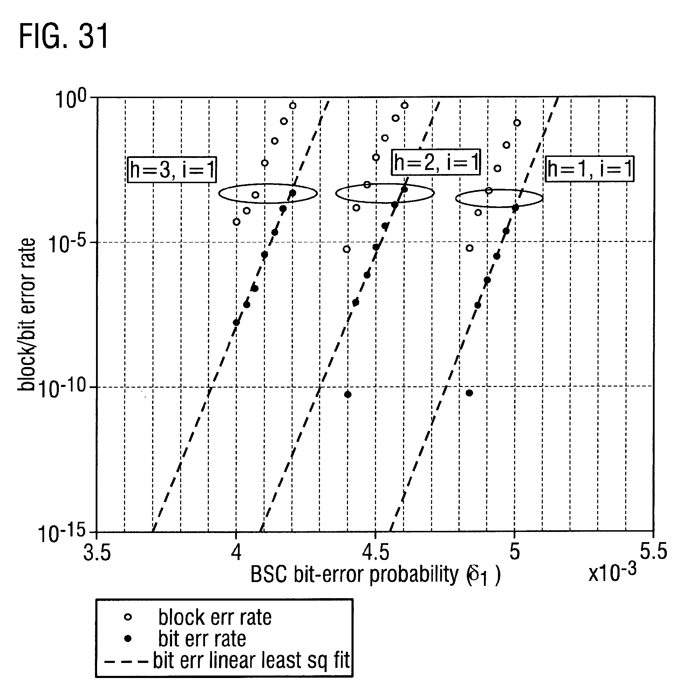

**Fig. 31** shows the block and bit error-rates for the three simulated cases. We extrapolate the bit-error-rate down to 1E-15 to obtain the estimated channel bit-error probability threshold $p_{sim}$. In the following table we compare the thresholds of different protruding block sizes. Due to the rate increase, even though the threshold appears to decrease in Fig. 31 with increasing protruding block sizes, the net-coding-gain (NCG, a measure of the gap to BSC capacity) largely remains constant.

| h | i | M | 2ir | R | *pc* | $p_{sim}$ | NCG (dB) |
|---|---|---|---|---|---|---|---|
| 1 | 1 | 421 | 60 | 0.9335 | 7.90E-3 | 4.55E-3 | 0.672 |
| 2 | 1 | 421 | 120 | 0.9376 | 7.30E-3 | 4.10E-3 | 0.691 |

(continued)

| h | i | M | 2ir | R | pc | p$_{sim}$ | NCG (dB) |
|---|---|---|-----|---|-----|-----------|----------|
| 3 | 1 | 421 | 180 | 0.9413 | 6.79E-3 | 3.70E-3 | 0.710 |

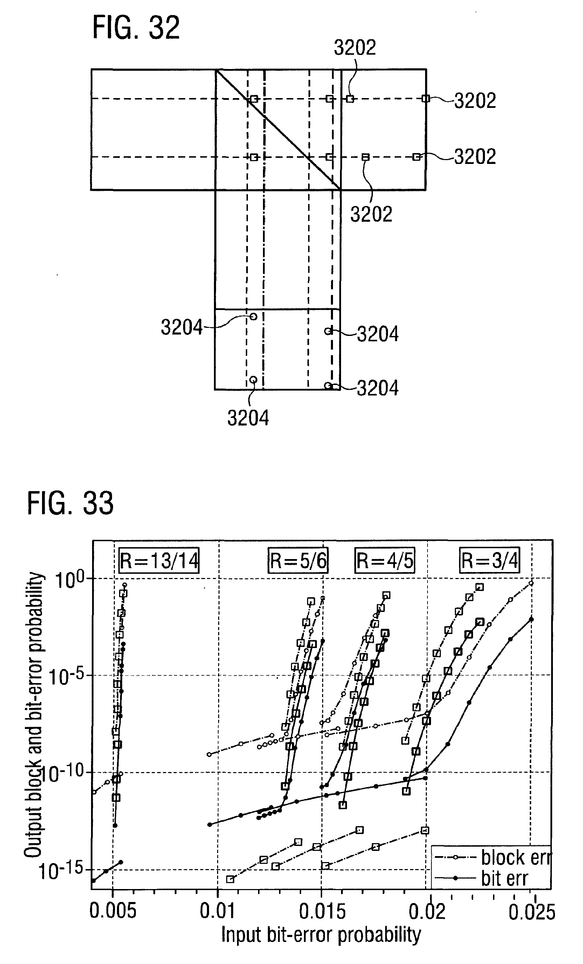

Error-floor analysis of some staircase codes and its variants proposed in this disclosure depends on enumerating the number of stall patterns, i.e., patterns of errors that the decoder cannot remove. To obtain a simple estimate of the error-floor, we only enumerate the smallest stall patterns resulting from channel errors, referred to as minimal stall patterns. We consider an erroneously decoded bit to be a bit error only if it is an information bit. A decoded block is considered to be a block error if it contains at least one bit error. The block (BKER) and bit (BER) error-rates are defined according to these definitions. We estimate the block and bit error-floors of FF-SC based on the above examples of low-error-floor permutations. An example of a minimal stall pattern for component codes with $t = 3$ is shown in **Fig. 32,** consisting of 4 information-bit errors and 4 redundancy-bit errors from the channel. Markers 3202 are bit errors in row component codes. Markers 3204 are bit errors in column component codes. Dashed and dash-dotted lines are referred to in the derivation of error-floor estimates. Note that only 4 out of the 8 bit errors in redundancy blocks are received from the channel, the other ones are interleaved versions thereof.

To construct such a stall pattern, first choose any 2 out of M rows in the information block, such as the rows marked by the horizontal dashed and dash-dotted lines in Fig. 32. Denote the chosen rows by $r_1$ and $r_2$. Under the transposes in Eq. (2), the chosen rows are mapped to columns marked by the thin vertical dashed and dash-dotted lines, reflected about the diagonal of the information block. Under the low-error-floor permutations, bit errors in the row redundancy block are cyclically shifted by no more than $2r$-1 columns, modulo $M$, in the column redundancy block. In Fig. 32, the range of cyclic shifts are bounded by the thin and thick vertical lines. For example, bit errors in the row redundancy block of $r_1$ may be shifted to the columns within the thin and thick dashed vertical lines. For $r_2$, bit errors in the row redundancy block may be shifted to the columns within the thin and thick dash-dotted vertical lines, wrapping around the right boundary of the column redundancy block. Given $r_i$, we can define its valid column set by

$$S(r_i) \triangleq \{r_i + j \bmod M \text{ for all } j \in [0, 2r - 1]\}.$$

It is simple to verify the following spreading property of the low-error-floor permutations: if $2r < M$, i.e. $R > 1/2$ or equivalently the overhead $OH < 100\%$, then row redundancy block bit-errors belonging to the same row cannot belong to the same column in the column redundancy block. Consequently, columns in the stall pattern can only be chosen from the intersection of valid column sets. The number of choices of such columns is

$$|S(r_1) \cap S(r_2)| \leq 2r$$

In Fig. 32, the intersection consists of columns bounded between the thin dashed and thick dash-dotted vertical lines and columns bounded between the thin dash-dotted and thick dashed vertical lines. The resulting error-floor estimates based on the simple upper-bound are given by

$$\mathrm{BKER_{FF}} = \binom{M}{2}\binom{2r}{2}p^8$$

$$\mathrm{BER_{FF}} = \mathrm{BKER_{FF}} \frac{4}{M^2}.$$

For arbitrary $t$, let $t_i = \lfloor (t+1)/2 \rfloor$ and $t_r = t+1 - t_i$. For odd $t$, $t_i = t_r$ and the above argument for $t=3$ applies directly. Observe that $t_i$ (resp. $t_r$) is then the number of information (resp. redundancy) block bit-errors in each row of a minimal stall pattern. The error-floor estimates for odd $t$ are given by

$$\mathrm{BKER_{FF}} = \binom{M}{t_r}\binom{2r}{t_r}p^{t_r(t+1)}$$

$$\mathrm{BER_{FF}} = \mathrm{BKER_{FF}} \frac{t_i t_r}{M^2}.$$

$$(7)$$

For *even t,* we first choose $t_i$ rows out *of M* in the information block. Each erroneous row is assumed to contain $t_i$ bit errors in the information block and $t_r$ bit errors in the row redundancy block. Under the spreading property, bit errors in the row redundancy block are spread to at least $t_r$ distinct columns in the column redundancy block. In the minimal stall pattern, there are exactly $t_r$ erroneous columns in the column redundancy block, each containing $t_i$ bit-errors (since the total number of bit errors in the row redundancy block is $t_i t_r$). Consequently, there must be $t_r$ erroneous columns in the information block, each containing at least $t+1 -t_i=t_r$ bit-errors. We add one additional erroneous row, with $t_i$ bit errors in the information block and $t_r$ bit errors in the row redundancy block, to complete the minimal stall pattern. The resulting minimal stall pattern contains $t_i t_r$ bit errors in the information block and $t_r^2$ bit-errors in the row (or column) redundancy block for a total of $t_r(t_i+t_r)= t_r(t+1)$ bit errors. Applying the intersection of valid column sets argument for the number of choices of columns in the stall pattern, we conclude that the error-floor estimates for even t are also given by the above Eq. (7) for BKER$_{FF}$ and BER$_{FF}$.

We estimate the block and bit error-floors of PFF-SC based on the minimal stall pattern of weight 16, with all 16 bits being information bits. This is the same minimal stall pattern as in the original staircase codes, obtained by choosing $t + 1$ rows out *of M* followed by $k$ columns out *of M* in one block and $t + 1 - k$ columns out *of M* in the adjacent block, for *all $k \in [0, 3]$*. The error-floor estimates for general $t$ are given by

$$\text{BKER}_{\text{PFF}} = \binom{M}{t+1} \sum_{k=0}^{t} \binom{M}{k}\binom{M}{t+1-k} p^{(t+1)^2}$$

$$\text{BER}_{\text{PFF}} = \text{BKER}_{\text{PFF}} \frac{(t+1)^2}{M^2}$$

Software simulated block and bit error-probabilities of transmission over a BSC using the codes in the following tables

TABLE I

FEED-FORWARD STAIRCASE CODE PARAMETERS

| R | OH (%) | m | t | s | M |
|---|---|---|---|---|---|
| 3/4 | 33.3 | 8 | 3 | 63 | 72 |
| 4/5 | 25.0 | 8 | 3 | 15 | 96 |
| 5/6 | 20.0 | 9 | 3 | 187 | 135 |
| 13/14 | 7.69 | 10 | 3 | 183 | 390 |

TABLE II

PARTIAL FEED-FORWARD STAIRCASE CODE PARAMETERS

| R | OH (%) | m | t | s | M | p | A | $\Delta_{\text{ref}}$ |
|---|---|---|---|---|---|---|---|---|
| *3/4* | 33.3 | 8 | 3 | 15 | 96 | $1.82 \times 10^{-2}$ | 1.64 | 1.38 |
| 4/5 | 25.0 | 9 | 3 | 187 | 135 | $1.56 \times 10^{-2}$ | 1.25 | 1.06 |
| 5/6 | 20.0 | 9 | 3 | 133 | 162 | $1.30 \times 10^{-2}$ | 1.07 | 0.92 |
| 13/14 | 7.69 | 10 | 3 | 123 | 420 | $4.80 \times 10^{-3}$ | 0.73 | 0.48 |

shown in **Fig. 33,** along with their error-floor estimates. All FF-SC were implemented using the above low-error-floor permutations. All PFF-SC were implemented with L = 1.

Both proposed classes of codes show similar performance in the waterfall region. PFF-SC have a slight performance loss at lower rates due to its rate loss, which requires a larger M compared to a FF-SC of the same rate. In the error-floor region, even with low-error-floor permutations, FF-SC have observable error-floors. On the other hand, PFF-SC, due to their similarity to the structure of the original staircase codes, do not exhibit any bit error-floor above a BER of $10^{-10}$. Estimates of the bit error-floor are orders of magnitude below $10^{-15}$.

Let $h(x)$ be the binary entropy function and erfc$^{-1}(x)$ be the inverse complementary error function. Given a code of rate R which achieves an output BER of $10^{-15}$ at an input BER of $p$, we define the NCG gap to capacity (in dB) by

EP 3 232 576 A1

$$\Delta \triangleq 20 \log_{10} \operatorname{erfc}^{-1}(2h^{-1}(1-R)) - 20 \log_{10} \operatorname{erfc}^{-1}(2p)$$

where $h^{-1}(x)$ is the unique $0 \leq p < 1/2$ such that $h(p) = x$. We extrapolate the BER curves of PFF-SC down to $10^{-15}$ in order to estimate $p$. The corresponding $\Delta$ values are given in Table II. For comparison, we also included the $\Delta_{ref}$ of some reference staircase codes of the same rates, which were found by exhaustively searching over a wide range of parameters $m$ and $t$ and are considered to be the best staircase codes based on the conventional construction. The referenced codes were based on BCH component codes with $t \in \{4, 5\}$. Nevertheless, the difference in NCG between PFF-SC with $t = 3$ and the referenced codes are less than 0.26 dB. Error-floors of PFF-SC and the referenced codes are identical and well below $10^{-15}$.

In this disclosure, we proposed some modifications to staircase codes which allow for convenient termination. In feed-forward staircase codes (FF-SC), a self-protection technique is used to completely eliminate parity-propagation. In partial feed-forward staircase codes (PFF-SC), a propagation-length parameter is used to control the extent of parity-propagation. Analysis and simulation results show that these codes have similar performance as the original staircase codes. FF-SC have slightly better waterfall performance than PFF-SC, while PFF-SC have much lower error-floors. Hence, FF-SC and PFF-SC are good staircase code solutions for applications where parity-propagation is undesirable or termination is necessary.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and examples of the invention, as well as specific examples thereof, are intended to encompass equivalents thereof.

Functional blocks shall be understood as functional blocks comprising circuitry that is adapted for performing a certain function, respectively. Hence, a "means for s.th." may as well be understood as a "means being adapted or suited for s.th.". A means being adapted for performing a certain function does, hence, not imply that such means necessarily is performing said function (at a given time instant).

Functions of various elements shown in the figures, including any functional blocks may be provided through the use of dedicated hardware, such as "a processor", "a controller", etc. as well as hardware capable of executing software in association with appropriate software. Moreover, any entity described herein as functional block, may correspond to or be implemented as "one or more modules", "one or more devices", "one or more units", etc. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, Digital Signal Processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the Detailed Description, where each claim may stand on its own as a separate embodiment. While each claim may stand on its own as a separate embodiment, it is to be noted that - although a dependent claim may refer in the claims to a specific combination with one or more other claims - other examples may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective steps of these methods.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some examples a single step may include or may be broken into multiple sub steps. Such sub steps may be included and part of the disclosure of this single step unless explicitly excluded.

**Claims**

1. A Forward Error Correction, FEC, encoding method, comprising:

mapping information symbols to information symbol positions in a sequence of two-dimensional symbol blocks, wherein a symbol block ($\mathbf{B}_i$) has a preceding symbol block ($\mathbf{B}_{i-1}$) and a subsequent symbol block ($\mathbf{B}_{i+1}$) in the sequence, wherein the symbol block ($\mathbf{B}_i$) has information symbol positions and redundancy symbol positions; generating redundancy symbols for the redundancy symbol positions of the symbol blocks in the sequence, wherein generating the redundancy symbols comprises

generating first redundancy symbols (X; $\tilde{P}_r$) for the symbol block ($\mathbf{B}_i$) such that symbols at symbol positions including or excluding redundancy symbol positions along a first dimension of the preceding symbol block ($\mathbf{B}_{i-1}$) concatenated with symbols at information symbol positions and the first redundancy symbols (X; $\tilde{P}_r$) along the first dimension of the symbol block ($\mathbf{B}_i$) form a codeword of a first FEC component code,

generating second redundancy symbols (Y; $\tilde{P}_c$) for the subsequent symbol block ($\mathbf{B}_{i+1}$) such that symbols at the information symbol positions along a second dimension of the symbol block ($\mathbf{B}_i$) concatenated with symbols at symbol positions excluding redundancy symbol positions and the second redundancy symbols (Y; $\tilde{P}_c$) along the second dimension of the subsequent symbol block ($\mathbf{B}_{i+1}$) form a codeword of a second FEC component code.

2. The FEC encoding method of claim 1, wherein the first and second redundancy symbols (X; $\tilde{P}_r$; Y; $\tilde{P}_c$) carry the same redundancy information.

3. The FEC encoding method of claim 2, further comprising:

transmitting the information symbols of the symbol block $\mathbf{B}_i$ and of the subsequent symbol block $\mathbf{B}_{i+1}$ along with either the first or the second redundancy symbols (X; $\tilde{P}_r$; Y; $\tilde{P}_c$).

4. The FEC encoding method of claim 1, wherein the first and the second FEC component codes are systematic block codes.

5. The FEC encoding method of claim 1, wherein the first FEC component code is the same as the second FEC component code.

6. The FEC encoding method of claim 1, wherein a number of information symbol positions in subsequent symbol blocks is different.

7. The FEC encoding method of claim 1, wherein the first FEC component code is different from the second FEC component code.

8. The FEC encoding method of claim 7, wherein a first generator polynomial corresponding to the first FEC component code is reciprocal to a second generator polynomial corresponding to the second FEC component code.

9. The FEC encoding method of claim 1, wherein the first redundancy symbols (X; $\tilde{P}_r$) are a permuted version of the second redundancy symbols (Y; $\tilde{P}_c$).

10. The FEC encoding method of claim 1, wherein the first redundancy symbols are a transposed version of the second redundancy symbols

11. The FEC encoding method of claim 1, wherein the first redundancy symbols (X; $\tilde{P}_r$) are a cyclically shifted version of the second redundancy symbols (Y; $\tilde{P}_c$).

12. The FEC encoding method of claim 1, wherein each of the first and second redundancy symbols (X; $\tilde{P}_r$; Y; $\tilde{P}_c$) comprises respective adjustable symbols (X; Y) and respective parity symbols ($\tilde{P}_r$; $\tilde{P}_c$), wherein computing the redundancy symbols comprises,

determining the first parity symbols ($\tilde{P}_r$) such that the symbols at symbol positions including or excluding redundancy symbol positions along the first dimension of the preceding symbol block ($\mathbf{B}_{i-1}$) concatenated with the symbols at the information symbol positions, the first adjustable symbols (X), and the first parity symbols ($\tilde{P}_r$) along the first dimension of the symbol block $\mathbf{B}_i$ form a codeword of the first FEC component code,

determining the second parity symbols ($\tilde{P}_c$) such that the symbols at the information symbol positions along the second dimension of the symbol block $\mathbf{B}_i$ concatenated with the symbols at the information symbol positions, the second adjustable symbols **(Y),** and the second parity symbols ($\tilde{P}_c$) along the second dimension of the subsequent symbol block $\mathbf{B}_{i+1}$ form a codeword of the second FEC component code,

wherein the second adjustable symbols **(Y)** are a permuted version of the first adjustable symbols **(X)** in accordance with a first permutation rule ($\pi_1$), and

wherein the second parity symbols ($\tilde{P}_c$) are a permuted version of the first parity symbols ($\tilde{P}_r$) in accordance with a second permutation rule ($\pi_2$).

**13.** The FEC encoding method of claim 12, wherein determining the first parity symbols ($\tilde{P}_r$) comprises determining first intermediate parity symbols ($\mathbf{P}_r$) based on combining a concatenation of the symbols at the information symbol positions along the first dimension of the preceding symbol block $\mathbf{B}_{i-1}$ and the symbols at the information symbol positions along the first dimension of the symbol block $\mathbf{B}_i$ according to a first portion of the first FEC component code, and

wherein determining the second parity symbols ($\tilde{P}_c$) comprises determining second intermediate parity symbols ($\mathbf{P}_c$) based on combining a concatenation of the symbols at the information symbol positions along the second dimension of the symbol block $\mathbf{B}_i$ and the symbols at the information symbol positions along the second dimension of the subsequent symbol block $\mathbf{B}_{i+1}$ according to a first portion of the second FEC component code.

**14.** The FEC encoding method of claim 12, wherein determining the first parity symbols ($\tilde{P}_r$) further comprises

determining one of the first or the second adjustable symbols **(X; Y)** based on a combination of first and second generator matrices corresponding to a respective second portion of the first and second FEC component code, first and second permutation matrices corresponding to the first and second permutation rule, and the first and the second intermediate parity symbols ($\mathbf{P}_r$; $\mathbf{P}_c$); and

determining the respective other adjustable symbols **(Y; X)** based on the determined first or the second adjustable symbols **(X; Y)** and the first permutation rule ($\pi_1$).

**15.** The FEC encoding method of claim 12, wherein a subset of information symbols ($\mathbf{M}_2$) of the symbol block ($\mathbf{B}_i$) is a permuted version of a subset of information symbols ($\mathbf{N}_2$) of the subsequent symbol block ($\mathbf{B}_{i+1}$) according to a third permutation rule.

**16.** The FEC encoding method of claim 15, wherein a size of the respective subset of information symbols ($\mathbf{M}_2$; $\mathbf{N}_2$) depends on an expected error probability of a communication channel for the codewords.

**17.** The FEC encoding method of claim 1, wherein the first redundancy symbols **(X; $\tilde{P}_r$)** for the symbol block $\mathbf{B}_i$ are generated based on symbols at information and redundancy symbol positions along the first dimension of the preceding symbol block $\mathbf{B}_i$ 1 concatenated with symbols at information symbol positions along the first dimension of the symbol block $\mathbf{B}_i$; and wherein the second redundancy symbols **(Y; $\tilde{P}_c$)** for the subsequent symbol block $\mathbf{B}_{i+1}$ are generated based on symbols at information symbol positions along the second dimension of the symbol block $\mathbf{B}_i$ concatenated with symbols at information symbol positions along the second dimension of the subsequent symbol block $\mathbf{B}_{i+1}$.

**18.** The FEC encoding method of claim 1, wherein generating redundancy symbols of different symbol blocks in the sequence comprises using different code rates of the first and/or second component codes between the different symbol blocks, wherein a code rate is defined by a ratio between a number of useful information symbols included in a codeword and a total number of symbols in the codeword.

**19.** The FEC encoding method of claim 1, wherein generating the first redundancy symbols comprises generating a subset (2306-1) of the first redundancy symbols such that a concatenation of

- a first subset of symbols (2302-1) at a first subset of symbol positions including or excluding redundancy symbol positions along the first dimension of the preceding symbol block ($\mathbf{B}_{i-1}$),
- predetermined symbols at a second subset of symbol positions including or excluding redundancy symbol positions (2302-2) along the first dimension of the preceding symbol block ($\mathbf{B}_{i-1}$),
- a first subset of information symbols (2304-1) at a first subset of information symbol positions along the first dimension of the symbol block ($\mathbf{B}_i$),
- predetermined symbols at a second subset of information symbol positions (2304-2) along the first dimension of the symbol block ($\mathbf{B}_i$), and
- the subset of first redundancy symbols (2306-1) along the first dimension of the symbol block ($\mathbf{B}_i$)

form a codeword of the first FEC component code.

**20.** The FEC encoding method of claim 19, wherein generating the second redundancy symbols ($\mathbf{Y}$; $\tilde{P}_c$) comprises generating a subset (2310-1) of the second redundancy symbols such that a concatenation of

- the first subset of information symbols (2304-1) at the first subset of information symbol positions along the second dimension of the symbol block ($\mathbf{B}_i$),
- predetermined symbols at a third subset of information symbol positions (2304-3) along the second dimension of the symbol block ($\mathbf{B}_i$),
- a first subset of information symbols (2308-1) at a first subset of information symbol positions along the second dimension of the subsequent symbol block ($\mathbf{B}_{i+1}$),
- predetermined symbols at a third subset of information symbol positions (2308-3) along the second dimension of the subsequent symbol block ($\mathbf{B}_{i+1}$), and
- the subset (2310-1) of the second redundancy symbols along the second dimension of the subsequent symbol block ($\mathbf{B}_{i+1}$)

form a codeword of the second FEC component code.

**21.** The FEC encoding method of claim 1, wherein, in at least the symbol block ($\mathbf{B}_i$), a number of information symbol positions along the first dimension differs from a number of information symbol positions along the second dimension.

## FIG. 1

100

$B_0$ · · · $B_1$ $B_2$ $B_i$ $B_{i+1}$ · · ·

M

M

102 104 106 108 110

## FIG. 2

200

| 2M-r | r |
|---|---|
| 202 | 204 |

## FIG. 3

300

M-r r

M

$B_{i,L}$ $B_{i,R}$

302 304

# FIG. 4

# FIG. 5

FIG. 6

FIG. 7

# FIG.8

$B_0$

| 0 | 0 | 0 |
| 0 | 0 | 0 |
| 0 | 0 | 0 |

$B_1$

| 1 | 0 | 0 |
| 0 | 1 | 1 |
| 0 | 0 | 0 |

X

| 0 | 0 |
| 1 | 1 |
| 0 | 1 |

$\tilde{P}_r$

| 1 | 0 |
| 0 | 0 |
| 1 | 0 |

$B_2$

| 0 | 1 | 0 |
| 1 | 1 | 1 |
| 1 | 1 | 0 |

Y

| 0 | 0 | 1 |
| 1 | 1 | 0 |

$\tilde{P}_c$

| 1 | 0 | 1 |
| 0 | 0 | 0 |

48

# FIG. 9

FIG. 10

FIG. 11

# FIG. 12

# FIG. 13

FIG. 14

FIG. 15

FIG. 16

FIG.17

# FIG.18

FIG. 19

FIG. 20

FIG.21

# FIG.22

FIG.23

FIG. 24

2400

2408

BSC($\delta_2$)

Source

Destination

2410

BSC($\delta_1$)

BSC($\delta_1$)

2402

Interm. Node 1

2404

2406

## FIG 25

## FIG. 26

FIG. 27

FIG. 28

FIG.29

# FIG. 30

# FIG. 31

## FIG. 32

## FIG. 33

| | Europäisches Patentamt<br>European Patent Office<br>Office européen des brevets | **EUROPEAN SEARCH REPORT** | Application Number<br>EP 16 30 5442 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2012/266051 A1 (FARHOODFAR ARASH [CA] ET AL) 18 October 2012 (2012-10-18)<br>* the whole document *<br>----- | 1-21 | INV.<br>H03M13/29<br>H03M13/27 |
| A | BENJAMIN P SMITH ET AL: "Staircase Codes: FEC for 100 Gb/s OTN",<br>JOURNAL OF LIGHTWAVE TECHNOLOGY, IEEE SERVICE CENTER, NEW YORK, NY, US,<br>vol. 30, no. 1,<br>1 January 2012 (2012-01-01), pages 110-117, XP011397841,<br>ISSN: 0733-8724, DOI:<br>10.1109/JLT.2011.2175479<br>* the whole document *<br>----- | 1-21 | ADD.<br>H03M13/15<br>H03M13/19 |
| A | SCHMALEN LAURENT ET AL: "Spatially Coupled Soft-Decision Error Correction for Future Lightwave Systems",<br>JOURNAL OF LIGHTWAVE TECHNOLOGY, IEEE SERVICE CENTER, NEW YORK, NY, US,<br>vol. 33, no. 5, 1 March 2015 (2015-03-01), pages 1109-1116, XP011575185,<br>ISSN: 0733-8724, DOI:<br>10.1109/JLT.2014.2379957<br>[retrieved on 2015-03-09]<br>* the whole document *<br>----- | 1-21 | TECHNICAL FIELDS SEARCHED (IPC)<br><br>H03M |

-/--

The present search report has been drawn up for all claims

| Place of search | Date of completion of the search | Examiner |
|---|---|---|
| Munich | 28 September 2016 | Offer, Elke |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

## EUROPEAN SEARCH REPORT

Application Number

EP 16 30 5442

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ITU: "SERIES G: TRANSMISSION SYSTEMS AND MEDIA, DIGITAL SYSTEMS AND NETWORKS Digital sections and digital line system - Optical fibre submarine cable systems Forward error correction for high bit-rate DWDM submarine systems ITU-T Recommendation G.975.1", ITU-T STANDARD IN FORCE (I), INTERNATIONAL TELECOMMUNICATION UNION, GENEVA, CH, no. g9751 2/4, 1 February 2004 (2004-02-01), pages 1-58, XP002474600, * the whole document * ----- | 1-21 | |

| | | | TECHNICAL FIELDS SEARCHED (IPC) |
|---|---|---|---|

The present search report has been drawn up for all claims

| Place of search | Date of completion of the search | Examiner |
|---|---|---|
| Munich | 28 September 2016 | Offer, Elke |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 16 30 5442

This annex lists the patent family members relating to the patent documents cited in the above-mentioned European search report.
The members are as contained in the European Patent Office EDP file on
The European Patent Office is in no way liable for these particulars which are merely given for the purpose of information.

28-09-2016

| Patent document cited in search report | Publication date | Patent family member(s) | Publication date |
|---|---|---|---|
| US 2012266051 A1 | 18-10-2012 | US 2012266051 A1<br>US 2014237325 A1 | 18-10-2012<br>21-08-2014 |

EPO FORM P0459

For more details about this annex : see Official Journal of the European Patent Office, No. 12/82